# EUROPEAN PATENT SPECIFICATION

(11) **EP 3 934 085 B1**
(45) Date of publication and mention of the grant of the patent: **01.03.2023**
(21) Application number: 21175989.9
(22) Date of filing: 26.05.2021
(51) Int. Cl.: H02M 5/458, H02M 7/00, H02M 7/06, H02M 7/493, H02M 7/5387, H02G 5/00, H05K 7/14, H02M 1/088

(54) **POWER CONVERSION APPARATUS**
STROMUMWANDLUNGSVORRICHTUNG
APPAREIL DE CONVERSION DE PUISSANCE

(30) Priority: 02.07.2020 JP 2020115209
(43) Date of publication of application: 05.01.2022
(73) Proprietor: Fuji Electric Co., Ltd., Kawasaki-shi, Kanagawa 210-9530 (JP)
(72) Inventor: Tsunawaki, Tomonori, Kanagawa, 210-9530 (JP); Matsuoka, Hiroki, Kanagawa, 210-9530 (JP); Ishimaru, Daiki, Kanagawa, 210-9530 (JP); Saga, Ayako, Kanagawa, 210-9530 (JP)
(74) Representative: Appelt, Christian W.

(56) References cited:
- JP-A- H0 746 857
- JP-A- 2014 042 377
- JP-B2- 5 150 570

## Description

### TECHNICAL FIELD

The present disclosure relates to a power conversion apparatus.

### BACKGROUND ART

Conventionally, with respect to a power conversion apparatus in which multiple switch legs constituted by semiconductor switches corresponding to upper and lower arms are connected in parallel, a technique for uniformizing electric currents flowing through the semiconductor switches is known (for example, see Japanese Laid-Open Patent Publication No. 2017-055478).

In Japanese Laid-Open Patent Publication No. 2017-055478, the switch legs are arranged in the width direction, and are provided with: a parallel connection bus bar connecting, in parallel, connection points between the upper and lower arms of each switch leg; and an output bus bar connected to the parallel connection bus bar. The parallel connection bus bar occupies the range in the width direction in which the switch legs are arranged, and is arranged to extend in the length direction from the switch legs. On the other end portions opposite to the switch legs in the length direction of the parallel connection bus bar, an output bus bar is stacked on the parallel connection bus bar with an insulating layer interposed therebetween, and is arranged to extend in the width direction and connected to the parallel connection bus bar at one end portion in the width direction.

Accordingly, this reduces the inductance of the power path in the width direction of the parallel connection bus bar when the electric currents of the switch legs are merged or the electric currents are branched into the switch legs, and can alleviate the unbalance between the electric currents flowing in the switch legs.

JP 5 150570 B2 describes that an inverter unit comprises each six groups of semiconductor packages from among even numbers of semiconductor packages, the six groups of semiconductor packages are divided into sets of two groups where each set is allowed to function as U, V, W phases, the six groups of semiconductor package are connected by the same P- and N-side DC busbars, the P- and N-side busbars are allowed to oppose each other while sandwiching a thin insulating layer therebetween to reduce the inductance of the DC busbars, and the inductance of the DC busbars among the U, V, W phases is reduced.

JP H07 46857 A describes that when the insulated gate transistors of switching circuits are turned ON/OFF sequentially, AC voltages from capacitors are converted into AC voltages through diodes and fed to a load. Upon turn ON of switching elements on the P side of the circuit, current flows from a conductor board on the P side through the P side conductor board of phase U to each switching element and fed to phase U of the load. Similarly, current is fed through the P side conductor board of phase V to phase V of the load upon turn ON of the circuits, and fed through the P side conductor board of phase W to phase W of load upon turn ON of the circuits.

JP 2014 042377 A describes that a power supply bus bar of a power converter comprises: a coupling part; a main bus bar installed so as to extend in a first direction while being opposite to a plurality of power modules to be arranged in the first direction and be electrically connected in parallel; and a sub bus bar for connecting the coupling part 22 and respective DC terminals of the plurality of power modules, when the power converter includes the plurality of power modules. The sub bus bar includes: a first section for transmitting power from the main bus bar through the coupling part; a second section which extends in parallel with the main bus bar and transmits the power from the first section; and third sections and for dividing the power from the second section and transmitting the divided power to the respective DC terminals of the plurality of power modules.

### SUMMARY OF THE INVENTION

However, in Japanese Laid-Open Patent Publication No. 2017-055478, the electric current of the output bus bar corresponds to the summation of the electric currents of all the switch legs, whereas the electric current flowing in the width direction on the other end portion of the parallel connection bus bar is merely an electric current having passed through a single switch leg or a summation of electric currents of only some of the switch legs. Therefore, the magnetic field generated by the output bus bar is likely not to be cancelled by the magnetic field generated by the parallel connection bus bar, and the magnetic field is likely to exit exist. Therefore, the magnetic field interlinks the electric current flowing in the width direction of the parallel connection bus bar, and accordingly, an inductance may occur in the electric current path in the width direction of the parallel connection bus bar, and may cause unbalance between the electric currents flowing through the switch legs.

In view of the above problems, in a power conversion apparatus in which multiple switch legs constituted by semiconductor switches corresponding to upper and lower arms are connected in parallel, it is an object to provide a technique capable of alleviating an unbalance of electric currents flowing through the semiconductor switches.

The above object is achieved by a power conversion apparatus according to claim 1. Claims 2 to 4 refer to specifically advantageous realizations of the power conversion apparatus according to claim 1.

In order to achieve the above object, according to an aspect of the present disclosure, provided is a power conversion apparatus (1) including:
a smoothing circuit (20);
an inverter circuit (40) including a bridge circuit that includes a plurality of output circuits, corresponding to respective phases, connected in parallel, each of the output circuits including a plurality of switch legs connected in parallel, each of the plurality of switch legs including upper and lower arms being connected in series and including a plurality of semiconductor switches, connection points between the upper and lower arms of the plurality of switch legs being connected with each other, and the inverter circuit being configured to output a predetermined alternating current power, based on a direct current power received from the smoothing circuit; and
output terminals (40T) configured to output the predetermined alternating current power to an outside,
wherein the inverter circuit includes:
   a positive-side direct current bus bar (40P) connecting positive-side terminals (410P, 420P, 430P) of the plurality of switch legs with each other;
   a negative-side direct current bus bar (40N) connecting negative-side terminals (410N, 420N, 430N) of the plurality of switch legs with each other; and
   a parallel connection bus bar (4101, 4201, 4301) connecting the connection points of the upper and lower arms of the plurality of switch legs,
wherein the positive-side direct current bus bar, the negative-side direct current bus bar, and the parallel connection bus bar have a laminated structure in which the positive-side direct current bus bar, the negative-side direct current bus bar, and the parallel connection bus bar are stacked one over another with an insulating layer (4111, 4211, 4311, 41I2, 42I2, 43I2) interposed therebetween, and
wherein a connection portion between the parallel connection bus bar and an interconnection extending to a corresponding one of the output terminals is arranged at a position farther away from the smoothing circuit than are the upper and lower arms farthest from the smoothing circuit among all of the upper and lower arms included in the plurality of switch legs.

In order to achieve the above object, according to another aspect of the present disclosure, provided is a power conversion apparatus (1) including:
a smoothing circuit (20);
an inverter circuit (40) including a bridge circuit that includes a plurality of output circuits, corresponding to respective phases, connected in parallel, each of the output circuits including a plurality of switch legs connected in parallel, each of the plurality of switch legs including upper and lower arms being connected in series and including a plurality of semiconductor switches, connection points between the upper and lower arms of the plurality of switch legs being connected with each other, and the inverter circuit being configured to output a predetermined alternating current power, based on a direct current power received from the smoothing circuit; and
output terminals (40T) configured to output the predetermined alternating current power to an outside,
wherein the inverter circuit includes:
   a positive-side direct current bus bar (40P) connecting positive-side terminals (410P, 420P, 430P) of the plurality of switch legs with each other;
   a negative-side direct current bus bar (40N) connecting negative-side terminals (410N, 420N, 430N) of the plurality of switch legs with each other; and
   a parallel connection bus bar (4101, 4201, 4301) connecting the connection points of the upper and lower arms of the plurality of switch legs,
wherein the positive-side direct current bus bar and the negative-side direct current bus bar have a laminated structure in which the positive-side direct current bus bar and the negative-side direct current bus bar are stacked with an insulating layer (41I1, 4211, 4311) interposed therebetween, and
wherein the parallel connection bus bar is configured such that lengths of respective paths from all of the upper and lower arms included in the plurality of switch legs to a merging portion where all of the respective paths from the plurality of switch legs are merged are substantially same.

In order to achieve the above object, according to still another aspect of the present disclosure, provided is a power conversion apparatus (1) including:
a smoothing circuit (20);
an inverter circuit (40) including a bridge circuit that includes a plurality of output circuits, corresponding to respective phases, connected in parallel, each of the output circuits including a plurality of switch legs connected in parallel, each of the plurality of switch legs including upper and lower arms being connected in series and including a plurality of semiconductor switches, connection points between the upper and lower arms of the plurality of switch legs being connected with each other, and the inverter circuit being configured to output a predetermined alternating current power, based on a direct current power received from the smoothing circuit; and
output terminals (40T) configured to output the predetermined alternating current power to an outside,
wherein the inverter circuit includes:
   a positive-side direct current bus bar (40P) connecting positive-side terminals (410P, 420P, 430P) of the plurality of switch legs with each other;
   a negative-side direct current bus bar (40N) connecting negative-side terminals (410N, 420N, 430N) of the plurality of switch legs with each other; and
   a parallel connection bus bar (4101, 4201, 4301) connecting the connection points of the upper and lower arms of the plurality of switch legs,
wherein the positive-side direct current bus bar and the negative-side direct current bus bar have a laminated structure in which the positive-side direct current bus bar and the negative-side direct current bus bar are stacked with an insulating layer (41I1, 4211, 4311) interposed therebetween, and
wherein the parallel connection bus bar is configured such that respective paths, passing through the upper and lower arms included in the plurality of switch legs, between the smoothing circuit and a merging portion where all of the respective paths from the plurality of switch legs are merged have substantially a same length and have substantially a same current density over entireties of the respective paths.

In order to achieve the above object, according to still yet another aspect of the present disclosure, provided is a power conversion apparatus (1) including:
a smoothing circuit (20);
an inverter circuit (40) including a bridge circuit that includes a plurality of output circuits, corresponding to respective phases, connected in parallel, each of the output circuits including a plurality of switch legs connected in parallel, each of the plurality of switch legs including upper and lower arms being connected in series and including a plurality of semiconductor switches, connection points between the upper and lower arms of the plurality of switch legs being connected with each other, and the inverter circuit being configured to output a predetermined alternating current power, based on a direct current power received from the smoothing circuit; and
output terminals (40T) configured to output the predetermined alternating current power to an outside,
wherein the inverter circuit includes:
   a positive-side direct current bus bar (40P) connecting positive-side terminals (410P, 420P, 430P) of the plurality of switch legs with each other;
   a negative-side direct current bus bar (40N) connecting negative-side terminals (410N, 420N, 430N) of the plurality of switch legs with each other; and
   a parallel connection bus bar (4101, 4201, 4301) connecting the connection points of the upper and lower arms of the plurality of switch legs,
wherein the positive-side direct current bus bar, the negative-side direct current bus bar, and the parallel connection bus bar have a laminated structure in which the positive-side direct current bus bar, the negative-side direct current bus bar, and the parallel connection bus bar are stacked one over another with an insulating layer (41I1, 4211, 4311, 41I2, 42I2, 43I2) interposed therebetween, and
wherein a connection portion between the parallel connection bus bar and an interconnection extending to a corresponding one of the output terminals is arranged at a position closer to the smoothing circuit than are the upper and lower arms closest to the smoothing circuit among all of the upper and lower arms included in the plurality of switch legs.

According to the above aspects, in a power conversion apparatus in which multiple switch legs constituted by semiconductor switches corresponding to upper and lower arms are connected in parallel, a technique capable of alleviating an unbalance of electric currents flowing through the semiconductor switches can be provided.

### BRIEF DESCRIPTION OF THE DRAWINGS

Each of FIG. 1 to FIG. 14 does not necessarily show each feature of the independent claim, which defines the scope of the present invention.
FIG. 1 is a circuit diagram illustrating an example of a power conversion apparatus according to a first embodiment not covered by independent apparatus claim 1.
FIG. 2 is a structural drawing illustrating an example of the power conversion apparatus according to the first embodiment, not covered by independent apparatus claim 1.
FIG. 3 is a structural drawing illustrating an example of the power conversion apparatus according to the first embodiment not covered by independent apparatus claim 1.
FIG. 4 is a drawing for explaining an example of an arrangement structure of bus bars;
FIG. 5 is a drawing for explaining an example of an arrangement structure of bus bars;
FIG. 6 is a drawing for explaining an example of an arrangement structure of bus bars;
FIG. 7 is a circuit diagram illustrating an example of a power conversion apparatus according to second to fourth embodiments;
FIG. 8 is a structural drawing illustrating an example of a power conversion apparatus according to the second embodiment;
FIG. 9 is a structural drawing illustrating an example of the power conversion apparatus according to the second embodiment;
FIG. 10 is a drawing for explaining paths of electric currents flowing through the switch modules;
FIG. 11 is a structural drawing illustrating an example of the power conversion apparatus according to the third embodiment;
FIG. 12 is a structural drawing illustrating an example of the power conversion apparatus according to the third embodiment;
FIG. 13 is a structural drawing illustrating an example of the power conversion apparatus according to the fourth embodiment; and
FIG. 14 is a structural drawing illustrating an example of the power conversion apparatus according to the fourth embodiment.

### DESCRIPTION OF EMBODIMENTS

Hereinafter, embodiments are described with reference to drawings.

### [First embodiment]

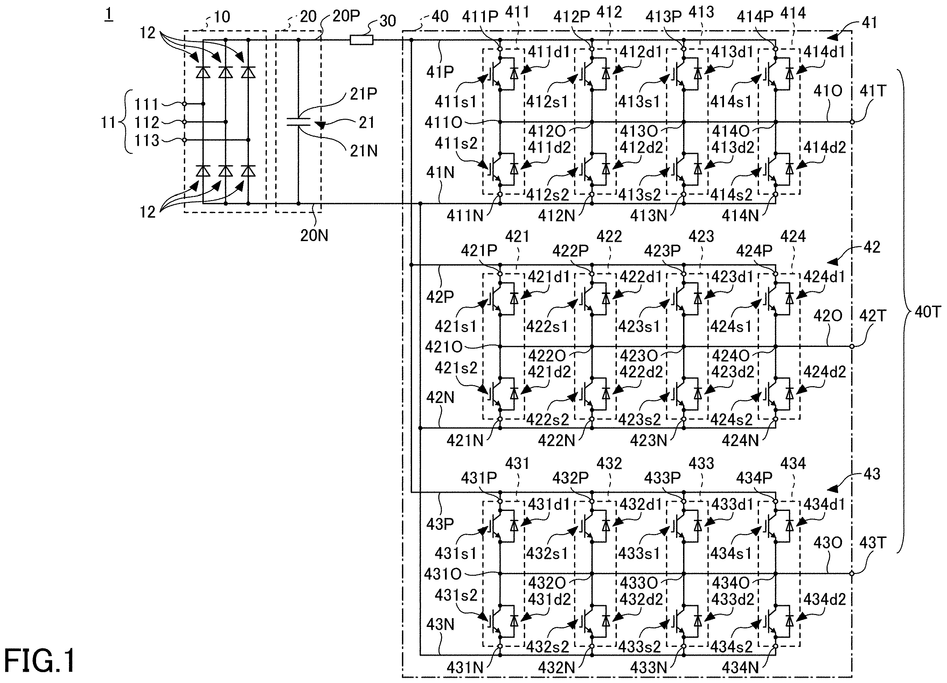

First, the first embodiment, which is not covered by independent apparatus claim 1, is explained with reference to FIG. 1 to FIG. 6.

### <Overview of power conversion apparatus>

FIG. 1 is a circuit diagram illustrating an example of a power conversion apparatus 1 according to the first embodiment not covered by independent apparatus claim 1.

The power conversion apparatus 1 uses a predetermined three-phase alternating current power received from a predetermined external power source (for example, a commercial power supply system) to generate a predetermined three-phase alternating current power, and supply the generated three-phase alternating current power to a predetermined load apparatus (for example, an electric motor).

As illustrated in FIG. 1, the power conversion apparatus 1 includes a rectifying circuit 10, a smoothing circuit 20, a fuse 30, and an inverter circuit 40.

The rectifying circuit 10 rectifies a three-phase alternating current power including R-phase, S-phase, and T-phase received through an input terminal 11 from an external power supply and outputs a predetermined direct current power to the smoothing circuit 20.

The input terminal 11 includes an R-phase input terminal 111 receiving an R-phase power, an S-phase input terminal 112 receiving an S-phase power, and a T-phase input terminal 113 receiving a T-phase power.

As illustrated in FIG. 1, the rectifying circuit 10 is, for example, a bridge-type full-wave rectifying circuit in which six diodes 12 are connected in a bridge form.

The smoothing circuit 20 smooths the direct current power output from the rectifying circuit 10 and the direct current power regenerated by the inverter circuit 40.

The smoothing circuit 20 includes a positive-side bus bar 20P, a negative-side bus bar 20N, and a smoothing capacitor 21.

The positive-side bus bar 20P is a flat plate-shaped member made of a material with a relatively high conductivity (for example, copper, aluminum, and the like). This is also applicable to a negative-side bus bar 20N, a U-phase positive-side direct current bus bar 41P, a U-phase negative-side direct current bus bar 41N, a V-phase positive-side direct current bus bar 42P, a V-phase negative-side direct current bus bar 42N, a W-phase positive-side direct current bus bar 43P, and a W-phase negative-side direct current bus bar 43N, which are explained later.

The positive-side bus bar 20P is connected to a positive-side output terminal of the rectifying circuit 10 and a positive-side input terminal of the inverter circuit 40.

The negative-side bus bar 20N is connected to a negative-side output terminal of the rectifying circuit 10 and a negative-side direct current input terminal of the inverter circuit 40.

The smoothing capacitor 21 is arranged in a power path connecting the positive-side bus bar 20P and the negative-side bus bar 20N in parallel with the rectifying circuit 10 and the inverter circuit 40. The smoothing capacitor 21 smooths the direct current power output from the rectifying circuit 10 and the inverter circuit 40 by repeating charging and discharging as appropriate.

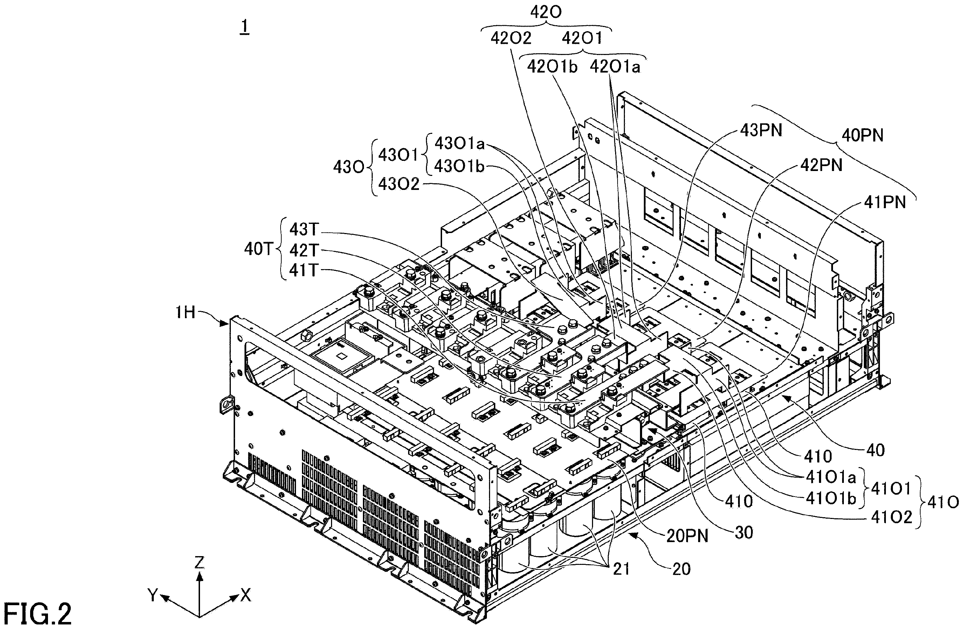

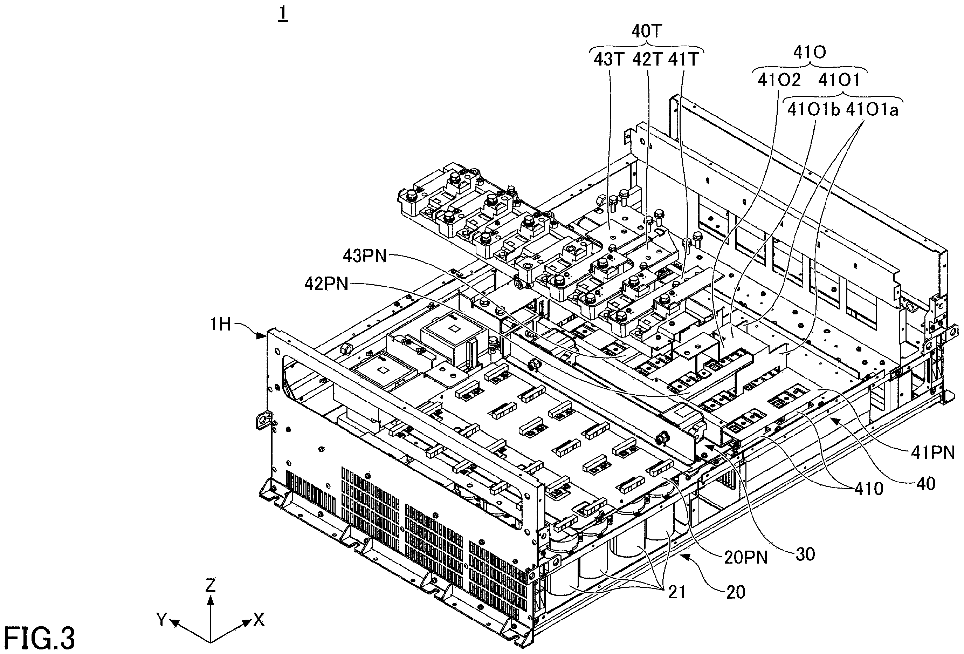

A single smoothing capacitor 21 may be provided or multiple smoothing capacitors 21 may be connected in parallel (see FIG. 2, FIG. 3).

The smoothing capacitor 21 includes a positive-side terminal 21P connected to the positive-side bus bar 20P and a negative-side terminal 21N connected to the negative-side bus bar 20N.

A fuse 30 is arranged in a positive-side power path between the positive-side bus bar 20P and the positive-side direct current input terminal of the inverter circuit 40. The fuse 30 melts when an over current and the like occur to protect the power conversion apparatus 1 (the inverter circuit 40) from damage caused by an over current due to an overload, short-circuit, and the like.

The inverter circuit 40 generates a three-phase alternating current power of the U-phase, V-phase, and W-phase from the direct current power supplied from the smoothing circuit 20, and outputs the three-phase alternating current power to an external load apparatus from an output terminal 40T. The output terminal 40T includes a U-phase output terminal 41T for outputting the U-phase alternating current power to the outside, a V-phase output terminal 42T for outputting the V-phase alternating current power to the outside, and a W-phase output terminal 43T for outputting the W-phase alternating current power to the outside.

The inverter circuit 40 includes a bridge circuit constituted by a U-phase circuit 41, a V-phase circuit 42, and a W-phase circuit 43. The U-phase circuit 41, the V-phase circuit 42, and the W-phase circuit 43 (each of which is an example of an output circuit) are connected in parallel between a positive-side wiring and a negative-side wiring of the power conversion apparatus 1.

The U-phase circuit 41 includes the U-phase positive-side direct current bus bar 41P, the U-phase negative-side direct current bus bar 41N, switch modules 411 to 414, and a U-phase alternating current bus bar 410. Hereinafter, in the first embodiment, the switch modules 411 to 414 may be collectively referred to as, or any one of the switch modules 411 to 414 may be individually referred to as a "switch module 410".

The U-phase positive-side direct current bus bar 41P is connected via the fuse 30 to the positive-side bus bar 20P of the smoothing circuit 20.

The U-phase negative-side direct current bus bar 41N is connected to the negative-side bus bar 20N of the smoothing circuit 20.

The switch modules 411 to 414 (examples of switch legs) are connected in parallel between the U-phase positive-side direct current bus bar 41P and the U-phase negative-side direct current bus bar 41N.

The switch module 411 includes semiconductor switches 411s1, 411s2 corresponding to the upper and lower arms, freewheeling diodes 411d1, 411d2, a positive-side terminal 411P, a negative-side terminal 411N, and an alternating current output terminal 4110.

The switch module 412 includes semiconductor switches 412s1, 412s2 corresponding to the upper and lower arms, freewheeling diodes 412d1, 412d2, a positive-side terminal 412P, a negative-side terminal 412N, and an alternating current output terminal 4120.

The switch module 413 includes semiconductor switches 413s1, 413s2 corresponding to the upper and lower arms, freewheeling diodes 413d1, 413d2, a positive-side terminal 413P, a negative-side terminal 413N, and an alternating current output terminal 4130.

The switch module 414 includes semiconductor switches 414s1, 414s2 corresponding to the upper and lower arms, freewheeling diodes 414d1, 414d2, a positive-side terminal 414P, a negative-side terminal 414N, and an alternating current output terminal 4140.

Hereinafter, in the first embodiment, the semiconductor switches 411s1, 411s2, 412s1, 412s2, 413s1, 413s2, 414s1, and 414s2 may be collectively referred to as, or any one of the semiconductor switches 411s1, 411s2, 412s1, 412s2, 413s1, 413s2, 414s1, and 414s2 may be individually referred to as a "semiconductor switch 410s". In the first embodiment, a constituent element of the "switch module 410" which corresponds to the positive-side terminals 411P to 414P may be referred to as a "positive-side terminal 410P". In the first embodiment, a constituent element of the "switch module 410" which corresponds to the negative-side terminals 411N to 414N may be referred to as a "negative-side terminal 410N". In the first embodiment, a constituent element of the switch module 410" which corresponds to the alternating current output terminals 4110 to 4140 may be referred to as an "alternating current output terminal 410O".

The switch modules 411 to 414 have similar constituent elements, and are constituted by similar circuits. Therefore, the switch module 411 is explained as a representing example, and explanations about the switch modules 412 to 414 are omitted.

The semiconductor switches 411s1, 411s2 (examples of upper and lower arms) are arranged in a power path connecting the positive-side terminal 411P and the negative-side terminal 411N, and are connected to each other in series. The semiconductor switches 411s1, 411s2 are, for example, IGBTs (Insulated Gate Bipolar Transistors).

The semiconductor switch 411s1 corresponds to the upper arm of the switch leg, and is connected to the positive-side terminal 411P.

The semiconductor switch 411s2 corresponds to the lower arm of the switch leg, and is connected to the negative-side terminal 411N.

The freewheeling diodes 411d1, 411d2 are connected in parallel with the semiconductor switches 411s1, 411s2, respectively.

The positive-side terminal 411P is connected to the U-phase positive-side direct current bus bar 41P.

The negative-side terminal 411N is connected to the U-phase negative-side direct current bus bar 41N.

The alternating current output terminal 4110 (an example of a connection point of the upper and lower arms) extends from a connection point (an intermediate point) between the semiconductor switches 411s1 and 411s2.

At one end, the U-phase alternating current bus bar 410 connects the alternating current output terminals 4110 to 4140 of the switch modules 411 to 414, respectively, with each other, and at the other end, the U-phase alternating current bus bar 410 is connected to the U-phase output terminal 41T. Accordingly, the inverter circuit 40 can output the U-phase alternating current power, which is output from the switch modules 411 to 414, to the outside through the U-phase output terminal 41T.

The V-phase circuit 42 includes the V-phase positive-side direct current bus bar 42P, the V-phase negative-side direct current bus bar 42N, switch modules 421 to 424, and a V-phase alternating current bus bar 42O. Hereinafter, in the first embodiment, the switch modules 421 to 424 may be collectively referred to as, or any one of the switch modules 421 to 424 may be individually referred to as a "switch module 420".

The V-phase positive-side direct current bus bar 42P is connected to the positive-side bus bar 20P of the smoothing circuit 20 via the fuse 30.

The V-phase negative-side direct current bus bar 42N is connected to the negative-side bus bar 20N of the smoothing circuit 20.

The switch modules 421 to 424 are connected in parallel between the V-phase positive-side direct current bus bar 42P and the V-phase negative-side direct current bus bar 42N.

The switch module 421 includes semiconductor switches 421s1, 421s2 corresponding to the upper and lower arms, freewheeling diodes 421d1, 421d2, a positive-side terminal 421P, a negative-side terminal 421N, and an alternating current output terminal 4210.

The switch module 422 includes semiconductor switches 422s1, 422s2 corresponding to the upper and lower arms, freewheeling diodes 422d1, 422d2, a positive-side terminal 422P, a negative-side terminal 422N, and an alternating current output terminal 422O.

The switch module 423 includes semiconductor switches 423s1, 423s2 corresponding to the upper and lower arms, freewheeling diodes 423d1, 423d2, a positive-side terminal 423P, a negative-side terminal 423N, and an alternating current output terminal 423O.

The switch module 424 includes semiconductor switches 424s1, 424s2 corresponding to the upper and lower arms, freewheeling diodes 424d1, 424d2, a positive-side terminal 424P, a negative-side terminal 424N, and an alternating current output terminal 424O.

Hereinafter, in the first embodiment, the semiconductor switches 421s1, 421s2, 422s1, 422s2, 423s1, 423s2, 424s1, and 424s2 may be collectively referred to as, or any one of the semiconductor switches 421s1, 421s2, 422s1, 422s2, 423s1, 423s2, 424s1, and 424s2 may be individually referred to as a "semiconductor switch 420s". Also, in the first embodiment, a constituent element of the "switch module 420" which corresponds to the positive-side terminals 421P to 424P may be referred to as a "positive-side terminal 420P". Also, in the first embodiment, a constituent element of the "switch module 420" which corresponds to the negative-side terminals 421N to 424N may be referred to as a "negative-side terminal 420N". Also, in the first embodiment, a constituent element of the "switch module 420" which corresponds to the alternating current output terminals 4210 to 424O may be referred to as an "alternating current output terminal 420O".

The switch modules 421 to 424 have similar constituent elements, and are constituted by similar circuits. Therefore, the switch module 421 is explained as a representing example, and explanations about the switch modules 422 to 424 are omitted.

The semiconductor switches 421s1, 421s2 (examples of upper and lower arms) are arranged in a power path connecting the positive-side terminal 421P and the negative-side terminal 421N, and are connected to each other in series.

The semiconductor switch 421s1 corresponds to the upper arm of the switch leg, and is connected to the positive-side terminal 421P.

The semiconductor switch 421s2 corresponds to the lower arm of the switch leg and is connected to the negative-side terminal 421N.

The freewheeling diodes 421d1, 421d2 are connected in parallel with the semiconductor switches 421s1, 421s2, respectively.

The positive-side terminal 421P is connected to the V-phase positive-side direct current bus bar 42P.

The negative-side terminal 421N is connected to the V-phase negative-side direct current bus bar 42N.

The alternating current output terminal 4210 (an example of a connection point of the upper and lower arms) extends from a connection point (an intermediate point) between the semiconductor switches 421s1 and 421s2.

At one end, the V-phase alternating current bus bar 42O connects the alternating current output terminals 4210 to 424O of the switch modules 421 to 424, respectively, with each other, and at the other end, the V-phase alternating current bus bar 42O is connected to the V-phase output terminal 42T. Accordingly, the inverter circuit 40 can output the V-phase alternating current power, which is output from the switch modules 421 to 424, to the outside through the V-phase output terminal 42T.

The W-phase circuit 43 includes the W-phase positive-side direct current bus bar 43P, the W-phase negative-side direct current bus bar 43N, switch modules 431 to 434, and a W-phase alternating current bus bar 43O. Hereinafter, in the first embodiment, the switch modules 431 to 434 may be collectively referred to as, or any one of the switch modules 431 to 434 may be individually referred to as a "switch module 430".

The W-phase positive-side direct current bus bar 43P is connected to the positive-side bus bar 20P of the smoothing circuit 20 via the fuse 30.

The W-phase negative-side direct current bus bar 43N is connected to the negative-side bus bar 20N of the smoothing circuit 20.

The switch modules 431 to 434 are connected in parallel between the W-phase positive-side direct current bus bar 43P and the W-phase negative-side direct current bus bar 43N.

The switch module 431 includes semiconductor switches 431s1, 431s2 corresponding to the upper and lower arms, freewheeling diodes 431d1, 431d2, a positive-side terminal 431P, a negative-side terminal 431N, and an alternating current output terminal 4310.

The switch module 432 includes semiconductor switches 432s1, 432s2 corresponding to the upper and lower arms, freewheeling diodes 432d1, 432d2, a positive-side terminal 432P, a negative-side terminal 432N, and an alternating current output terminal 432O.

The switch module 433 includes semiconductor switches 433s1, 433s2 corresponding to the upper and lower arms, freewheeling diodes 433d1, 433d2, a positive-side terminal 433P, a negative-side terminal 433N, and an alternating current output terminal 433O.

The switch module 434 includes semiconductor switches 434s1, 434s2 corresponding to the upper and lower arms, freewheeling diodes 434d1, 434d2, a positive-side terminal 434P, a negative-side terminal 434N, and an alternating current output terminal 434O.

Hereinafter, in the first embodiment, the semiconductor switches 431s1, 431s2, 432s1, 432s2, 433s1, 433s2, 434s1, and 434s2 may be collectively referred to as, or any one of the semiconductor switches 431s1, 431s2, 432s1, 432s2, 433s1, 433s2, 434s1, and 434s2 may be individually referred to as a "semiconductor switch 430s". Also, in the first embodiment, a constituent element of the "switch module 430" which corresponds to the positive-side terminals 431P to 434P may be referred to as a "positive-side terminal 430P". Also, in the first embodiment, a constituent element of the "switch module 430" which corresponds to the negative-side terminals 431N to 434N may be referred to as a "negative-side terminal 430N". Also, in the first embodiment, a constituent element of the "switch module 430" which corresponds to the alternating current output terminals 4310 to 434O may be referred to as an "alternating current output terminal 430O".

The switch modules 431 to 434 have similar constituent elements, and are constituted by similar circuits. Therefore, the switch module 431 is explained as a representing example, and explanations about the switch modules 432 to 434 are omitted.

The semiconductor switches 431s1, 431s2 (examples of upper and lower arms) are arranged in a power path connecting positive-side terminal 431P and the negative-side terminal 431N, and are connected to each other in series.

The semiconductor switch 431s1 corresponds to the upper arm of the switch leg, and is connected to the positive-side terminal 431P.

The semiconductor switch 431s2 corresponds to the lower arm of the switch leg, and is connected to the negative-side terminal 431N.

The freewheeling diodes 431d1, 431d2 are connected to the semiconductor switches 431s1, 431s2, respectively.

The positive-side terminal 431P is connected to the W-phase positive-side direct current bus bar 43P.

The negative-side terminal 431N is connected to the W-phase negative-side direct current bus bar 43N.

The alternating current output terminal 4310 (an example of a connection point of the upper and lower arms) extends from a connection point (an intermediate point) between the semiconductor switches 431s1 and 431s2.

At one end, the W-phase alternating current bus bar 43O connects the alternating current output terminals 4310 to 434O of the switch modules 431 to 434, respectively, with each other, and at the other end, the W-phase alternating current bus bar 43O is connected to the W-phase output terminal 43T. Accordingly, the inverter circuit 40 can output the W-phase alternating current power, which is output from the switch modules 431 to 434, to the outside through the W-phase output terminal 43T.

### <Structure of power conversion apparatus>

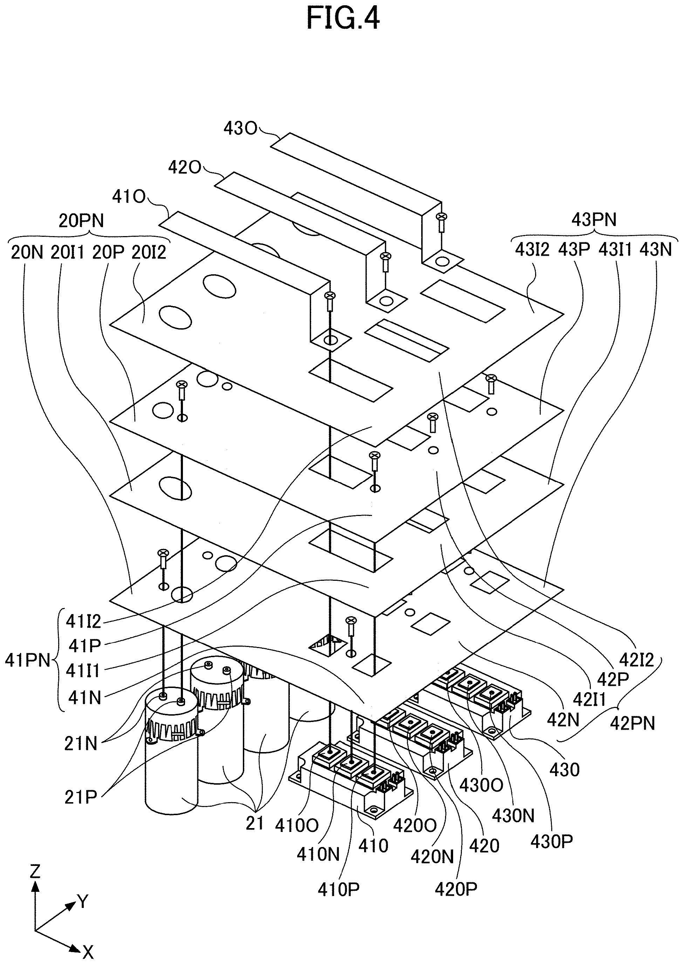

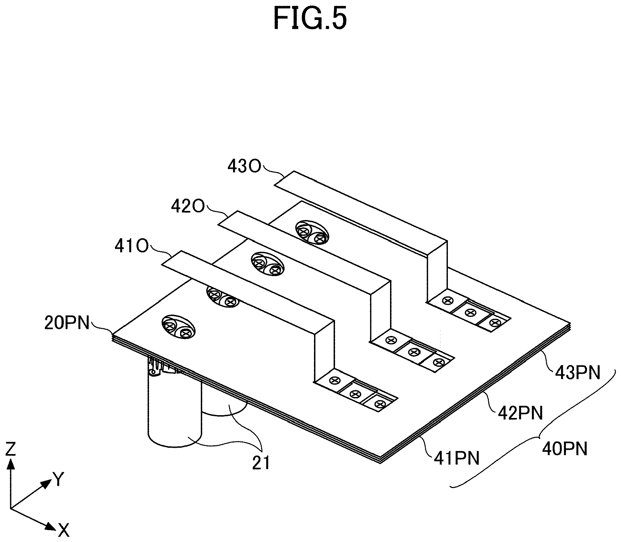

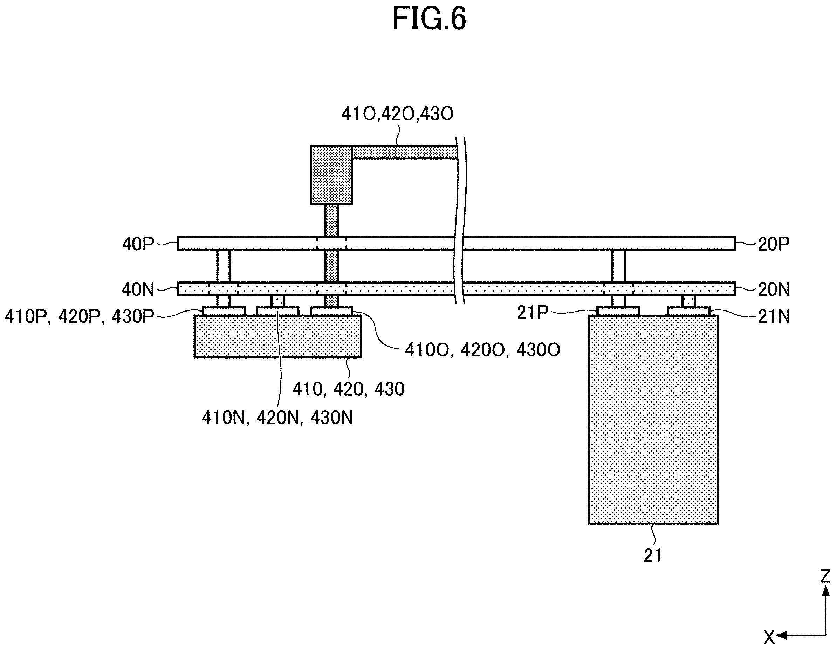

FIG. 2 and FIG. 3 are structural drawings illustrating an example of a power conversion apparatus 1 according to the first embodiment not covered by independent apparatus claim 1. Specifically, FIG. 2 is a perspective view illustrating the power conversion apparatus 1 from which a portion of a housing 1H is detached. FIG. 3 is an exploded perspective view illustrating a state in which the portion of the housing 1H of the power conversion apparatus 1 is detached and the output terminal 40T is detached and moved in the upward direction. FIG. 4 to FIG. 6 explanations about s for explaining an example of an arrangement structure of bus bars. Specifically, FIG. 4 is an exploded perspective view schematically illustrating the bus bars, FIG. 5 is a perspective view illustrating a completed state in which constituent elements of the bus bars of FIG. 4 are assembled, and FIG. 6 is a side view schematically illustrating an example of an arrangement structure of bus bars.

In FIG. 4 and FIG. 5, for the sake of convenience, a laminate bus bar 20PN, a U-phase laminate bus bar 41PN, a V-phase laminate bus bar 42PN, and a W-phase laminate bus bar 43PN are illustrated as integrally-formed members. Also, in FIG. 4, for the sake of convenience, the positive-side bus bar 20P of the smoothing circuit 20, and the U-phase positive-side direct current bus bar 41P, the V-phase positive-side direct current bus bar 42P, and the W-phase positive-side direct current bus bar 43P of the inverter circuit 40 are illustrated as integrally-formed members. Likewise, in FIG. 4, for the sake of convenience, the negative-side bus bar 20N of the smoothing circuit 20, and the U-phase negative-side direct current bus bar 41N, the V-phase negative-side direct current bus bar 42N, and the W-phase negative-side direct current bus bar 43N of the inverter circuit 40 are illustrated as integrally-formed members. Likewise, in FIG. 4, insulating layers 20I1, 41I1, 4211, 4311 are illustrated as integrally-formed members. Likewise, in FIG. 4, the insulating layers 20I2, 41I2, 42I2, 43I2 are illustrated as integrally-formed members. Also, in FIG. 4 and FIG. 5, for the sake of simplicity, only some (four) of all of the smoothing capacitors 21 in the smoothing circuit 20 are illustrated as a representing example. Likewise, in FIG. 4 and FIG. 5, for the sake of simplicity, only some (one) of all of the switch modules 410 in the U-phase circuit 41 is illustrated as a representing example. Likewise, in FIG. 4 and FIG. 5, for the sake of simplicity, only some (one) of all of the switch modules 420 in the V-phase circuit 42 is illustrated as a representing example. Likewise, in FIG. 4 and FIG. 5, for the sake of simplicity, only some (one) of all of the switch modules 430 in the W-phase circuit 43 is illustrated as a representing example. Also, in FIG. 6, for the sake of convenience, the insulating layers 20I1, 20I2, 41I1, 41I2, 4211, 42I2, 4311, and 43I2 are not illustrated.

As illustrated in FIG. 2 and FIG. 3, in the power conversion apparatus 1, various kinds of constituent elements are accommodated in a housing 1H having a substantially box shape in a substantially rectangular shape in all of a plan view, a side view, and a front view. The term "substantially" is intended to allow manufacturing variation, and the like, and is hereinafter used for similar meanings.

Hereinafter, the longitudinal direction of the housing 1H in the plan view may be referred to as an X axis direction, the lateral direction of the housing 1H in the plan view may be referred to as a Y axis direction, and the vertical direction may be referred to as the Z axis direction (see FIG. 2 to FIG. 6).

As illustrated in FIG. 2 and FIG. 3, the smoothing circuit 20, the fuse 30, and the inverter circuit 40 are arranged next to each other in order from one end portion to the other end portion in the longitudinal direction (in the positive direction of the X axis) of the inner space of the housing 1H.

Also, the output terminal 40T is arranged in a central portion in the longitudinal direction (the X axis direction) in the inner space of the housing 1H and is arranged in an upper portion in the inner space of the housing 1H. Specifically, the output terminal 40T is arranged on or above the smoothing circuit 20 and the fuse 30 in the inner space of the housing 1H.

As described above, the output terminal 40T includes the U-phase output terminal 41T, the V-phase output terminal 42T, and the W-phase output terminal 43T. The U-phase output terminal 41T, the V-phase output terminal 42T, and the W-phase output terminal 43T are arranged next to each other in order from one end portion to the central portion in the lateral direction (in the positive direction of the Y axis) of the inner space of the housing 1H.

In the example, the smoothing circuit 20 includes twenty four (24) smoothing capacitors 21.

The smoothing capacitors 21 have substantially cylindrical shapes and are placed on the bottom surface of the housing 1H with the axial direction thereof being in the vertical direction. Also, the positive-side terminal 21P and the negative-side terminal 21N are arranged on a surface (an upper surface) opposite from the surface on which the smoothing capacitors 21 are placed.

Specifically, as illustrated in FIG. 2 and FIG. 3, four smoothing capacitors 21 are arranged in the X axis direction and six smoothing capacitors 21 are arranged in the Y axis direction.

On the upper surface of the smoothing capacitor 21, the laminate bus bar 20PN is arranged substantially in parallel in the X axis direction and the Y axis direction.

The laminate bus bar 20PN has a substantially rectangular shape in the plan view. The laminate bus bar 20PN is arranged in a range that covers the twenty four (24) smoothing capacitors 21 in the X axis direction and the Y axis direction.

As illustrated in FIG. 4 and FIG. 5, the laminate bus bar 20PN is structured by stacking the positive-side bus bar 20P and the negative-side bus bar 20N with the insulating layer 2011 interposed therebetween. Specifically, the laminate bus bar 20PN has a four-layer laminated structure including the negative-side bus bar 20N arranged in the lowermost layer, the insulating layer 2011 arranged thereon, the positive-side bus bar 20P arranged thereon, the insulating layer 20I2 arranged in the uppermost layer.

As illustrated in FIG. 4 to FIG. 6, relatively small through holes in which bolts are fastened to fix the negative-side terminals 21N of the smoothing capacitors 21 are provided in the negative-side bus bar 20N in the lowermost layer. Accordingly, the negative-side terminals 21N of the smoothing capacitors 21 and the negative-side bus bar 20N can be directly connected. In the negative-side bus bar 20N, relatively large through holes are provided to expose the positive-side terminals 21P in the plan view. Accordingly, the positive-side bus bar 20P, which is in the layer higher than the negative-side bus bar 20N, and the positive-side terminals 21P can be connected.

As illustrated in FIG. 4 and FIG. 5, in the insulating layer 2011 adjacent to the negative-side bus bar 20N, relatively large through holes are provided to expose, in the plan view, the positive-side terminals 21P and the negative-side terminals 21N of the smoothing capacitors 21 (the fastening through holes formed in the negative-side bus bar 20N) .

As illustrated in FIG. 4 to FIG. 6, relatively small through holes in which bolts are fastened to fix the positive-side terminals 21P of the smoothing capacitors 21 are provided in the positive-side bus bar 20P arranged on the insulating layer 2011. Accordingly, the positive-side terminals 21P of the smoothing capacitors 21 and the positive-side bus bar 20P can be directly connected. In the positive-side bus bar 20P, relatively large through holes are provided to expose, in the plan view, the negative-side terminals 21N of the smoothing capacitors 21 (the fastening through holes formed in the negative-side bus bar 20N). Accordingly, a worker can access the fastening through holes formed in the negative-side bus bar 20N that is the layer below the positive-side bus bar 20P.

As illustrated in FIG. 4 and FIG. 5, in the insulating layer 20I2 of the uppermost layer, relatively large through holes are provided to expose, in the plan view, the positive-side terminals 21P of the smoothing capacitors 21 (the fastening through holes formed in the positive-side bus bar 20P) and the negative-side terminals 21N of the smoothing capacitors 21 (the fastening through holes formed in the negative-side bus bar 20N).

The positive-side bus bar 20P and the negative-side bus bar 20N of the laminate bus bar 20PN have, for example, substantially the same thickness. Accordingly, the current densities of the positive-side bus bar 20P and the negative-side bus bar 20N are substantially the same.

The laminate bus bar 20PN may be arranged in the housing 1H so as to relatively increase (preferably, so as to maximize) the size of area in which the positive-side bus bar 20P and the negative-side bus bar 20N overlap with each other. The laminate bus bar 20PN may be configured so that the thickness of the insulating layer 2011 is set so as to ensure the insulation property between the positive-side bus bar 20P and the negative-side bus bar 20N while relatively reducing the distance therebetween. Accordingly, the electric current paths flowing in the opposite directions can be brought closer to each other. Therefore, at least portions of the magnetic fields generated by the electric current of the positive-side bus bar 20P and the magnetic field generated by the electric current of the negative-side bus bar 20N are cancelled, so that the inductances of the positive-side bus bar 20P and the negative-side bus bar 20N can be reduced. Also, as described above, in a case where the current densities are substantially the same, the magnitude of the magnetic fields generated by the electric current of the positive-side bus bar 20P and the electric current of the negative-side bus bar 20N become substantially the same, so that most of the generated magnetic fields can be canceled. Therefore, the inductances of the positive-side bus bar 20P and the negative-side bus bar 20N can be further alleviated. Therefore, according to the decrease in the inductances of the positive-side bus bar 20P and the negative-side bus bar 20N, the surge voltage of the power conversion apparatus 1 can be alleviated.

As described above, the inverter circuit 40 includes the bridge circuit constituted by the U-phase circuit 41, the V-phase circuit 42, and the W-phase circuit 43.

As illustrated in FIG. 2 and FIG. 3, the U-phase circuit 41, the V-phase circuit 42, and the W-phase circuit 43 are arranged next to each other in order in the Y axis direction from an end portion in the negative direction of the Y axis toward an end portion in the positive direction of the Y axis.

The U-phase circuit 41 includes four switch modules 410 (corresponding to the switch modules 411 to 414 explained above).

The four switch modules 410 are arranged such that two groups, in each of which two switch modules 410 are arranged next to each other in the X axis direction, are arranged next to each other in two rows in the Y axis direction. The four switch modules 410 are arranged on other components (for example, a control circuit of the power conversion apparatus 1, a drive circuit of the semiconductor switches 410s, 420s, and 430s, a cooling mechanism of the inverter circuit 40, and the like) arranged on the bottom surface of the housing 1H. This can relatively reduce the difference in the upper end position from the smoothing capacitors 21 of relatively large sizes in the Z axis direction. Therefore, the position of the positive-side bus bar 20P and the negative-side bus bar 20N in the Z axis direction and the position of the U-phase positive-side direct current bus bar 41P and the U-phase negative-side direct current bus bar 41N in the Z axis direction can be relatively brought closer to each other.

As illustrated in FIG. 4 and FIG. 5, the switch module 410 has a box shape with cutouts and seat surfaces for bolts at the corner portions in the plan view.

In the plan view, the longitudinal direction of the switch modules 410 are arranged substantially in the X axis direction. In the switch module 410, the alternating current output terminal 4100, the negative-side terminal 410N, and the positive-side terminal 410P are arranged, in an ascending order of the distance from the smoothing circuit 20 (the smoothing capacitors 21), next to each other along the longitudinal direction of the switch module 410 (the X axis direction).

The U-phase circuit 41 may have a switch leg in a form different from the form in which series-connected bodies each having two semiconductor switches 410s are accommodated in a housing in advance in a manner similarly with the switch modules 410. Hereinafter, this is also applicable to the switch module 420 of the V-phase circuit 42 and the switch module 430 of the W-phase circuit 43, and is also applicable to the second to fourth embodiments explained later.

On the upper end portion of the switch module 410, the U-phase laminate bus bar 41PN is arranged substantially parallel to the X axis direction and the Y axis direction. Specifically, the U-phase laminate bus bar 41PN is configured to be integrally connected to the V-phase laminate bus bar 42PN and W-phase laminate bus bar 43PN explained later. In other words, on the upper end portion of the switch module 410, a laminate bus bar 40PN including the U-phase laminate bus bar 41PN, the V-phase laminate bus bar 42PN, and the W-phase laminate bus bar 43PN is arranged substantially parallel to the X axis direction and the Y axis direction. Hereinafter, this is also applicable to the second to fourth embodiments explained later.

The U-phase laminate bus bar 41PN is arranged in a range that covers the four switch modules 410 in the X axis direction and the Y axis direction.

As illustrated in FIG. 4 and FIG. 5, the U-phase laminate bus bar 41PN is structured by stacking the U-phase positive-side direct current bus bar 41P and the U-phase negative-side direct current bus bar 41N with the insulating layer 41I1 interposed therebetween. Specifically, the U-phase laminate bus bar 41PN has a four-layer laminated structure including the U-phase negative-side direct current bus bar 41N arranged in the lowermost layer, the insulating layer 41I1 arranged thereon, the U-phase positive-side direct current bus bar 41P arranged thereon, and the insulating layer 41I2 arranged in the uppermost layer.

The U-phase positive-side direct current bus bar 41P is configured to be integrally connected to the V-phase positive-side direct current bus bar 42P and the W-phase positive-side direct current bus bar 43P explained later (for example, configured as an integrated plate-shaped member). Specifically, as illustrated in FIG. 6, the laminate bus bar 40PN includes a positive-side direct current bus bar 40P configured to include the U-phase positive-side direct current bus bar 41P, the V-phase positive-side direct current bus bar 42P, and the W-phase positive-side direct current bus bar 43P. Hereinafter, this is also applicable to the second to fourth embodiments explained later.

The U-phase negative-side direct current bus bar 41N is configured to be integrally connected to the V-phase negative-side direct current bus bar 42N and the W-phase negative-side direct current bus bar 43N explained later (for example, configured as an integrated plate-shaped member). Specifically, as illustrated in FIG. 6, the laminate bus bar 40PN includes a negative-side direct current bus bar 40N configured to include the U-phase negative-side direct current bus bar 41N, the V-phase negative-side direct current bus bar 42N, and the W-phase negative-side direct current bus bar 43N. Hereinafter, this is also applicable to the second to fourth embodiments explained later.

The insulating layer 41I1 is configured to be integrally connected to the insulating layer 4211 and the insulating layer 4311 explained later (for example, configured as an integrated plate-shaped member). Likewise, the insulating layer 42I2 is configured to be integrally connected to the insulating layer 42I2 and the insulating layer 43I2 explained later (for example, configured as an integrated plate-shaped member). Hereinafter, this is also applicable to the second to fourth embodiments explained later.

As illustrated in FIG. 4 to FIG. 6, relatively small through holes in which bolts are fastened to fix the negative-side terminals 410N of the switch modules 410 are provided in the U-phase negative-side direct current bus bar 41N of the lowermost layer. Accordingly, the negative-side terminals 410N of the switch modules 410 and the U-phase negative-side direct current bus bar 41N can be directly connected. In the U-phase negative-side direct current bus bar 41N, relatively large substantially rectangular through holes are provided to expose the positive-side terminals 410P in the plan view. Accordingly, the U-phase positive-side direct current bus bar 41P, which is in the layer higher than the U-phase negative-side direct current bus bar 41N, and the positive-side terminals 410P can be connected. In the U-phase negative-side direct current bus bar 41N, relatively large substantially rectangular through holes are provided to expose the alternating current output terminals 4100 in the plan view. Accordingly, the U-phase alternating current bus bar 410, which is in the layer higher than the U-phase negative-side direct current bus bar 41N, and the alternating current output terminals 4100 can be connected.

As illustrated in FIG. 4 and FIG. 5, relatively large substantially rectangular through holes corresponding to the switch modules 410 are provided in the insulating layer 41I1 arranged on the U-phase negative-side direct current bus bar 41N. Accordingly, the positive-side terminal 410P, the negative-side terminal 410N (the fastening through hole of the U-phase negative-side direct current bus bar 41N), and the alternating current output terminal 4100 can be exposed in the plan view.

As illustrated in FIG. 4 to FIG. 6, relatively small through holes in which bolts are fastened to fix the positive-side terminals 410P of the switch modules 410 are provided in the U-phase positive-side direct current bus bar 41P on the insulating layer 41I1. Accordingly, the positive-side terminals 410P of the switch modules 410 and the U-phase positive-side direct current bus bar 41P can be directly connected. In the U-phase positive-side direct current bus bar 41P, relatively large through holes are provided to expose, in the plan view, the negative-side terminals 410N (the fastening through holes formed in the U-phase negative-side direct current bus bar 41N) and the alternating current output terminals 4100 of the switch modules 410. Accordingly, a worker can access the fastening through hole formed in the U-phase negative-side direct current bus bar 41N that is the layer below the U-phase positive-side direct current bus bar 41P and can access the alternating current output terminal 4100.

As illustrated in FIG. 4 and FIG. 5, relatively large rectangular through holes corresponding to the switch modules 410 are provided in the insulating layer 41I2 of the uppermost layer. Therefore, the positive-side terminals 410P of the switch modules 410 (the fastening through holes formed in the U-phase positive-side direct current bus bar 41P), the negative-side terminals 410N of the switch modules 410 (the fastening through holes formed in the U-phase negative-side direct current bus bar 41N), and the alternating current output terminals 4100 of the switch modules 410 can be exposed in the plan view.

The U-phase positive-side direct current bus bar 41P and the U-phase negative-side direct current bus bar 41N of the U-phase laminate bus bar 41PN has, for example, substantially the same thickness. Accordingly, the current densities of the U-phase positive-side direct current bus bar 41P and the U-phase negative-side direct current bus bar 41N are substantially the same.

As illustrated in FIG. 2 to FIG. 6, the U-phase alternating current bus bar 410 connects the alternating current output terminals 4100 of the switch modules 410 and the U-phase output terminal 41T. The U-phase alternating current bus bar 410 includes a U-phase parallel connection bus bar 4101 and a U-phase output bus bar 4102.

The U-phase parallel connection bus bar 4101 is, of the entire configuration of the U-phase alternating current bus bar 410, a constituent portion for connecting the alternating current output terminals 4100 of the four switch modules 410 in parallel. Specifically, the U-phase parallel connection bus bar 4101 is, of the entire configuration of the U-phase alternating current bus bar 410, a constituent portion for merging power paths from the alternating current output terminals 4100 of the four switch modules 410 toward the U-phase output terminal 41T.

As illustrated in FIG. 2 and FIG. 3, the U-phase parallel connection bus bar 4101 is configured to be in a plane-symmetrical arrangement about the plane perpendicular to the X axis at the central position between two switch modules 410 arranged next to each other in the X axis direction. Also, the U-phase parallel connection bus bar 4101 is configured to be in a plane-symmetrical arrangement about the plane perpendicular to the Y axis at the central position between two rows of switch modules 410 arranged next to each other in the Y axis direction. The U-phase parallel connection bus bar 4101 is connected to a position of the U-phase output bus bar 4102 corresponding to the central position, in the X axis direction and the Y axis direction, of the alternating current output terminals 4100 of the four switch modules 410. Accordingly, the lengths of the paths from the alternating current output terminals 4100 of the four switch modules 410 to the merging point where the paths are merged toward the U-phase output terminal 41T can be made substantially the same. In addition, the current densities of the paths from the alternating current output terminals 4100 of the four switch modules 410 to the merging point where the paths are merged toward the U-phase output terminal 41T can be made substantially the same. Therefore, the inductances of the power paths between the four switch modules 410 and the U-phase output terminal 41T can be made substantially the same.

Specifically, the U-phase parallel connection bus bar 4101 includes two leg portions 41O1a and an interconnection portion 41O1b.

Each of the two leg portions 41O1a has a flat plate-like shape substantially parallel to the X axis direction and the Z axis direction. Each of the two leg portions 41O1a connect the alternating current output terminals 4100 of two switch modules 410, arranged next to each other in the X axis direction, with the switch modules 410 being arranged in two rows in the Y axis direction. The two leg portions 41O1a are configured to be in a plane-symmetrical arrangement about the plane perpendicular to the X axis direction at a substantially central position between the alternating current output terminals 4100 of the two switch modules 410 arranged next to each other in the X axis direction. Specifically, the leg portion 41O1a includes two bottom surface portions, two lower leg portions, an intermediate leg portion, and an upper leg portion. The two bottom surface portions are in a substantially rectangular shape in the plan view and placed on the alternating current output terminals 4100 of the two switch modules 410 arranged next to each other in the X axis direction, and have fastening holes in which bolts are fastened to fix the alternating current output terminals 4100. The two lower leg portions are arranged to extend upward from the two bottom surface portions. The intermediate leg portion connects the two lower leg portions with each other so as to extend in the X axis direction. The upper leg portion is provided to extend upward from a central position, in the X axis direction, of the upper end of the intermediate leg portion. Accordingly, the leg portion 41O1a can merge, at substantially the same distance, the paths from the alternating current output terminals 4100 of the two switch modules 410. In addition, with the leg portion 41O1a, the sizes of the cross-sectional areas of the paths from the alternating current output terminals 4100 of the two switch modules 410 can be made substantially the same, and the current densities can be made substantially the same. The two leg portions 41O1a are configured to be in a plane-symmetrical arrangement about the plane perpendicular to the Y axis direction at a substantially central position between the alternating current output terminals 4100 of two switch modules 410 arranged next to each other in the Y axis direction. Accordingly, with the two leg portions 41O1a, the distances of the paths from the two switch modules 410 to the merging point can be made substantially the same.

The interconnection portion 41O1b has a flat plate-like shape substantially parallel to the X axis direction and the Y axis direction, and connects the two leg portions 41O1a arranged next to each other in the Y axis direction. Specifically, the interconnection portion 41O1b has a substantially rectangular shape in the plan view, and connects the upper leg portions of the two leg portions 41O1a with each other so as to extend in the Y axis direction. The interconnection portion 41O1b is configured to be in a plane-symmetrical arrangement about the plane perpendicular to the Y axis at a substantially central position between the two leg portions 41O1a in the Y axis direction, i.e., a substantially central position between the alternating current output terminals 4100 of the two switch modules 410 (in two rows) arranged next to each other in the Y axis direction. Also, the interconnection portion 41O1b is connected to the U-phase output bus bar 4102 at a substantially central position between the two leg portions 41O1a in the Y axis direction. Accordingly, while the U-phase parallel connection bus bar 4101 merges the paths from the four switch modules 410 by twos to have the same length, the U-phase parallel connection bus bar 4101 makes the lengths of all of the paths be substantially the same, and makes the current densities of the respective paths be the same.

The U-phase output bus bar 4102 is arranged to extend, in the plan view, toward the negative direction of the X axis from the central portion in the Y axis direction of the interconnection portion 41O1b of the U-phase parallel connection bus bar 4101, and is connected to the U-phase output terminal 41T.

Similarly with the U-phase circuit 41, the V-phase circuit 42 includes the four switch modules 420.

The arrangement structure of the four switch modules 420 is similar to the case of the four switch modules 410 of the U-phase circuit 41, and therefore, the explanation thereabout is omitted.

As illustrated in FIG. 4 and FIG. 5, the external shapes of the switch modules 420 are similar to those of the switch modules 410.

In the plan view, the longitudinal direction of the switch module 420 is arranged substantially in the X axis direction. In the switch module 420, the alternating current output terminal 420O, the negative-side terminal 420N, and the positive-side terminal 420P are arranged, in an ascending order of the distance from the smoothing circuit 20 (the smoothing capacitors 21), next to each other along the longitudinal direction of the switch module 420 (the X axis direction).

On the upper end portion of the switch module 420, the V-phase laminate bus bar 42PN is arranged substantially parallel to the X axis direction and the Y axis direction.

The V-phase laminate bus bar 42PN is arranged in a range that covers the four switch modules 420 in the X axis direction and the Y axis direction.

As illustrated in FIG. 4 and FIG. 5, the V-phase laminate bus bar 42PN is structured by stacking the V-phase positive-side direct current bus bar 42P and the V-phase negative-side direct current bus bar 42N with the insulating layer 4211 interposed therebetween. Specifically, the V-phase laminate bus bar 42PN has a four-layer laminated structure including the V-phase negative-side direct current bus bar 42N arranged in the lowermost layer, the insulating layer 4211 arranged thereon, the V-phase positive-side direct current bus bar 42P arranged thereon, and the insulating layer 42I2 arranged in the uppermost layer.

As described above, the V-phase positive-side direct current bus bar 42P is configured to be integrally connected to the U-phase positive-side direct current bus bar 41P and the W-phase positive-side direct current bus bar 43P explained later.

As described above, the V-phase negative-side direct current bus bar 42N is configured to be integrally connected to the U-phase negative-side direct current bus bar 41N and the W-phase negative-side direct current bus bar 43N explained later.

As described above, the insulating layer 4211 is configured to be integrally connected to the insulating layer 41I1 and the insulating layer 43I1 explained later. Likewise, as described above, the insulating layer 42I2 is configured to be integrally connected to the insulating layer 41I2 and the insulating layer 43I2 explained later.

The detailed structure of the V-phase laminate bus bar 42PN is similar to the case of the U-phase laminate bus bar 41PN, and therefore, the explanation thereabout is omitted.

As illustrated in FIG. 2 to FIG. 6, the V-phase alternating current bus bar 42O connects the alternating current output terminals 420O of the switch modules 420 and the V-phase output terminal 42T. The V-phase alternating current bus bar 42O includes a V-phase parallel connection bus bar 4201 and a V-phase output bus bar 42O2.

The arrangement and the structure of the V-phase alternating current bus bar 42O are similar to the case of the U-phase alternating current bus bar 410, and therefore, the explanation thereabout is omitted.

Similarly with the U-phase circuit 41, the W-phase circuit 43 includes the four switch modules 430.

The arrangement structure of the four switch modules 430 is similar to the case of the four switch modules 410 of the U-phase circuit 41, and therefore, the explanation thereabout is omitted.

As illustrated in FIG. 4 and FIG. 5, the external shape of the switch module 430 is similar to the switch module 410.

In the plan view, the longitudinal direction of the switch module 430 is arranged substantially in the X axis direction. In the switch module 430, the alternating current output terminal 430O, the negative-side terminal 430N, and the positive-side terminal 430P are arranged, in an ascending order of the distance from the smoothing circuit 20 (the smoothing capacitors 21), next to each other along the longitudinal direction of the switch module 430 (the X axis direction).

On the upper end portion of the switch module 430, the W-phase laminate bus bar 43PN is arranged substantially parallel to the X axis direction and the Y axis direction.

The W-phase laminate bus bar 43PN is arranged in a range that covers the four switch modules 430 in the X axis direction and the Y axis direction.

As illustrated in FIG. 4 and FIG. 5, the W-phase laminate bus bar 43PN is structured by stacking the W-phase positive-side direct current bus bar 43P and the W-phase negative-side direct current bus bar 43N with the insulating layer 4311 interposed therebetween. Specifically, the W-phase laminate bus bar 43PN has a four-layer laminated structure including the W-phase negative-side direct current bus bar 43N arranged in the lowermost layer, the insulating layer 4311 arranged thereon, the W-phase positive-side direct current bus bar 43P arranged thereon, and the insulating layer 43I2 arranged in the uppermost layer.

As described above, the W-phase positive-side direct current bus bar 43P is configured to be integrally connected to the U-phase positive-side direct current bus bar 41P and the V-phase positive-side direct current bus bar 42P.

As described above, the W-phase negative-side direct current bus bar 43N is configured to be integrally connected to the U-phase negative-side direct current bus bar 41N and the V-phase negative-side direct current bus bar 42N.

As described above, the insulating layer 4311 is configured to be integrally connected to the insulating layer 41I1 and the insulating layer 4211. Likewise, as described above, the insulating layer 43I2 is configured to be integrally connected to the insulating layer 41I2 and the insulating layer 42I2.

The detailed structure of the W-phase laminate bus bar 43PN is similar to the case of the U-phase laminate bus bar 41PN, and therefore, the explanation thereabout is omitted.

As illustrated in FIG. 2 to FIG. 6, the W-phase alternating current bus bar 43O connects the alternating current output terminals 430O of the switch modules 430 and the W-phase output terminal 43T. The W-phase alternating current bus bar 43O includes a W-phase parallel connection bus bar 4301 and a W-phase output bus bar 43O2.

The arrangement and the structure of the W-phase alternating current bus bar 43O are similar to the case of the U-phase alternating current bus bar 410, and therefore, the explanation thereabout is omitted.

The laminate bus bar 40PN may be arranged in the housing 1H so as to relatively increase (preferably, so as to maximize) the size of area where the positive-side direct current bus bar 40P and the negative-side direct current bus bar 40N overlap with each other. Also, the laminate bus bar 40PN may be configured so that the thicknesses of the insulating layers 41I1, 4211, and 4311 are set so that, while the insulation property between the positive-side direct current bus bar 40P and the negative-side direct current bus bar 40N is ensured, the distance between the positive-side direct current bus bar 40P and the negative-side direct current bus bar 40N relatively decreases. Accordingly, in the space, the electric current paths flowing in the opposite directions can be brought closer to each other. Therefore, at least portions of the magnetic field generated by the electric current of the positive-side direct current bus bar 40P and the magnetic field generated by the electric current of the negative-side direct current bus bar 40N can be cancelled. This is because, for example, in a case where an electric current of the U-phase flows in the positive-side direct current bus bar 40P, an electric current of the V-phase and the W-phase flows in the negative-side direct current bus bar 40N. Therefore, the inductances of the positive-side direct current bus bar 40P and the negative-side direct current bus bar 40N can be reduced. Also, as described above, in a case where the current densities are substantially the same, the magnitudes of the magnetic fields generated by both of the electric current of the positive-side direct current bus bar 40P and the electric current of the negative-side direct current bus bar 40N become substantially the same, so that most of the generated magnetic fields can be cancelled. Therefore, the inductances of the positive-side direct current bus bar 40P and the negative-side direct current bus bar 40N can be further alleviated. Therefore, in accordance with the decrease in the inductances of the positive-side direct current bus bar 40P and the negative-side direct current bus bar 40N, the surge voltage of the power conversion apparatus 1 can be reduced.

In this manner, in the first embodiment, the positive-side bus bar 20P and the negative-side bus bar 20N of the smoothing circuit 20 have a laminated structure stacked with the insulating layer 2011 interposed therebetween. Likewise, the positive-side direct current bus bar 40P and the negative-side direct current bus bar 40N of the inverter circuit 40 have a laminated structure stacked one over another with the insulating layers 41I1, 4211, and 4311 interposed therebetween. Accordingly, in the circuits of the power paths between the smoothing circuit 20 and the output terminal 40T, the inductance of the direct current portion can be significantly reduced. Therefore, the surge voltage caused by switching operations of the semiconductor switches 410s, 420s, and 430s of the power conversion apparatus 1 can be alleviated.

Also, in the first embodiment, the U-phase parallel connection bus bar 4101 is configured so that the lengths of the paths from the alternating current output terminals 4100 of the four switch modules 410 to the merging point where the paths are merged toward the U-phase output terminal 41T are made substantially the same. Specifically, the U-phase parallel connection bus bar 4101 is configured so that the lengths of the power paths between (the alternating current output terminals 4100 of) the four switch modules 410 and the connection portion with the U-phase output bus bar 4102 are substantially the same. Accordingly, the difference in the inductances of the power paths between the alternating current output terminals 4100 of the four switch modules 410 and the U-phase output terminal 41T can be relatively reduced. Therefore, the difference in the inductances of the circuits of respective power paths, passing through the four switch modules 410, between the smoothing circuit 20 and the U-phase output terminal 41T can be relatively reduced. In addition, the U-phase parallel connection bus bar 4101 is configured so that the current densities of the power paths from the alternating current output terminals 4100 of the four switch modules 410 to the merging point where the power paths are merged toward the U-phase output terminal 41T are made substantially the same. Accordingly, all of the inductances of the respective power paths between the alternating current output terminals 4100 of the four switch modules 410 and the U-phase output terminal 41T can be made substantially the same. Therefore, the inductances of the circuits of the power paths, passing through the four switch modules 410, between the smoothing circuit 20 and the U-phase output terminal 41T can be made substantially the same. Likewise, the V-phase parallel connection bus bar 4201 is configured so that the lengths of the power paths from the alternating current output terminals 420O of the four switch modules 420 to the merging point where the paths are merged toward the V-phase output terminal 42T are substantially the same. Accordingly, the difference in the inductances of the power paths between the alternating current output terminals 420O of the four switch modules 420 and the V-phase output terminal 42T can be relatively reduced. Therefore, the difference in the inductances of the circuits of respective power paths, passing through the four switch modules 420, between the smoothing circuit 20 and the V-phase output terminal 42T can be relatively reduced. In addition, the V-phase parallel connection bus bar 4201 is configured so that the current densities of the power paths from the alternating current output terminals 420O of the four switch modules 420 to the merging point where the power paths are merged toward the V-phase output terminal 42T are made substantially the same. Therefore, the inductances of the circuits of the power paths, passing through the four switch modules 420, between the smoothing circuit 20 and the V-phase output terminal 42T can be made substantially the same. Therefore, the inductances of the circuits of the power paths, passing through the four switch modules 420, between the smoothing circuit 20 and the V-phase output terminal 42T can be made substantially the same. Likewise, the W-phase parallel connection bus bar 4301 is configured so that the lengths of the power paths from the alternating current output terminals 430O of the four switch modules 430 to the merging point where the paths are merged toward the W-phase output terminal 43T are substantially the same. Accordingly, the difference in the inductances of the power paths between the alternating current output terminals 430O of the four switch modules 430 and the W-phase output terminal 43T can be relatively reduced. Therefore, the difference in the inductances of the circuits of respective power paths, passing through the four switch modules 430, between the smoothing circuit 20 and the W-phase output terminal 43T can be relatively reduced. In addition, the W-phase parallel connection bus bar 4301 is configured so that the current densities of the power paths from the alternating current output terminals 430O of the four switch modules 430 to the merging point where the power paths are merged toward the W-phase output terminal 43T are made substantially the same. Accordingly, all of the inductances of the respective power paths between the alternating current output terminals 430O of the four switch modules 430 and the W-phase output terminal 43T can be made substantially the same. Therefore, the inductances of the circuits of the power paths, passing through the four switch modules 430, between the smoothing circuit 20 and the W-phase output terminal 43T can be made substantially the same. As described above, this is because, in the circuits of the power paths between the smoothing circuit 20 and the output terminal 40T, the inductance of the direct current portion is extremely small, and the inductance of the alternating current portion is dominant. Therefore, the unbalance in the electric currents of the four switch modules 410, the four switch modules 420, and the four switch modules 430 can be alleviated, and the electric currents can be uniformized.

In the first embodiment, the number of switch modules 410 connected in parallel may be any number so long as the lengths of the power paths from the alternating current output terminals 4100 of the respective switch modules 410 to the merging point where all of the paths are merged toward the U-phase output terminal 41T are substantially the same. Specifically, the number of switch modules 410 connected in parallel may be 2 or 3, or may be 5 or more. For example, in a case where the number of switch modules 410 connected in parallel is two, the U-phase parallel connection bus bar 4101 is constituted by only one leg portion 41O1a, and a substantially central position (a middle point) in the X axis direction of the upper end of the leg portion 41O1a may be configured to be connected to the U-phase output bus bar 4102. This is also applicable to the numbers of switch modules 420 and switch modules 430. Also, in the first embodiment, multiple switch modules 410 may be arranged in any way so long as the lengths of the power paths from the alternating current output terminals 4100 of the respective switch modules 410 to the merging point where all of the paths are merged toward the U-phase output terminal 41T are substantially the same. For example, three or more switch modules 410 may be arranged in the X axis direction. For example, three or more rows extending in the X axis direction, in each row of which multiple switch modules 410 are arranged in the X axis direction, may be arranged in the Y axis direction. For example, the number of rows and columns arranged in the X axis direction and the Y axis direction are preferably powers of two. Accordingly, as described above, while the paths from the alternating current output terminals 4100 of the respective switch modules 410 are merged by twos to have the same length, the lengths of all of the paths and the current densities of the paths can be made substantially the same. This is also applicable to the arrangements of switch modules 420 and switch modules 430. Also, in the first embodiment, the configuration of the U-phase parallel connection bus bar 4101 may be in any way so long as the lengths of the power paths from the alternating current output terminals 4100 of the respective switch modules 410 to the merging point where all of the paths are merged toward the U-phase output terminal 41T are substantially the same. For example, the U-phase parallel connection bus bar 4101 does not have to be configured in a plane-symmetrical arrangement as described above, so long as the lengths of the power paths from the alternating current output terminals 4100 of the four switch modules 410 to the merging point where all of the paths are merged toward the U-phase output terminal 41T are substantially the same. Specifically, the two leg portions 41O1a of the U-phase parallel connection bus bar 4101 do not have to be in a plane-symmetrical arrangement about the plane perpendicular to the Y axis direction, and may be configured to have substantially the same shapes spaced apart from each other in the Y axis direction. This is also applicable to the V-phase parallel connection bus bar 4201 the W-phase parallel connection bus bar 4301.

### [Second embodiment]

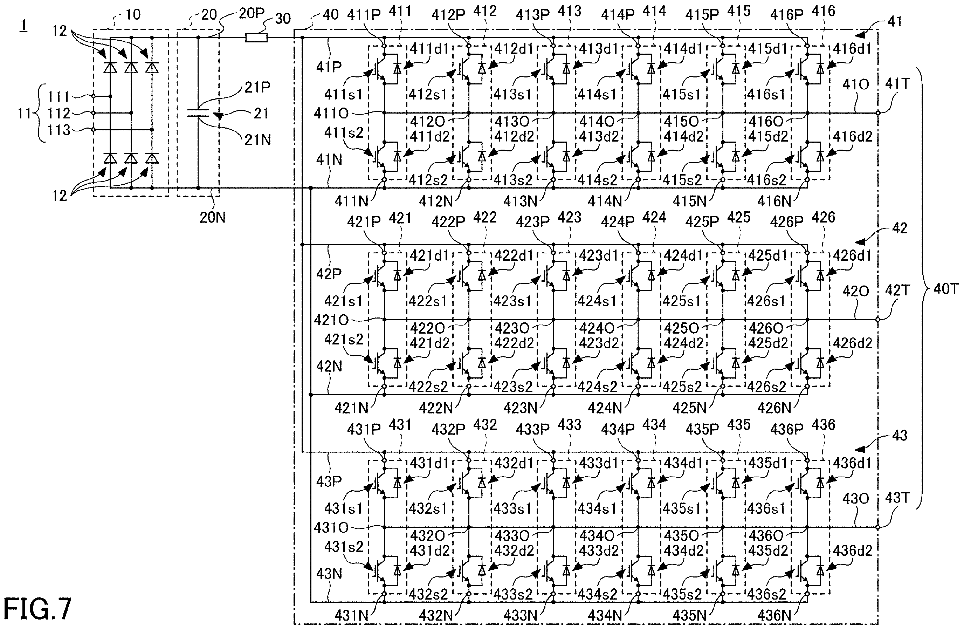

Subsequently, the second embodiment is explained with reference to FIG. 7 to FIG. 10. Hereinafter, features different from the power conversion apparatus 1 according to the first embodiment are mainly explained, and explanations about the same contents as or contents corresponding to the first embodiment may be simplified or omitted.

### <Overview of power conversion apparatus>

FIG. 7 is a circuit diagram illustrating an example of a power conversion apparatus 1 according to the second embodiment.

As illustrated in FIG. 7, similarly with the first embodiment, the power conversion apparatus 1 includes a rectifying circuit 10, a smoothing circuit 20, a fuse 30, and an inverter circuit 40.

Similarly with the first embodiment, the inverter circuit 40 includes a bridge circuit constituted by a U-phase circuit 41, a V-phase circuit 42, and a W-phase circuit 43.

Similarly with the first embodiment, the U-phase circuit 41 includes a U-phase positive-side direct current bus bar 41P, a U-phase negative-side direct current bus bar 41N, switch modules 411 to 414, and a U-phase alternating current bus bar 410. In contrast to the case of the first embodiment, the U-phase circuit 41 further includes switch modules 415 and 416. Hereinafter, in the second embodiment, and in the third embodiment and the fourth embodiment explained later, the switch modules 411 to 416 may be collectively referred to as, or any one of the switch modules 411 to 416 may be individually referred to as a "switch module 410". In other words, in contrast to the case of the first embodiment, the U-phase circuit 41 includes six switch modules 410.

The switch modules 411 to 416 (examples of switch legs) are connected in parallel between the U-phase positive-side direct current bus bar 41P and the U-phase negative-side direct current bus bar 41N.

The switch module 415 includes semiconductor switches 415s1, 415s2 corresponding to the upper and lower arms, freewheeling diodes 415d1, 415d2, a positive-side terminal 415P, a negative-side terminal 415N, and an alternating current output terminal 4150.

The switch module 416 includes semiconductor switches 416s1, 416s2 corresponding to the upper and lower arms, freewheeling diodes 416d1, 416d2, a positive-side terminal 416P, a negative-side terminal 416N, and an alternating current output terminal 4160.

Hereinafter, in the second embodiment, and in the third embodiment and the fourth embodiment explained later, the semiconductor switches 411s1, 411s2, 412s1, 412s2, 413s1, 413s2, 414s1, 414s2, 415s1, 415s2, 416s1, and 416s2 may be collectively referred to as, or any one of the semiconductor switches 411s1, 411s2, 412s1, 412s2, 413s1, 413s2, 414s1, 414s2, 415s1, 415s2, 416s1, and 416s2 may be individually referred to as a "semiconductor switch 410s". In the second embodiment, and in the third embodiment and the fourth embodiment explained later, a constituent element of the "switch module 410" which corresponds to the positive-side terminals 411P to 416P may be referred to as a "positive-side terminal 410P". In the second embodiment, and in the third embodiment and the fourth embodiment explained later, a constituent element of the "switch module 410" which corresponds to the negative-side terminals 411N to 416N may be referred to as a "negative-side terminal 410N". In the second embodiment, and in the third embodiment and the fourth embodiment explained later, a constituent element of the "switch module 410" which corresponds to the alternating current output terminals 4110 to 4160 may be referred to as an "alternating current output terminal 410O".

The switch modules 411 to 416 have similar constituent elements, and are constituted by similar circuits.

At one end, the U-phase alternating current bus bar 410 connects the alternating current output terminals 4110 to 4160 of the switch modules 411 to 416, respectively, with each other, and at the other end, the U-phase alternating current bus bar 410 is connected to the U-phase output terminal 41T. Accordingly, the inverter circuit 40 can output the U-phase alternating current power, which is output from the switch modules 411 to 416, to the outside through the U-phase output terminal 41T.

Similarly with the first embodiment, the V-phase circuit 42 includes a V-phase positive-side direct current bus bar 42P, a V-phase negative-side direct current bus bar 42N, switch modules 421 to 424, and a V-phase alternating current bus bar 42O. Unlike the case of the first embodiment, the V-phase circuit 42 further includes switch modules 425 and 426. Hereinafter, in the second embodiment, and in the third embodiment and the fourth embodiment explained later, the switch modules 421 to 426 may be collectively referred to as, or any one of the switch modules 421 to 426 may be individually referred to as a "switch module 420". In other words, in contrast to the case of the first embodiment, the V-phase circuit 42 includes six switch modules 420.

The switch modules 421 to 426 are connected in parallel between the V-phase positive-side direct current bus bar 42P and the V-phase negative-side direct current bus bar 42N.

The switch module 425 includes semiconductor switches 425s1, 425s2 corresponding to the upper and lower arms, freewheeling diodes 425d1, 425d2, a positive-side terminal 425P, a negative-side terminal 425N, and an alternating current output terminal 425O.

The switch module 426 includes semiconductor switches 426s1, 426s2 corresponding to the upper and lower arms, freewheeling diodes 426d1, 426d2, a positive-side terminal 426P, a negative-side terminal 426N, and an alternating current output terminal 426O.

Hereinafter, in the second embodiment, and in the third embodiment and the fourth embodiment explained later, the semiconductor switches 421s1, 421s2, 422s1, 422s2, 423s1, 423s2, 424s1, 424s2, 425s1, 425s2, 426s1, and 426s2 may be collectively referred to as, or any one of the semiconductor switches 421s1, 421s2, 422s1, 422s2, 423s1, 423s2, 424s1, 424s2, 425s1, 425s2, 426s1, and 426s2 may be individually referred to as a "semiconductor switch 420s". In the second embodiment, and in the third embodiment and the fourth embodiment explained later, a constituent element of the "switch module 420" which corresponds to the positive-side terminals 421P to 426P may be referred to as a "positive-side terminal 420P". In the second embodiment, and in the third embodiment and the fourth embodiment explained later, a constituent element of the "switch module 420" which corresponds to the negative-side terminals 421N to 426N may be referred to as a "negative-side terminal 420N". In the second embodiment, and in the third embodiment and the fourth embodiment explained later, a constituent element of the "switch module 420" which corresponds to the alternating current output terminals 4210 to 426O may be referred to as an "alternating current output terminal 420O".

The switch modules 421 to 426 have similar constituent elements, and are constituted by similar circuits.

At one end, the V-phase alternating current bus bar 42O connects the alternating current output terminals 4210 to 426O of the switch modules 421 to 426, respectively, with each other, and at the other end, the V-phase alternating current bus bar 42O is connected to the V-phase output terminal 42T. Accordingly, the inverter circuit 40 can output the V-phase alternating current power, which is output from the switch modules 421 to 426, to the outside through the V-phase output terminal 42T.

Similarly with the first embodiment, the W-phase circuit 43 includes a W-phase positive-side direct current bus bar 43P, a W-phase negative-side direct current bus bar 43N, switch modules 431 to 434, and a W-phase alternating current bus bar 43O. Unlike the case of the first embodiment, the W-phase circuit 43 further includes switch modules 435, 436. Hereinafter, in the second embodiment, and in the third embodiment and the fourth embodiment explained later, the switch modules 431 to 436 may be collectively referred to as, or any one of the switch modules 431 to 436 may be individually referred to as a "switch module 430". In other words, in contrast to the case of the first embodiment, the W-phase circuit 43 includes six switch modules 430.

The switch modules 431 to 436 are connected in parallel between the W-phase positive-side direct current bus bar 43P and the W-phase negative-side direct current bus bar 43N.

The switch module 435 includes semiconductor switches 435s1, 435s2 corresponding to the upper and lower arms, freewheeling diodes 435d1, 435d2, a positive-side terminal 435P, a negative-side terminal 435N, and an alternating current output terminal 435O.

The switch module 436 includes semiconductor switches 436s1, 436s2 corresponding to the upper and lower arms, freewheeling diodes 436d1, 436d2, a positive-side terminal 436P, a negative-side terminal 436N, and an alternating current output terminal 436O.

Hereinafter, in the second embodiment, and in the third embodiment and the fourth embodiment explained later, the semiconductor switches 431s1, 431s2, 432s1, 432s2, 433s1, 433s2, 434s1, 434s2, 435s1, 435s2, 436s1, and 436s2 may be collectively referred to as, or any one of the semiconductor switches 431s1, 431s2, 432s1, 432s2, 433s1, 433s2, 434s1, 434s2, 435s1, 435s2, 436s1, and 436s2 may be individually referred to as a "semiconductor switch 430s". In the second embodiment, and in the third embodiment and the fourth embodiment explained later, a constituent element of the "switch module 430" which corresponds to the positive-side terminals 431P to 436P may be referred to as a "positive-side terminal 430P". In the second embodiment, and in the third embodiment and the fourth embodiment explained later, a constituent element of the "switch module 430" which corresponds to the negative-side terminals 431N to 436N may be referred to as a "negative-side terminal 430N". In the second embodiment, and in the third embodiment and the fourth embodiment explained later, a constituent element of the "switch module 430" which corresponds to the alternating current output terminals 4310 to 436O may be referred to as an "alternating current output terminal 430O".

The switch modules 431 to 436 have similar constituent elements, and are constituted by similar circuits.

At one end, the W-phase alternating current bus bar 43O connects the alternating current output terminals 4310 to 436O of the switch modules 431 to 436, respectively, with each other, and at the other end, the W-phase alternating current bus bar 43O is connected to the W-phase output terminal 43T. Accordingly, the inverter circuit 40 can output the W-phase alternating current power, which is output from the switch modules 431 to 436, to the outside through the W-phase output terminal 43T.

### <Structure of power conversion apparatus>

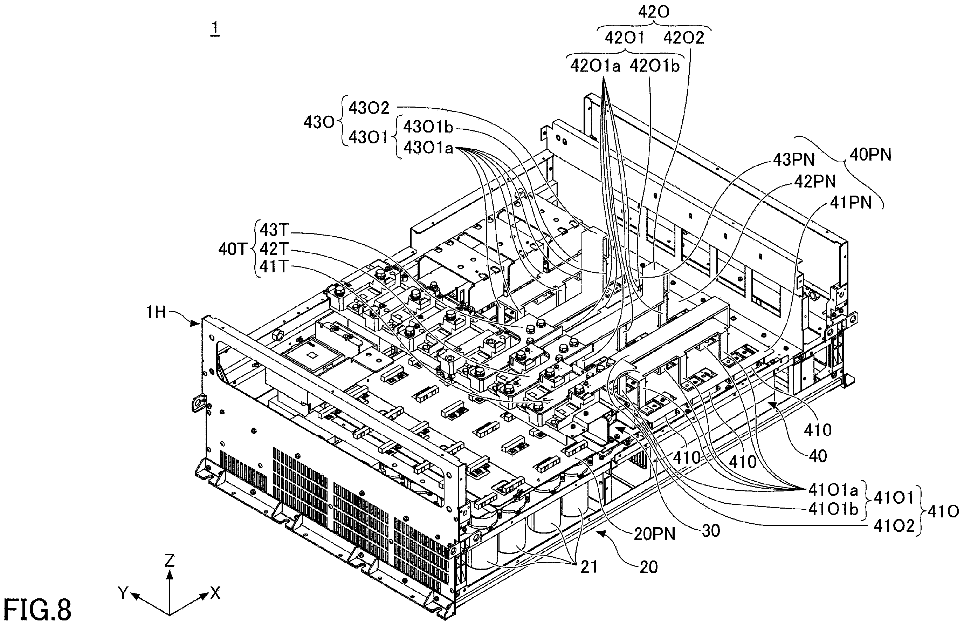

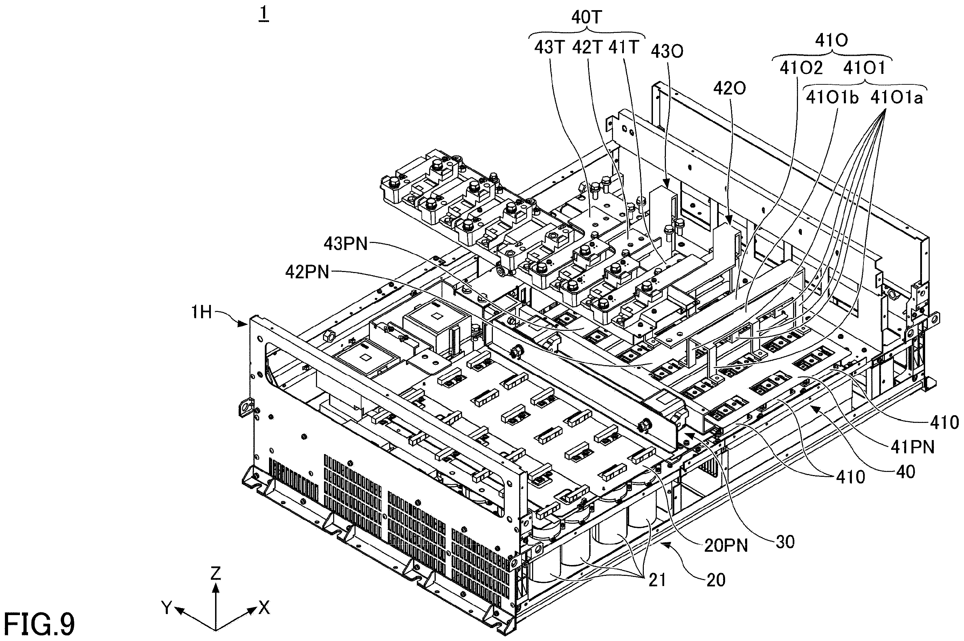

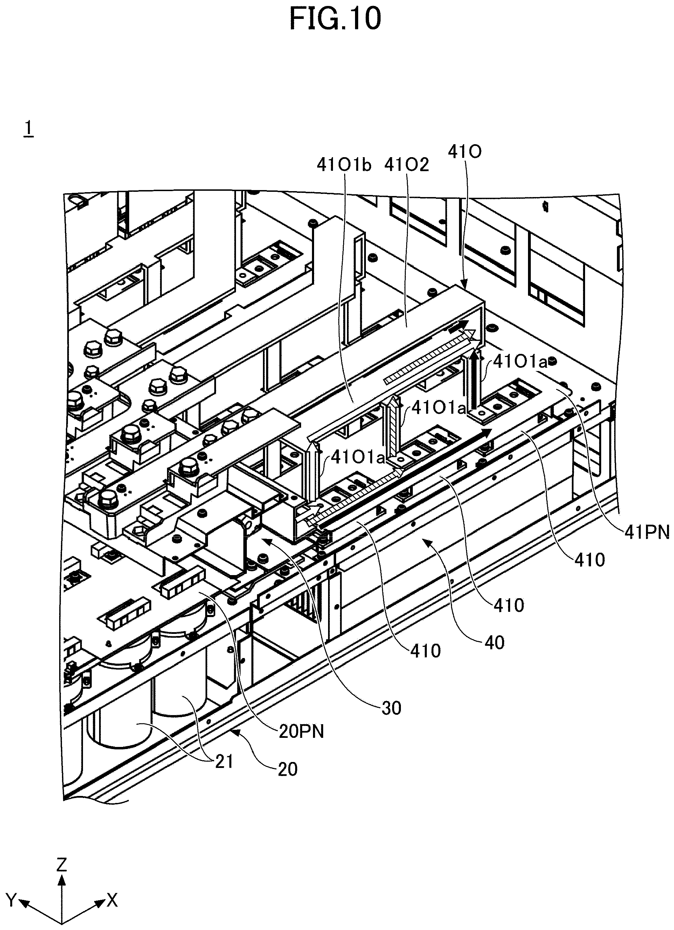

FIG. 8 and FIG. 9 are structural drawings illustrating an example of a power conversion apparatus according to the second embodiment. Specifically, FIG. 8 is a perspective view illustrating the power conversion apparatus 1 from which a portion of a housing 1H is detached. FIG. 9 is an exploded perspective view illustrating a state in which a portion of the housing 1H of the power conversion apparatus 1 is detached, and the output terminal 40T, the U-phase alternating current bus bar 410, the V-phase alternating current bus bar 42O, and the W-phase alternating current bus bar 43O are detached and moved upward. FIG. 10 is a drawing for explaining paths of electric currents flowing through the switch modules 410 arranged next to each other in the X axis direction. In FIG. 10, the paths of the electric currents passing through the three switch modules 410 arranged in the X axis direction are indicated by an outlined arrow, a diagonally hatched arrow, and a solid arrow, which are in the order from the switch module 410 closest to the smoothing circuit 20.

As illustrated in FIG. 8 and FIG. 9, similarly with the first embodiment, the smoothing circuit 20, the fuse 30, and the inverter circuit 40 are arranged next to each other in order from one end portion to the other end portion in the longitudinal direction (in the positive direction of the X axis) of the inner space of the housing 1H.

Similarly with the first embodiment, the output terminal 40T is arranged in a central portion in the longitudinal direction (the X axis direction) in the inner space of the housing 1H and is arranged in an upper portion in the inner space of the housing 1H. Specifically, the output terminal 40T is arranged on or above the smoothing circuit 20 and the fuse 30 in the inner space of the housing 1H.

As described above, the output terminal 40T includes a U-phase output terminal 41T, a V-phase output terminal 42T, and a W-phase output terminal 43T. Similarly with the first embodiment, the U-phase output terminal 41T, the V-phase output terminal 42T, and the W-phase output terminal 43T are arranged next to each other in order from one end portion to the central portion in the lateral direction (in the positive direction of the Y axis) of the inner space of the housing 1H.

As described above, the inverter circuit 40 includes the bridge circuit constituted by the U-phase circuit 41, the V-phase circuit 42, and the W-phase circuit 43.

As illustrated in FIG. 8 and FIG. 9, similarly with the first embodiment, the U-phase circuit 41, the V-phase circuit 42, and the W-phase circuit 43 are arranged next to each other in order in the Y axis direction from an end portion in the negative direction of the Y axis toward an end portion in the positive direction of the Y axis.

The U-phase circuit 41 includes six switch modules 410 (corresponding to the switch modules 411 to 416 explained above).

The six switch modules 410 are arranged such that two groups, in each of which three switch modules 410 are arranged next to each other in the X axis direction, are arranged next to each other in two rows in the Y axis direction. Similarly with the first embodiment, the six switch modules 410 are arranged on other components arranged on the bottom surface of the housing 1H.

Similarly with the first embodiment, in the plan view, the longitudinal direction of the switch modules 410 are arranged substantially in the X axis direction. In the switch module 410, the alternating current output terminal 4100, the negative-side terminal 410N, and the positive-side terminal 410P are arranged, in an ascending order of the distance from the smoothing circuit 20 (the smoothing capacitors 21), next to each other along the longitudinal direction of the switch module 410 (the X axis direction).

As illustrated in FIG. 8 and FIG. 9, similarly with the first embodiment, on the upper end portion of the switch module 410, the U-phase laminate bus bar 41PN is arranged substantially parallel to the X axis direction and the Y axis direction.

The U-phase laminate bus bar 41PN is arranged in a range that covers the six switch modules 410 in the X axis direction and the Y axis direction.

As illustrated in FIG. 8 and FIG. 9, the U-phase alternating current bus bar 410 connects the alternating current output terminals 4100 of the switch modules 410 and the U-phase output terminal 41T. Similarly with the first embodiment, the U-phase alternating current bus bar 410 includes a U-phase parallel connection bus bar 4101 and a U-phase output bus bar 4102.

As illustrated in FIG. 8 and FIG. 9, the U-phase parallel connection bus bar 4101 is connected to the U-phase output bus bar 4102 in proximity to switch modules 410 of the six switch modules 410 farthest from the smoothing circuit 20 in the plan view. Specifically, in the plan view, the U-phase parallel connection bus bar 4101 is connected to the U-phase output bus bar 4102 at a position farther away from the smoothing circuit 20 in the X axis direction than are the switch modules 410 at the end portion away from the smoothing circuit 20 from among the groups, in each of which three switch modules 410 are arranged next to each other in the X axis direction, that are arranged in two rows in the Y axis direction.

More specifically, the U-phase parallel connection bus bar 4101 includes six leg portions 41O1a and an interconnection portion 41O1b.

Each of the six leg portions 41O1a has a flat plate-like shape substantially parallel to the X axis direction and the Z axis direction. The six leg portions 41O1a include: bottom surface portions placed on the alternating current output terminals 4100 of the six respective switch modules 410; and main leg portions extending upward (the positive direction of the z axis) from the respective bottom surface portions. The dimensions of the six leg portions 41O1a in the Z axis direction are set to substantially the same dimensions. The sizes of the cross-sectional areas of the six leg portions 41O1a are set to substantially the same sizes. Accordingly, the current densities of the six leg portions 41O1a can be made substantially the same.

The interconnection portion 41O1b has a flat plate-like shape substantially parallel to the X axis direction and the Y axis direction, and connects the six leg portions 41O1a. Specifically, the interconnection portion 41O1b has a substantially rectangular shape in the plan view, and is arranged to extend in the X axis direction and the Y axis direction in the range in which the six leg portions 41O1a are arranged. The end portion of the interconnection portion 41O1b in the positive direction of the X axis is arranged at a position shifted toward the positive direction of the X axis with respect to the alternating current output terminals 4100 of the two switch modules 410 located at the end portion in the positive direction of the X axis from among the six switch modules 410, and is connected to the U-phase output bus bar 4102.

As illustrated in FIG. 10, in the paths of the electric currents from the direct current input terminal of the U-phase circuit 41 through the three switch modules 410, which are arranged next to each other in the X axis direction, to the connection portion between the U-phase parallel connection bus bar 4101 and the U-phase output bus bar 4102, all of the lengths of the paths flowing in the Z axis direction are substantially the same. This is because, as described above, the dimensions of the six leg portions 41O1a in the Z axis direction are substantially the same. In addition, in the paths of the electric currents from the direct current input terminal of the U-phase circuit 41 through the three switch modules 410, which are arranged next to each other in the X axis direction, to the connection portion between the U-phase parallel connection bus bar 4101 and the U-phase output bus bar 4102, all of the lengths of the paths flowing in the X axis direction are substantially the same. This is because the laminate bus bar 20PN, the U-phase laminate bus bar 41PN, and the interconnection portion 41O1b are arranged substantially parallel in the X axis direction and the Y axis direction. Therefore, the entire lengths of all of the paths of the electric currents from the direct current input terminal of the U-phase circuit 41 through the three switch modules 410, which are arranged next to each other in the X axis direction, to the connection portion between the U-phase parallel connection bus bar 4101 and the U-phase output bus bar 4102 are substantially the same. This is also applicable to the three switch modules 410 arranged next to each other in the X axis direction in the other row. Therefore, the entire lengths of all of the paths of the electric currents from the smoothing circuit 20 through the six switch modules 410 to the U-phase output terminal 41T are substantially the same. Likewise, all of the lengths of the entire paths of the electric currents from the U-phase output terminal 41T through the six switch modules 410 to the smoothing circuit 20 are also substantially the same.

The size of the cross-sectional area, i.e., the width and the thickness, of the interconnection portion 41O1b is set so that the current density of each of the six power paths passing through the six switch modules 410 is substantially the same as the current densities of the U-phase positive-side direct current bus bar 41P and the U-phase negative-side direct current bus bar 41N. Accordingly, the lengths and the current densities of all of the power paths, passing through the six switch modules 410, between the smoothing circuit 20 and the U-phase output terminal 41T are substantially the same. Therefore, the inductances of the circuits of the power paths, passing through the six switch modules 410, between the smoothing circuit 20 and the U-phase output terminal 41T can be made substantially the same and uniformized.

As illustrated in FIG. 8 and FIG. 9, the U-phase output bus bar 4102 connects the U-phase parallel connection bus bar 4101 and the U-phase output terminal 41T. The U-phase output bus bar 4102 includes: a folded portion extending upward from the end portion in the positive direction of the X axis of the interconnection portion 41O1b of the U-phase parallel connection bus bar 4101; and a main portion extending toward the U-phase output terminal 41T substantially parallel to the X axis direction and the Y axis direction from the upper end of the folded portion.

Similarly with the U-phase circuit 41, the V-phase circuit 42 includes six switch modules 420 (corresponding to the switch modules 421 to 426 explained above).

The arrangement structure of the six switch modules 420 is similar to the case of the six switch modules 410 of the U-phase circuit 41, and therefore, the explanation thereabout is omitted.

Similarly with the switch module 410, in the plan view, the longitudinal direction of the switch module 420 is arranged substantially in the X axis direction. In the switch module 420, the alternating current output terminal 420O, the negative-side terminal 420N, and the positive-side terminal 420P are arranged, in an ascending order of the distance from the smoothing circuit 20 (the smoothing capacitors 21), next to each other along the longitudinal direction of the switch module 420 (the X axis direction).

On the upper end portion of the switch module 420, the V-phase laminate bus bar 42PN is arranged substantially parallel to the X axis direction and the Y axis direction.

The V-phase laminate bus bar 42PN is arranged in a range that covers the six switch modules 420 in the X axis direction and the Y axis direction.

As illustrated in FIG. 8 and FIG. 9, the V-phase alternating current bus bar 42O connects the alternating current output terminals 420O of the switch modules 420 and the V-phase output terminal 42T. The V-phase alternating current bus bar 42O includes a V-phase parallel connection bus bar 4201 and a V-phase output bus bar 42O2.

The arrangement and the structure of the V-phase alternating current bus bar 42O are similar to the case of the U-phase alternating current bus bar 410, and therefore, the explanation thereabout is omitted.

Similarly with the U-phase circuit 41, the W-phase circuit 43 includes six switch modules 430 (corresponding to the switch modules 431 to 436 explained above).

The arrangement structure of the six switch modules 430 is similar to the case of the six switch modules 410 of the U-phase circuit 41, and therefore, the explanation thereabout is omitted.

In the plan view, the longitudinal direction of the switch module 430 is arranged substantially in the X axis direction. In the switch module 430, the alternating current output terminal 430O, the negative-side terminal 430N, and the positive-side terminal 430P are arranged, in an ascending order of the distance from the smoothing circuit 20 (the smoothing capacitors 21), next to each other along the longitudinal direction of the switch module 420 (the X axis direction).

On the upper end portion of the switch module 430, the W-phase laminate bus bar 43PN is arranged substantially parallel to the X axis direction and the Y axis direction.

The W-phase laminate bus bar 43PN is arranged in a range that covers the six switch modules 430 in the X axis direction and the Y axis direction.

The detailed structure of the W-phase laminate bus bar 43PN is similar to the case of the U-phase laminate bus bar 41PN, and therefore, the explanation thereabout is omitted.

As illustrated in FIG. 8 and FIG. 9, the W-phase alternating current bus bar 43O connects the alternating current output terminals 430O of the switch modules 430 and the W-phase output terminal 43T. The W-phase alternating current bus bar 43O includes a W-phase parallel connection bus bar 4301 and a W-phase output bus bar 43O2.

The arrangement and the structure of the W-phase alternating current bus bar 43O are similar to the case of the U-phase alternating current bus bar 410, and therefore, the explanation thereabout is omitted.

In this manner, in the second embodiment, the U-phase parallel connection bus bar 4101 is configured so that the lengths of the power paths, passing through the six switch modules 410, between the direct current input terminal of the U-phase laminate bus bar 41PN and the connection portion with the U-phase output bus bar 4102 are substantially the same. In addition, the U-phase parallel connection bus bar 4101 is configured so that the current densities of the entire paths of the respective power paths, passing through the six switch modules 410, between the direct current input terminal of the U-phase laminate bus bar 41PN and the connection portion with the U-phase output bus bar 4102 are substantially the same. Specifically, the six leg portions 41O1a have substantially the same length and substantially the same size of the cross-sectional area as each other, and are configured so that the current densities of all of the six leg portions 41O1a are substantially the same. In addition, the interconnection portion 41O1b is configured so that the current density of each of the power paths passing through the six switch modules 410 is substantially the same as the current densities of the positive-side direct current bus bar 40P and the negative-side direct current bus bar 40N. In other words, the U-phase parallel connection bus bar 4101 is configured so that the current densities of all of the portions of the six power paths of which the lengths are the same (i.e., the six leg portions 4101a) are substantially the same. Also, the U-phase parallel connection bus bar 4101 is configured so that the current densities of portions of the six power paths other than the above-mentioned portions, i.e., portions of the respective power paths of which the lengths are different (i.e., the interconnection portion 4101b), are, for each of the six power paths, substantially the same as the current densities of the positive-side direct current bus bar 40P and the negative-side direct current bus bar 40N. Accordingly, the lengths and the current densities of the circuits of all of the power paths, passing through the six switch modules 410, between the smoothing circuit 20 and the U-phase output terminal 41T are substantially the same. Therefore, the inductances of the circuits of all of the power paths, passing through the six switch modules 410, between the smoothing circuit 20 and the U-phase output terminal 41T can be made substantially the same and uniformized. Likewise, the V-phase parallel connection bus bar 4201 is configured so that the lengths of all of the power paths, passing through the six switch modules 420, between the direct current input terminal of the V-phase laminate bus bar 42PN and the connection portion with the V-phase output bus bar 42O2 are substantially the same. The V-phase parallel connection bus bar 4201 is configured so that the current densities of the entire paths of the respective power paths, passing through the six switch modules 420, between the direct current input terminal of the V-phase laminate bus bar 42PN and the connection portion with the V-phase output bus bar 42O2 are substantially the same. Therefore, the inductances of the circuits of all of the power paths, passing through the six switch modules 420, between the smoothing circuit 20 and the V-phase output terminal 42T can be made substantially the same and uniformized. Likewise, the W-phase parallel connection bus bar 4301 is configured so that the lengths of all of the power paths, passing through the six switch modules 430, between the direct current input terminal of the W-phase laminate bus bar 43PN and the connection portion with the W-phase output bus bar 43O2 are substantially the same. The W-phase parallel connection bus bar 4301 is configured so that the current densities of the entire paths of the respective power paths, passing through the six switch modules 430, between the direct current input terminal of the W-phase laminate bus bar 43PN and the connection portion with the W-phase output bus bar 43O2 are substantially the same. Therefore, the inductances of the circuits of all of the power paths, passing through the six switch modules 430, between the smoothing circuit 20 and the W-phase output terminal 43T can be made substantially the same and uniformized. Accordingly, the unbalance in the electric currents through the six switch modules 410, the six switch modules 420, and the six switch modules 430 can be alleviated, and the electric currents can be uniformized.

In the second embodiment, the number of switch modules 410 connected in parallel may be any number so long as the lengths of the power paths, passing through the respective switch modules 410, between the direct current input terminal of the U-phase laminate bus bar 41PN and the connection portion with the U-phase output bus bar 4102 are substantially the same and so long as the current densities of the respective paths throughout the entire paths are configured to be the same. Specifically, the number of switch modules 410 connected in parallel may be two or more and five or less, or may be seven or more. This is also applicable to the numbers of switch modules 420 and switch modules 430. Also in the second embodiment, the multiple switch modules 410 may be arranged in any arrangement so long as the lengths of the power paths, passing through the respective switch modules 410, between the direct current input terminal of the U-phase laminate bus bar 41PN and the connection portion with the U-phase output bus bar 4102 are substantially the same and so long as the current densities of the respective paths throughout the entire paths are configured to be the same. For example, multiple switch modules 410 may be arranged in one row in the X axis direction, and groups in each of which the switch modules 410 are arranged next to each other in one row in the X axis direction may be arranged in three or more rows in the Y axis direction. This is also applicable to the arrangement of the switch modules 420 and the switch modules 430. In the second embodiment, the configuration of the U-phase parallel connection bus bar 4101 may be in any configuration so long as the lengths of the power paths, passing through the respective switch modules 410, between the direct current input terminal of the U-phase laminate bus bar 41PN and the connection portion with the U-phase output bus bar 4102 are substantially the same and so long as the current densities of the respective paths throughout the entire paths are configured to be the same. For example, the U-phase parallel connection bus bar 4101 may be configured so that only the current densities of the power paths in respective portions between the connection portions with the leg portions 41O1a at both ends in the X axis direction of the interconnection portion 41O1b are substantially the same as in the U-phase positive-side direct current bus bar 41P and the U-phase negative-side direct current bus bar 41N. Specifically, the interconnection portion 41O1b of the U-phase parallel connection bus bar 4101 may be configured so that at least the current densities in path sections from the six switch modules 410 to the merging point where all of the paths are merged are substantially the same as in the U-phase positive-side direct current bus bar 41P and the U-phase negative-side direct current bus bar 41N. This is also applicable to the V-phase parallel connection bus bar 4201 and the W-phase parallel connection bus bar 4301.

### [Third embodiment]

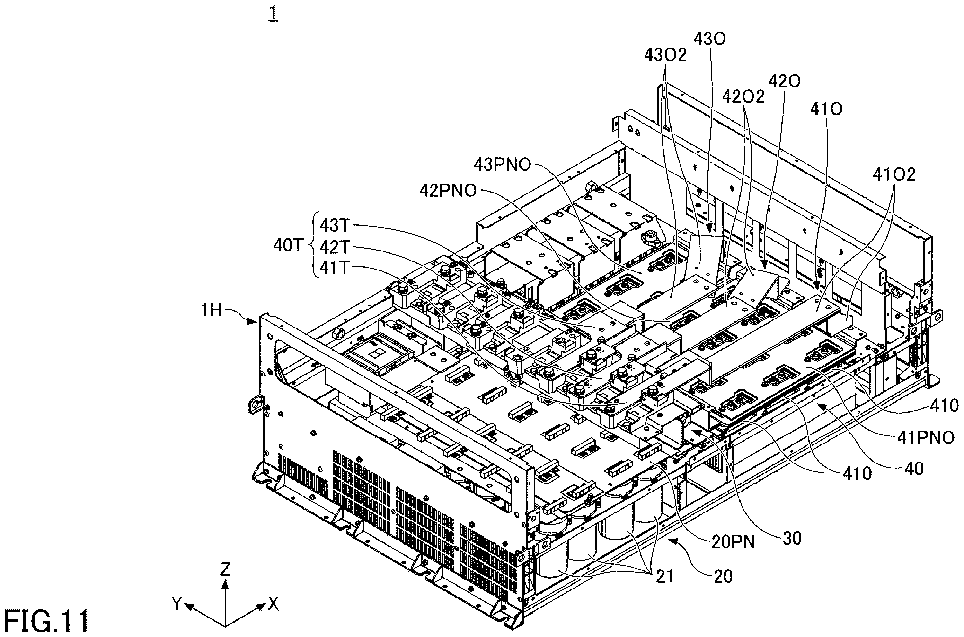

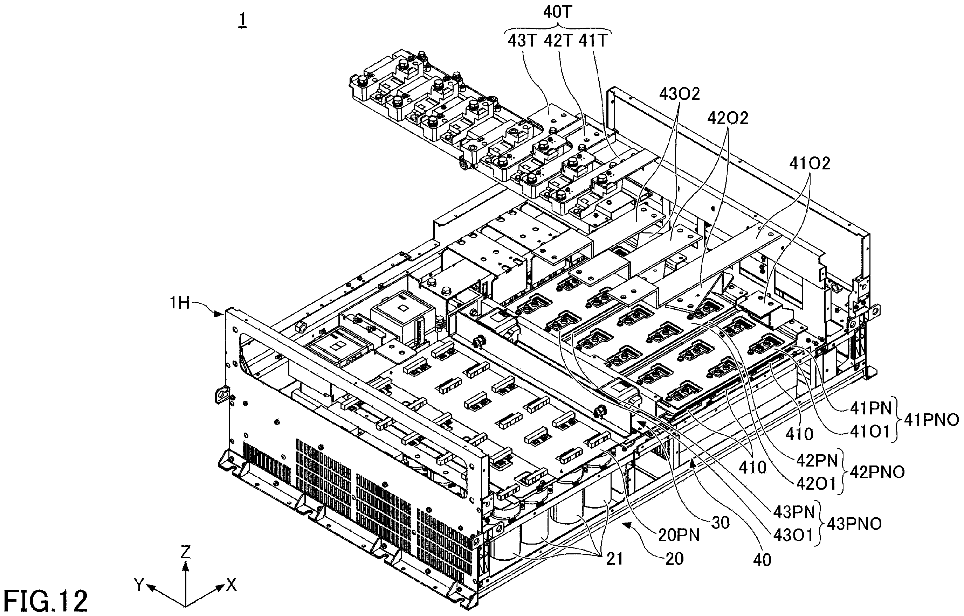

Subsequently, the third embodiment is explained with reference to FIG. 11 and FIG. 12. The circuit configuration of a power conversion apparatus 1 according to the third embodiment is similar to the second embodiment (FIG. 7) explained above, and therefore, the explanation thereabout is omitted. Hereinafter, features different from the power conversion apparatus 1 according to the first embodiment and the second embodiment are mainly explained, and explanations about the same contents as or contents corresponding to the first embodiment and the second embodiment may be simplified or omitted.

### structure of power conversion apparatus>

FIG. 11 and FIG. 12 are structural drawings illustrating an example of the power conversion apparatus 1 according to the third embodiment. Specifically, FIG. 11 is a perspective view illustrating a state in which a portion of the housing 1H of the power conversion apparatus 1 is detached. FIG. 12 is an exploded perspective view illustrating a state in which a portion of the housing 1H of the power conversion apparatus 1 is detached, and the output terminal 40T, the U-phase output bus bar 4102, the V-phase output bus bar 42O2, and the W-phase output bus bar 43O2 are detached and moved upward.

As illustrated in FIG. 11 and FIG. 12, similarly with the first embodiment and the like, the smoothing circuit 20, the fuse 30, and the inverter circuit 40 are arranged next to each other in order from one end portion to the other end portion in the longitudinal direction (in the positive direction of the X axis) of the inner space of the housing 1H.

Similarly with the first embodiment and the like, the output terminal 40T is arranged in a central portion in the longitudinal direction (the X axis direction) in the inner space of the housing 1H and is arranged in an upper portion in the inner space of the housing 1H. Specifically, the output terminal 40T is arranged on or above the smoothing circuit 20 and the fuse 30 in the inner space of the housing 1H.

As described above, the output terminal 40T includes a U-phase output terminal 41T, a V-phase output terminal 42T, and a W-phase output terminal 43T. Similarly with the first embodiment and the like, the U-phase output terminal 41T, the V-phase output terminal 42T, and the W-phase output terminal 43T are arranged next to each other in order from one end portion to the central portion in the
the lateral direction (in the positive direction of the Y axis) of the inner space of the housing 1H.

As described above, the inverter circuit 40 includes the bridge circuit constituted by the U-phase circuit 41, the V-phase circuit 42, and the W-phase circuit 43.

As illustrated in FIG. 11 and FIG. 12, similarly with the first embodiment and the like, the U-phase circuit 41, the V-phase circuit 42, and the W-phase circuit 43 are arranged next to each other in order in the Y axis direction from an end portion in the negative direction of the Y axis toward an end portion in the positive direction of the Y axis.

Similarly with the case of the second embodiment, the U-phase circuit 41 includes six switch modules 410 (corresponding to the switch modules 411 to 416 explained above).

Similarly with the case of the second embodiment, the six switch modules 410 are arranged such that two groups, in each of which three switch modules 410 are arranged next to each other in the X axis direction, are arranged next to each other in two rows in the Y axis direction. Similarly with the first embodiment and the like, the six switch modules 410 are arranged on other components arranged on the bottom surface of the housing 1H.

Similarly with the first embodiment and the like, in the plan view, the longitudinal direction of the switch modules 410 are arranged substantially in the X axis direction. In the switch module 410, the alternating current output terminal 4100, the negative-side terminal 410N, and the positive-side terminal 410P are arranged, in an ascending order of the distance from the smoothing circuit 20 (the smoothing capacitors 21), next to each other along the longitudinal direction of the switch module 410 (the X axis direction).

As illustrated in FIG. 12, on the upper end portion of the switch module 410, similarly with the first embodiment and the like, the U-phase laminate bus bar 41PN is arranged substantially parallel to the X axis direction and the Y axis direction.

The U-phase laminate bus bar 41PN is arranged in a range that covers the six switch modules 410 in the X axis direction and the Y axis direction.

As illustrated in FIG. 12, the U-phase alternating current bus bar 410 connects the alternating current output terminals 4100 of the switch modules 410 and the U-phase output terminal 41T. Similarly with the first embodiment and the like, the U-phase alternating current bus bar 410 includes the U-phase parallel connection bus bar 4101 and the U-phase output bus bar 4102.

The U-phase parallel connection bus bar 4101 has a flat plate-like shape substantially parallel to the X axis direction and the Y axis direction, and has a substantially rectangular shape extending in a range that covers the six switch modules 410 in the plan view. The U-phase parallel connection bus bar 4101 is further stacked on the insulating layer 41I2 of the uppermost layer (see FIG. 4) of the U-phase laminate bus bar 41PN. Accordingly, the U-phase negative-side direct current bus bar 41N, the U-phase positive-side direct current bus bar 41P, and the U-phase parallel connection bus bar 4101, which are stacked in order from the lower side with insulating layers 41I1, 41I2 interposed therebetween, constitute a U-phase laminate bus bar 41PNO of a laminate structure. Therefore, the current density of the U-phase parallel connection bus bar 4101 is substantially the same as in the U-phase positive-side direct current bus bar 41P and the U-phase negative-side direct current bus bar 41N.

As illustrated in FIG. 11 and FIG. 12, in the U-phase parallel connection bus bar 4101, substantially rectangular relatively large through holes are provided at the positions corresponding to the six switch modules 410 in the plan view. Accordingly, the positive-side terminal 410P of the switch module 410 (the fastening through hole of the U-phase positive-side direct current bus bar 41P), the negative-side terminal 410N (the fastening through hole of the U-phase negative-side direct current bus bar 41N), and the alternating current output terminal 4100 can be exposed in the plan view. Therefore, from above the U-phase parallel connection bus bar 4101, the worker can access the positive-side terminal 410P, the negative-side terminal 410N, and the alternating current output terminal 4100 of the switch module 410.

As illustrated in FIG. 11 and FIG. 12, the U-phase output bus bar 4102 connects the U-phase parallel connection bus bar 4101 and the U-phase output terminal 41T. The U-phase output bus bar 4102 is connected to a position shifted toward the positive direction of the X axis with respect to the alternating current output terminals 4100 of the switch modules 410 at the end portion in the positive direction of the X axis of the U-phase parallel connection bus bar 4101, i.e., at the end portion in the positive direction of the X axis of the three switch modules 410 arranged next to each other in the X axis direction in two rows. The U-phase output bus bar 4102 is connected to a substantially central position in the Y axis direction between the alternating current output terminals 4100, which are at the end portion in the positive direction of the X axis of the U-phase parallel connection bus bar 4101, of the group of three switch modules 410 arranged in the X axis direction in two rows. Accordingly, the lengths of all of the power paths, passing through the six switch modules 410, between the direct current input terminal of the U-phase circuit 41 and the connection portion between the U-phase parallel connection bus bar 4101 and the U-phase output bus bar 4102 are substantially the same. Therefore, the lengths and the current densities of the circuits of all of the power paths, passing through the six switch modules 410, between the smoothing circuit 20 and the U-phase output terminal 41T are substantially the same. Therefore, the inductances of the circuits of the power paths, passing through the six switch modules 410, between the smoothing circuit 20 and the U-phase output terminal 41T can be made substantially the same and uniformized.

Similarly with the U-phase circuit 41, the V-phase circuit 42 includes six switch modules 420 (corresponding to the switch modules 421 to 426 explained above).

The arrangement structure of the six switch modules 420 is similar to the case of the six switch modules 410 of the U-phase circuit 41, and therefore, the explanation thereabout is omitted.

Similarly with the switch module 410, in the plan view, the longitudinal direction of the switch module 420 is arranged substantially in the X axis direction. In the switch module 420, the alternating current output terminal 420O, the negative-side terminal 420N, and the positive-side terminal 420P are arranged, in an ascending order of the distance from the smoothing circuit 20 (the smoothing capacitors 21), next to each other along the longitudinal direction of the switch module 420 (the X axis direction).

As illustrated in FIG. 12, on the upper end portion of the switch module 420, the V-phase laminate bus bar 42PN is arranged substantially parallel to the X axis direction and the Y axis direction.

The V-phase laminate bus bar 42PN is arranged in a range that covers the six switch modules 420 in the X axis direction and the Y axis direction.

As illustrated in FIG. 12, the V-phase alternating current bus bar 42O connects the alternating current output terminals 420O of the switch modules 420 and the V-phase output terminal 42T. The V-phase alternating current bus bar 42O includes a V-phase parallel connection bus bar 4201 and a V-phase output bus bar 42O2.

The V-phase parallel connection bus bar 4201 has a flat plate-like shape substantially parallel to the X axis direction and the Y axis direction, and has a substantially rectangular shape extending in a range that covers the six switch modules 420 in the plan view. The V-phase parallel connection bus bar 4201 is further stacked on the insulating layer 42I2 of the uppermost layer (see FIG. 4) of the V-phase laminate bus bar 42PN. Accordingly, the V-phase negative-side direct current bus bar 42N, the V-phase positive-side direct current bus bar 42P, and the V-phase parallel connection bus bar 4201, which are stacked in order from the lower side with insulating layers 4211, 42I2 interposed therebetween, constitute a V-phase laminate bus bar 42PNO of a laminate structure. Therefore, the current density of the V-phase parallel connection bus bar 4201 is substantially the same as the V-phase positive-side direct current bus bar 42P and the V-phase negative-side direct current bus bar 42N.

The arrangement and the structure of the V-phase alternating current bus bar 42O (the V-phase parallel connection bus bar 4201 and the V-phase output bus bar 42O2) are similar to the case of the U-phase alternating current bus bar 410, and therefore, the explanation thereabout is omitted.

Similarly with the U-phase circuit 41, the W-phase circuit 43 includes six switch modules 430 (corresponding to the switch modules 431 to 436 explained above).

The arrangement structure of the six switch modules 430 is similar to the case of the six switch modules 410 of the U-phase circuit 41, and therefore, the explanation thereabout is omitted.

Similarly with the switch module 410, in the plan view, the longitudinal direction of the switch module 430 is arranged substantially in the X axis direction. In the switch module 430, the alternating current output terminal 430O, the negative-side terminal 430N, and the positive-side terminal 430P are arranged, in an ascending order of the distance from the smoothing circuit 20 (the smoothing capacitors 21), next to each other along the longitudinal direction of the switch module 420 (the X axis direction).

As illustrated in FIG. 12, on the upper end portion of the switch module 430, the W-phase laminate bus bar 43PN is arranged substantially parallel to the X axis direction and the Y axis direction.

The W-phase laminate bus bar 43PN is arranged in a range that covers the six switch modules 430 in the X axis direction and the Y axis direction.

As illustrated in FIG. 12, the W-phase alternating current bus bar 43O connects the alternating current output terminals 430O of the switch modules 430 and the W-phase output terminal 43T. The W-phase alternating current bus bar 43O includes a W-phase parallel connection bus bar 4301 and a W-phase output bus bar 43O2.

The W-phase parallel connection bus bar 4301 has a flat plate-like shape substantially parallel to the X axis direction and the Y axis direction, and has a substantially rectangular shape extending in a range that covers the six switch modules 430 in the plan view. The W-phase parallel connection bus bar 4301 is further stacked on the insulating layer 43I2 of the uppermost layer (see FIG. 4) of the W-phase laminate bus bar 43PN. Accordingly, the W-phase negative-side direct current bus bar 43N, the W-phase positive-side direct current bus bar 43P, and the W-phase parallel connection bus bar 4301, which are stacked in order from the lower side with insulating layers 4311, 43I2 interposed therebetween, constitute a W-phase laminate bus bar 43PNO of a laminate structure. Therefore, the current density of the W-phase parallel connection bus bar 4301 is substantially the same as the W-phase positive-side direct current bus bar 43P and the W-phase negative-side direct current bus bar 43N.

The arrangement and the structure of the W-phase alternating current bus bar 43O (the W-phase parallel connection bus bar 4301 and the W-phase output bus bar 43O2) are similar to the case of the U-phase alternating current bus bar 410, and therefore, the explanation thereabout is omitted.

In this manner, in the third embodiment, the U-phase parallel connection bus bar 4101 has a laminated structure in which the U-phase parallel connection bus bar 4101 as well as the U-phase positive-side direct current bus bar 41P and the U-phase negative-side direct current bus bar 41N are stacked one over another with the insulating layers 41I1, 41I2 interposed therebetween. The U-phase parallel connection bus bar 4101 is connected to the U-phase output bus bar 4102 at a position shifted toward the positive direction of the X axis with respect to the alternating current output terminals 4100 of the switch modules 410 at the end portion in the positive direction of the X axis from among the six switch modules 410. Accordingly, the lengths and the current densities of the circuits of all of the power paths, passing through the six switch modules 410, between the smoothing circuit 20 and the U-phase output terminal 41T are substantially the same. Therefore, the inductances of the circuits of the power paths, passing through the six switch modules 410, between the smoothing circuit 20 and the U-phase output terminal 41T can be made substantially the same and uniformized. Likewise, the V-phase parallel connection bus bar 4201 has a laminated structure in which the V-phase parallel connection bus bar 4201 as well as the V-phase positive-side direct current bus bar 42P and the V-phase negative-side direct current bus bar 42N are stacked one over another with the insulating layers 4211, 42I2 interposed therebetween. The V-phase parallel connection bus bar 4201 is connected to the V-phase output bus bar 42O2 at a position shifted toward the positive direction of the X axis with respect to the alternating current output terminals 420O of the switch modules 420 at the end portion in the positive direction of the X axis from among the six switch modules 420. Accordingly, the lengths and the current densities of the circuits of all of the power paths, passing through the six switch modules 420, between the smoothing circuit 20 and the V-phase output terminal 42T are substantially the same. Therefore, the inductances of the circuits of the power paths, passing through the six switch modules 420, between the smoothing circuit 20 and the V-phase output terminal 42T can be made substantially the same and uniformized. Likewise, the W-phase parallel connection bus bar 4301 has a laminated structure in which the W-phase parallel connection bus bar 4301 as well as the W-phase positive-side direct current bus bar 43P and the W-phase negative-side direct current bus bar 43N are stacked one over another with the insulating layers 4311, 43I2 interposed therebetween. The W-phase parallel connection bus bar 4301 is connected to the W-phase output bus bar 43O2 at a position shifted toward the positive direction of the X axis with respect to the alternating current output terminals 430O of the switch modules 430 at the end portion in the positive direction of the X axis from among the six switch modules 430. Accordingly, the lengths and the current densities of the circuits of all of the power paths, passing through the six switch modules 430, between the smoothing circuit 20 and the W-phase output terminal 43T are substantially the same. Therefore, the inductances of the circuits of the power paths, passing through the six switch modules 430, between the smoothing circuit 20 and the W-phase output terminal 43T can be made substantially the same and uniformized. Accordingly, the unbalance in the electric currents through the six switch modules 410, the six switch modules 420, and the six switch modules 430 can be alleviated, and the electric currents can be uniformized.

In the third embodiment, the number of switch modules 410 connected in parallel may be any number, and may be two or more and five or less, or seven or more. This is also applicable to the numbers of switch modules 420 and switch modules 430. In the third embodiment, the arrangement of the multiple switch modules 410 may be in any arrangement. For example, multiple switch modules 410 may be arranged in one row in the X axis direction, and groups in each of which the switch modules 410 are arranged next to each other in one row in the X axis direction may be arranged in three or more rows in the Y axis direction.

### [Fourth embodiment]

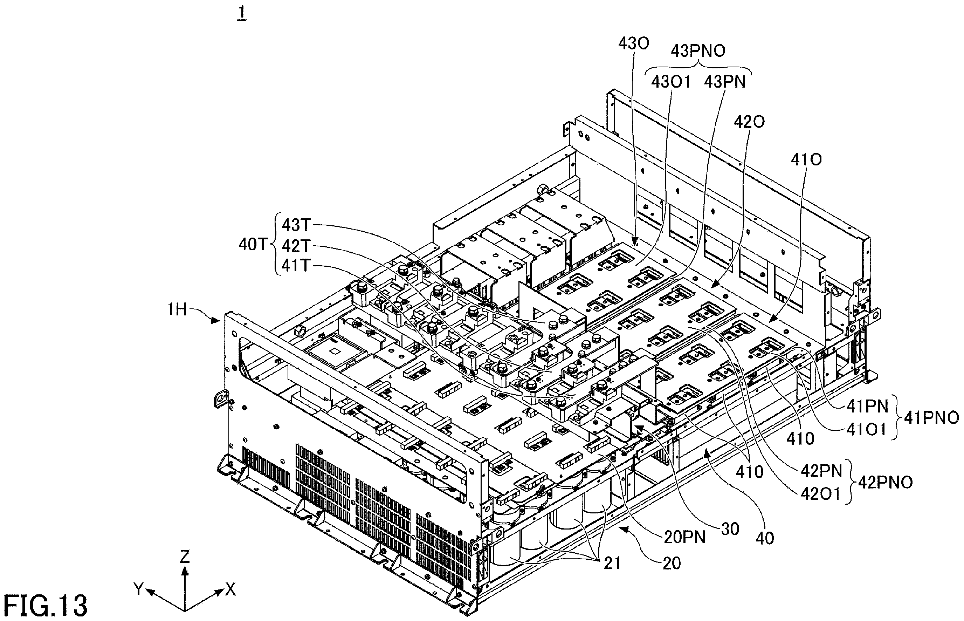

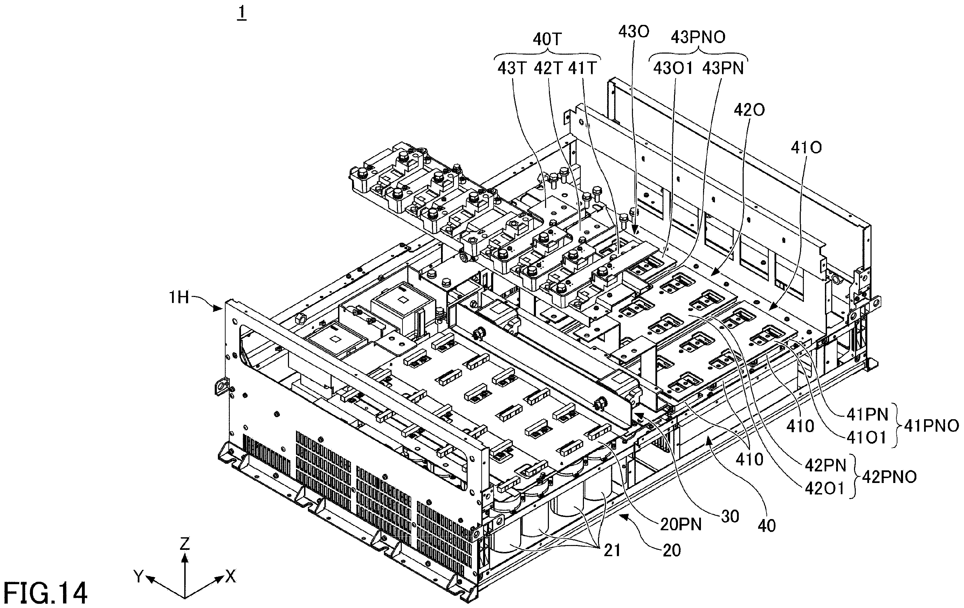

Subsequently, the fourth embodiment is explained with reference to FIG. 13 and FIG. 14. The circuit configuration of a power conversion apparatus 1 according to the fourth embodiment is similar to the second embodiment (FIG. 7) explained above, and therefore, the explanation thereabout is omitted. Hereinafter, features different from the power conversion apparatus 1 according to the first embodiment to the third embodiment are mainly explained, and explanations about the same contents as or contents corresponding to the first embodiment to the third embodiment may be simplified or omitted.

### <Structure of power conversion apparatus>

FIG. 13 and FIG. 14 are structural drawings illustrating an example of the power conversion apparatus 1 according to the fourth embodiment. Specifically, FIG. 13 is a perspective view illustrating a state in which a portion of the housing 1H of the power conversion apparatus 1 is detached. FIG. 14 is an exploded perspective view illustrating a state in which a portion of the housing 1H of the power conversion apparatus 1 is detached, and the output terminal 40T is detached and moved upward.

As illustrated in FIG. 13 and FIG. 14, similarly with the first embodiment and the like, the smoothing circuit 20, the fuse 30, and the inverter circuit 40 are arranged next to each other in order from one end portion to the other end portion in the longitudinal direction (in the positive direction of the X axis) of the inner space of the housing 1H.

Similarly with the first embodiment and the like, the output terminal 40T is arranged in a central portion in the longitudinal direction (the X axis direction) in the inner space of the housing 1H and is arranged in an upper portion in the inner space of the housing 1H. Specifically, the output terminal 40T is arranged on or above the smoothing circuit 20 and the fuse 30 in the inner space of the housing 1H.

As described above, the output terminal 40T includes a U-phase output terminal 41T, a V-phase output terminal 42T, and a W-phase output terminal 43T. Similarly with the first embodiment and the like, the U-phase output terminal 41T, the V-phase output terminal 42T, and the W-phase output terminal 43T are arranged next to each other in order from one end portion to the central portion in the
the lateral direction (in the positive direction of the Y axis) of the inner space of the housing 1H.

As described above, the inverter circuit 40 includes the bridge circuit constituted by the U-phase circuit 41, the V-phase circuit 42, and the W-phase circuit 43.

As illustrated in FIG. 13 and FIG. 14, similarly with the first embodiment and the like, the U-phase circuit 41, the V-phase circuit 42, and the W-phase circuit 43 are arranged next to each other in order in the Y axis direction from an end portion in the negative direction of the Y axis toward an end portion in the positive direction of the Y axis.

Similarly with the cases of the second embodiment and the like, the U-phase circuit 41 includes six switch modules 410 (corresponding to the switch modules 411 to 416 explained above).

Similarly with the cases of the second embodiment and the like, the six switch modules 410 are arranged such that two groups, in each of which three switch modules 410 are arranged next to each other in the X axis direction, are arranged next to each other in two rows in the Y axis direction. Similarly with the first embodiment and the like, the six switch modules 410 are arranged on other components arranged on the bottom surface of the housing 1H.

Similarly with the first embodiment and the like, in the plan view, the longitudinal direction of the switch modules 410 are arranged substantially in the X axis direction. In the switch module 410, the alternating current output terminal 4100, the negative-side terminal 410N, and the positive-side terminal 410P are arranged, in an ascending order of the distance from the smoothing circuit 20 (the smoothing capacitors 21), next to each other along the longitudinal direction of the switch module 410 (the X axis direction).

As illustrated in FIG. 13 and FIG. 14, on the upper end portion of the switch module 410, similarly with the first embodiment and the like, the U-phase laminate bus bar 41PN is arranged substantially parallel to the X axis direction and the Y axis direction.

The U-phase laminate bus bar 41PN is arranged in a range that covers the six switch modules 410 in the X axis direction and the Y axis direction.

As illustrated in FIG. 13 and FIG. 14, the U-phase alternating current bus bar 410 connects the alternating current output terminals 4100 of the switch modules 410 and the U-phase output terminal 41T. Similarly with the first embodiment and the like, the U-phase alternating current bus bar 410 includes the U-phase parallel connection bus bar 4101 and the U-phase output bus bar 4102.

Similarly with the third embodiment, the U-phase parallel connection bus bar 4101 has a flat plate-like shape substantially parallel to the X axis direction and the Y axis direction, and has a substantially rectangular shape extending in a range that covers the six switch modules 410 in the plan view. The U-phase parallel connection bus bar 4101 is further stacked on the insulating layer 41I2 of the uppermost layer (see FIG. 4) of the U-phase laminate bus bar 41PN. Accordingly, the U-phase negative-side direct current bus bar 41N, the U-phase positive-side direct current bus bar 41P, and the U-phase parallel connection bus bar 4101, which are stacked in order from the lower side with insulating layers 41I1, 41I2 interposed therebetween, constitute a U-phase laminate bus bar 41PNO of a laminate structure. Therefore, the current density of the U-phase parallel connection bus bar 4101 is substantially the same as the U-phase positive-side direct current bus bar 41P and the U-phase negative-side direct current bus bar 41N.

As illustrated in FIG. 13 and FIG. 14, the U-phase output bus bar 4102 connects the U-phase parallel connection bus bar 4101 and the U-phase output terminal 41T. The U-phase output bus bar 4102 is connected to a position shifted toward the negative direction of the X axis with respect to the alternating current output terminals 4100 of the switch modules 410 at the end portion in the negative direction of the X axis of the U-phase parallel connection bus bar 4101, i.e., at the end portion in the negative direction of the X axis of the three switch modules 410 arranged next to each other in the X axis direction in two rows. The U-phase output bus bar 4102 is connected to a substantially central position in the Y axis direction between the alternating current output terminals 4100, which are at the end portion in the negative direction of the X axis of the U-phase parallel connection bus bar 4101, of the group of three switch modules 410 arranged in the X axis direction in two rows. Accordingly, the direction of the electric current flowing through the U-phase positive-side direct current bus bar 41P toward each of the six switch modules 410 is the positive direction of the X axis. Conversely, the direction of the electric current flowing through the U-phase parallel connection bus bar 4101 from each of the six switch modules 410 to the U-phase output terminal 41T is the negative direction of the X axis that is opposite thereto. Therefore, since the electric currents of the same current density flow in the opposite directions, the magnetic field generated by the electric currents of the U-phase positive-side direct current bus bar 41P and the U-phase parallel connection bus bar 4101 is cancelled, and the inductance thereof can be greatly reduced. Likewise, the direction of the electric current flowing through the U-phase parallel connection bus bar 4101 from the U-phase output terminal 41T toward each of the six switch modules 410 is the positive direction of the X axis. Conversely, the direction of the electric current flowing through the U-phase negative-side direct current bus bar 41N from each of the six switch modules 410 toward the smoothing circuit 20 is the negative direction of the X axis. Therefore, since the electric currents of the same current density flow in the opposite directions, the magnetic field generated by the electric currents of the U-phase negative-side direct current bus bar 41N and the U-phase parallel connection bus bar 4101 is cancelled, and the inductance thereof can be greatly reduced. Accordingly, the inductances of the circuits of the power paths, passing through the six switch modules 410, between the smoothing circuit 20 and the U-phase output terminal 41T are significantly reduced, so that the difference in the inductances between the power paths can be alleviated, and the inductances can be uniformized.

Similarly with the U-phase circuit 41, the V-phase circuit 42 includes six switch modules 420 (corresponding to the switch modules 421 to 426 explained above).

The arrangement structure of the six switch modules 420 are similar to the case of the six switch modules 410 of the U-phase circuit 41, and therefore, the explanation thereabout is omitted.

Similarly with the switch module 410, in the plan view, the longitudinal direction of the switch modules 420 are arranged substantially in the X axis direction. In the switch module 420, the alternating current output terminal 420O, the negative-side terminal 420N, and the positive-side terminal 420P are arranged, in an ascending order of the distance from the smoothing circuit 20 (the smoothing capacitors 21), next to each other along the longitudinal direction of the switch module 420 (the X axis direction).

As illustrated in FIG. 13 and FIG. 14, on the upper end portion of the switch module 420, the V-phase laminate bus bar 42PN is arranged substantially parallel to the X axis direction and the Y axis direction.

The V-phase laminate bus bar 42PN is arranged in a range that covers the six switch modules 420 in the X axis direction and the Y axis direction.

As illustrated in FIG. 13 and FIG. 14, the V-phase alternating current bus bar 42O connects the alternating current output terminals 420O of the switch modules 420 and the V-phase output terminal 42T. The V-phase alternating current bus bar 42O includes a V-phase parallel connection bus bar 4201 and a V-phase output bus bar 42O2.

Similarly with the case of the third embodiment, the V-phase parallel connection bus bar 4201 has a flat plate-like shape substantially parallel to the X axis direction and the Y axis direction, and has a substantially rectangular shape extending in a range that covers the six switch modules 420 in the plan view. The V-phase parallel connection bus bar 4201 is further stacked on the insulating layer 42I2 of the uppermost layer (see FIG. 4) of the V-phase laminate bus bar 42PN. Accordingly, the V-phase negative-side direct current bus bar 42N, the V-phase positive-side direct current bus bar 42P, and the V-phase parallel connection bus bar 4201, which are stacked in order from the lower side with insulating layers 4211, 42I2 interposed therebetween, constitute a V-phase laminate bus bar 42PNO of a laminate structure. Therefore, the current density of the V-phase parallel connection bus bar 4201 is substantially the same as the V-phase positive-side direct current bus bar 42P and the V-phase negative-side direct current bus bar 42N.

The arrangement and the structure of the V-phase alternating current bus bar 42O (the V-phase parallel connection bus bar 4201 and the V-phase output bus bar 42O2) are similar to the case of the U-phase alternating current bus bar 410, and therefore, the explanation thereabout is omitted.

Similarly with the U-phase circuit 41, the W-phase circuit 43 includes six switch modules 430 (corresponding to the switch modules 431 to 436 explained above).

The arrangement structure of the six switch modules 430 is similar to the case of the six switch modules 410 of the U-phase circuit 41, and therefore, the explanation thereabout is omitted.

Similarly with the switch module 410, in the plan view, the longitudinal direction of the switch module 430 is arranged substantially in the X axis direction. In the switch module 430, the alternating current output terminal 430O, the negative-side terminal 430N, and the positive-side terminal 430P are arranged, in an ascending order of the distance from the smoothing circuit 20 (the smoothing capacitors 21), next to each other along the longitudinal direction of the switch module 420 (the X axis direction).

As illustrated in FIG. 13 and FIG. 14, on the upper end portion of the switch module 430, the W-phase laminate bus bar 43PN is arranged substantially parallel to the X axis direction and the Y axis direction.

The W-phase laminate bus bar 43PN is arranged in a range that covers the six switch modules 430 in the X axis direction and the Y axis direction.

As illustrated in FIG. 13 and FIG. 14, the W-phase alternating current bus bar 43O connects the alternating current output terminals 430O of the switch modules 430 and the W-phase output terminal 43T. The W-phase alternating current bus bar 43O includes a W-phase parallel connection bus bar 4301 and a W-phase output bus bar 43O2.

Similarly with the case of the third embodiment, the W-phase parallel connection bus bar 4301 has a flat plate-like shape substantially parallel to the X axis direction and the Y axis direction, and has a substantially rectangular shape extending in a range that covers the six switch modules 430 in the plan view. The W-phase parallel connection bus bar 4301 is further stacked on the insulating layer 43I2 of the uppermost layer (see FIG. 4) of the W-phase laminate bus bar 43PN. Accordingly, the W-phase negative-side direct current bus bar 43N, the W-phase positive-side direct current bus bar 43P, and the W-phase parallel connection bus bar 4301, which are stacked in order from the lower side with insulating layers 4311, 43I2 interposed therebetween, constitute a W-phase laminate bus bar 43PNO of a laminate structure. Therefore, the current density of the W-phase parallel connection bus bar 4301 is substantially the same as the W-phase positive-side direct current bus bar 43P and the W-phase negative-side direct current bus bar 43N.

The arrangement and the structure of the W-phase alternating current bus bar 43O (the W-phase parallel connection bus bar 4301 and the W-phase output bus bar 43O2) are similar to the case of the U-phase alternating current bus bar 410, and therefore, the explanation thereabout is omitted.

In this manner, in the fourth embodiment, the U-phase parallel connection bus bar 4101 has a laminated structure in which the U-phase parallel connection bus bar 4101 as well as the U-phase positive-side direct current bus bar 41P and the U-phase negative-side direct current bus bar 41N are stacked one over another with the insulating layers 41I1, 41I2 interposed therebetween. The U-phase parallel connection bus bar 4101 is connected to the U-phase output bus bar 4102 at a position shifted toward the negative direction of the X axis with respect to the alternating current output terminals 4100 of the switch modules 410 at the end portion in the negative direction of the X axis from among the six switch modules 410. Accordingly, before and after passing through the six switch modules 410, the electric currents flowing through the U-phase positive-side direct current bus bar 41P and the U-phase parallel connection bus bar 4101 and the electric currents flowing through the U-phase parallel connection bus bar 4101 and the U-phase negative-side direct current bus bar 41N are of the same current density but are in the opposite directions in the space. Therefore, the magnetic fields generated by the electric currents flowing through the U-phase positive-side direct current bus bar 41P and the U-phase parallel connection bus bar 4101 and the electric currents flowing through the U-phase parallel connection bus bar 4101 and the U-phase negative-side direct current bus bar 41N are cancelled, so that the inductances of these power paths can be significantly reduced. As a result, the difference in the inductances between the circuits of the power paths, passing through the six switch modules 410, between the smoothing circuit 20 and the U-phase output terminal 41T can be alleviated, and the inductances can be uniformized. Likewise, the V-phase parallel connection bus bar 4201 has a laminated structure in which the V-phase parallel connection bus bar 4201 as well as the V-phase positive-side direct current bus bar 42P and the V-phase negative-side direct current bus bar 42N are stacked on one over another with the insulating layers 4211, 42I2 interposed therebetween. The V-phase parallel connection bus bar 4201 is connected to the V-phase output bus bar 42O2 at a position shifted toward the negative direction of the X axis with respect to the alternating current output terminals 420O of the switch modules 420 at the end portion in the positive direction of the X axis from among the six switch modules 420. Accordingly, before and after passing through the six switch modules 420, the electric currents flowing through the V-phase positive-side direct current bus bar 42P and the V-phase parallel connection bus bar 4201 and the electric currents flowing through the V-phase parallel connection bus bar 4201 and the V-phase negative-side direct current bus bar 42N are of the same current density but are in the opposite directions in the space. Therefore, the magnetic fields generated by the electric currents flowing through the V-phase positive-side direct current bus bar 42P and the V-phase parallel connection bus bar 4201 and the electric currents flowing through the V-phase parallel connection bus bar 4201 and the V-phase negative-side direct current bus bar 42N are cancelled, so that the inductances of these power paths can be significantly reduced. As a result, the difference in the inductances between the circuits of the power paths, passing through the six switch modules 420, between the smoothing circuit 20 and the V-phase output terminal 42T can be alleviated, and the inductances can be uniformized. Likewise, the W-phase parallel connection bus bar 4301 has a laminated structure in which the W-phase parallel connection bus bar 4301 as well as the W-phase positive-side direct current bus bar 43P and the W-phase negative-side direct current bus bar 43N are stacked one over another with the insulating layers 4311, 43I2 interposed therebetween. The W-phase parallel connection bus bar 4301 is connected to the W-phase output bus bar 43O2 at a position shifted toward the positive direction of the X axis with respect to the alternating current output terminals 430O of the switch modules 430 at the end portion in the positive direction of the X axis from among the six switch modules 430. Accordingly, before and after passing through the six switch modules 430, the electric currents flowing through the W-phase positive-side direct current bus bar 43P and the W-phase parallel connection bus bar 4301 and the electric currents flowing through the W-phase parallel connection bus bar 4301 and the W-phase negative-side direct current bus bar 43N are of the same current density but are in the opposite directions in the space. Therefore, the magnetic fields generated by the electric currents flowing through the W-phase positive-side direct current bus bar 43P and the W-phase parallel connection bus bar 4301 and the electric currents flowing through the W-phase parallel connection bus bar 4301 and the W-phase negative-side direct current bus bar 43N are cancelled, so that the inductances of these power paths can be significantly reduced. As a result, the difference in the inductances of the circuits of the power paths, passing through the six switch modules 430, between the smoothing circuit 20 and the W-phase output terminal 43T can be alleviated, and the inductances can be uniformized. Therefore, the unbalance in the electric currents through the six switch modules 410, the six switch modules 420, and the six switch modules 430 can be alleviated, and the electric currents can be uniformized.

In the fourth embodiment, the number of switch modules 410 connected in parallel may be any number, and may be two or more and five or less, or seven or more. This is also applicable to the numbers of switch modules 420 and switch modules 430. In the fourth embodiment, the arrangement of the multiple switch modules 410 may be in any arrangement, and for example, the multiple switch modules 410 may be arranged in one row in the X axis direction, and groups in each of which the switch modules 410 are arranged next to each other in one row in the X axis direction may be arranged in three or more rows in the Y axis direction.

### [Operations]

Subsequently, the operations of the power conversion apparatus 1 according to the present embodiment are explained.

In the present embodiment (the first embodiment), the power conversion apparatus 1 includes the smoothing circuit 20, the inverter circuit 40, and the output terminal 40T. Specifically, the inverter circuit 40 includes the U-phase circuit 41 in which multiple switch modules 410, in which upper and lower arms including multiple semiconductor switches 410s are connected in series, are connected in parallel, wherein connection points (the alternating current output terminals 4100) of the upper and lower arms of the multiple switch modules 410 are connected with each other. Likewise, the inverter circuit 40 includes the V-phase circuit 42 in which multiple switch modules 420, in which upper and lower arms including multiple semiconductor switches 420s are connected in series, are connected in parallel, wherein connection points (the alternating current output terminals 420O) of the upper and lower arms of the multiple switch modules 420 are connected with each other. Likewise, the inverter circuit 40 includes the W-phase circuit 43 in which multiple switch modules 430, in which upper and lower arms including multiple semiconductor switches 430s are connected in series, are connected in parallel, wherein connection points (the alternating current output terminals 430O) of the upper and lower arms of the multiple switch modules 430 are connected with each other. Specifically, the inverter circuit 40 includes the bridge circuit constituted by connecting multiple phases of output circuits (the U-phase circuit 41, the V-phase circuit 42, and the W-phase circuit 43) in parallel. The inverter circuit 40 outputs a predetermined alternating current power on the basis of the direct current power received from the smoothing circuit 20. The output terminal 40T outputs a predetermined alternating current power from the inverter circuit 40 to the outside. Also, the inverter circuit 40 includes: the positive-side direct current bus bar 40P connecting the positive-side terminals 410P, 420P, and 430P of the multiple switch modules 410, 420, and 430 with each other; and the negative-side direct current bus bar 40N connecting the negative-side terminals 410N, 420N, and 430N of the multiple switch modules 410, 420, and 430 with each other. Also, the inverter circuit 40 includes the U-phase parallel connection bus bar 4101 connecting the alternating current output terminals 4100 of the multiple switch modules 410 with each other. Likewise, the inverter circuit 40 includes the V-phase parallel connection bus bar 4201 connecting the alternating current output terminals 420O of the multiple switch modules 420 with each other. Likewise, the inverter circuit 40 includes the W-phase parallel connection bus bar 4301 connecting the alternating current output terminals 430O of the multiple switch modules 430. Also, the positive-side direct current bus bar 40P and the negative-side direct current bus bar 40N have the laminated structure in which the positive-side direct current bus bar 40P and the negative-side direct current bus bar 40N are stacked one over another with the insulating layers 41I1, 4211, and 4311 being interposed therebetween. The U-phase parallel connection bus bar 4101 is configured so that the lengths of the paths from all of the arms (the semiconductor switches 410s) included in the multiple switch modules 410 to the merging portion where all of the paths from the multiple switch modules 410 are merged are substantially the same. Likewise, the V-phase parallel connection bus bar 4201 is configured so that the lengths of the paths from all of the arms (the semiconductor switches 420s) included in the multiple switch modules 420 to the merging portion where all of the paths from the multiple switch modules 420 are merged are substantially the same. Likewise, the W-phase parallel connection bus bar 4301 is configured so that the lengths of the paths from all of the arms (the semiconductor switches 430s) included in the multiple switch modules 430 to the merging portion where all of the paths from the multiple switch modules 430 are merged are substantially the same.

For example, in an inverter circuit, the rated electric current of the power conversion apparatus can be increased by connecting multiple switch legs in parallel.

In certain cases, when the inductances of respective paths passing through the multiple switch legs are different, the electric currents passing through the multiple switch legs become unbalanced, and the electric current may concentrate on certain semiconductor switches included in some of the switch legs. As a result, the devices of the semiconductor switches may be damaged due to the increase in the temperature caused by the loss.

It may be possible to determine the rated electric current of the power conversion apparatus in view of the unbalance of the electric currents according to the tolerable electric currents of the semiconductor switches on which the electric currents are most concentrated. In this case, however, only an electric current relatively lower than the tolerable electric current flows through the semiconductor switches other than the semiconductor switches on which the electric currents are concentrated. As a result, even if more switch legs connected in parallel are provided, the tolerable electric current achieved by the entirety of the multiple switch legs cannot be efficiently utilized, and it may be impossible to appreciably increase the rated electric current of the power conversion apparatus.

For this problem, in the present embodiment (the first embodiment), the inductances of the positive-side and negative-side direct current wiring portions of the inverter circuit 40 can be significantly reduced by making the positive-side direct current bus bar 40P and the negative-side direct current bus bar 40N into the laminate structure. Therefore, in the inductances of the circuits of the power paths between the smoothing circuit 20 and the output terminal 40T, the inductance of the alternating current wiring portion is dominant. On top of that, the lengths of the paths from all of the arms (the semiconductor switches 410s) included in the multiple switch modules 410 to the merging portion are configured to be substantially the same, so that the difference in the inductances of the power paths passing through the semiconductor switches 410s in the U-phase parallel connection bus bar 4101 can be relatively reduced. Therefore, in the power paths passing through the multiple switch modules 410, the power conversion apparatus 1 can relatively reduce the difference in the inductances of the circuits of power paths between the smoothing circuit 20 and the output terminal 40T (the U-phase output terminal 41T). Accordingly, the power conversion apparatus 1 can alleviate the unbalance in the electric currents flowing through the multiple semiconductor switches 410s (the switch modules 410) and can uniformize the electric currents. This is also applicable to the multiple switch modules 420. Therefore, in the power paths passing through the multiple switch modules 420, the power conversion apparatus 1 can relatively reduce the difference in the inductances of the circuits of power paths between the smoothing circuit 20 and the output terminal 40T (the V-phase output terminal 42T). Accordingly, the power conversion apparatus 1 can alleviate the unbalance in the electric currents through multiple semiconductor switches 420s (the switch modules 420), and can uniformize the electric currents. This is also applicable to the multiple switch modules 430. Therefore, in the power paths passing through the multiple switch modules 430, the power conversion apparatus 1 can relatively reduce the difference in the inductances of the circuits of power paths between the smoothing circuit 20 and the output terminal 40T (the W-phase output terminal 43T). Accordingly, the power conversion apparatus 1 can alleviate the unbalance in the electric currents through multiple semiconductor switches 430s (the switch modules 430), and can uniformize the electric currents.

Also, in the present embodiment (the first embodiment), the U-phase parallel connection bus bar 4101 is configured so that the current densities of the paths from all the semiconductor switches 410s included in the multiple switch modules 410 to the merging portion where all of the paths from the multiple switch modules 410 are merged are substantially the same. This is also applicable to the V-phase parallel connection bus bar 4201 and the W-phase parallel connection bus bar 4301.

Accordingly, the inductances of the power paths passing through the semiconductor switches 410s in the U-phase parallel connection bus bar 4101 can be made substantially the same. Therefore, in the power paths passing through the multiple switch modules 410, the power conversion apparatus 1 can make the inductances of the circuits of the power paths between the smoothing circuit 20 and the output terminal 40T (the U-phase output terminal 41T) be substantially the same. Therefore, the power conversion apparatus 1 can further alleviate the unbalance in the electric currents flowing through the multiple semiconductor switches 410s (the switch modules 410), and can further uniformize the electric currents. With regard to the V-phase parallel connection bus bar 4201 and the W-phase parallel connection bus bar 4301, operations and effects similar to the above can be achieved.

In the present embodiment (the first embodiment), two switch modules 410 included in the multiple switch modules 410 are arranged next to each other in one axial direction (the X axis direction). This is also applicable to the multiple switch modules 420 and the multiple switch modules 430. Also, the U-phase parallel connection bus bar 4101 may merge, at a substantially central position (a middle point) between the alternating current output terminals 4100 of the two switch modules 410 in the X axis direction, the paths extending from the two switch modules 410 to the U-phase output terminal 41T. This is also applicable to the V-phase parallel connection bus bar 4201 and the W-phase parallel connection bus bar 4301.

Accordingly, for each combination of two switch modules 410, the U-phase parallel connection bus bar 4101 can merge the paths from the alternating current output terminals 4100 of the two switch modules 410 in such a manner that the lengths thereof are substantially the same. With regard to the V-phase parallel connection bus bar 4201 and the W-phase parallel connection bus bar 4301, operations and effects similar to the above can be achieved.

In the present embodiment (the first embodiment), the multiple switch modules 410 connected in parallel may include multiple combinations of two switch modules 410. This is also applicable to multiple switch modules 420 connected in parallel and multiple switch modules 430 connected in parallel. The U-phase parallel connection bus bar 4101 may be configured so that the lengths of the power paths between an intermediate merging portion where paths from multiple combinations of two switch modules 410 are merged and merging portions where the paths from the respective switch modules 410 are merged are substantially the same. This is also applicable to the V-phase parallel connection bus bar 4201 and the W-phase parallel connection bus bar 4301.

Accordingly, in the U-phase parallel connection bus bar 4101, the lengths of paths from multiple switch modules 410 connected in parallel to a merging point where all of the paths are merged may be substantially the same. With regard to the V-phase parallel connection bus bar 4201 and the W-phase parallel connection bus bar 4301, operations and effects similar to the above can be achieved.

In the present embodiment (the first embodiment), multiple (four) switch modules 410 connected in parallel may be arranged so that two sets each including two switch modules 410 aligned in the X axis direction are arranged next to each other in two rows in another axial direction (the Y axis direction) perpendicular to the X axis direction. This is also applicable to multiple (four) switch modules 420 and multiple (four) switch modules 430. The U-phase parallel connection bus bar 4101 is configured to be in a plane-symmetrical arrangement about a vertical plane at a central position of the two switch modules 410 in the X axis direction. Also, the U-phase parallel connection bus bar 4101 may be configured to be in a plane-symmetrical arrangement about a vertical plane at a central position of the two sets in the Y axis direction. The U-phase parallel connection bus bar 4101 may be configured so that a connection portion with an interconnection extending to the U-phase output terminal 41T (the U-phase output bus bar 4102) is at a central position, in the X axis direction and the Y axis direction, of the four switch modules 410 included in the two sets. This is also applicable to the V-phase parallel connection bus bar 4201 and the W-phase parallel connection bus bar 4301.

Accordingly, in the U-phase parallel connection bus bar 4101, specifically, the lengths of the paths from multiple (four) switch modules 410 connected in parallel to the merging point where the paths are merged may be substantially the same. In this case, the power conversion apparatus 1 can specifically make the inductances of the paths passing through the respective semiconductor switches 410s be substantially the same. With respect to the V-phase parallel connection bus bar 4201 and the W-phase parallel connection bus bar 4301, operations and effects similar to the above can be achieved.

In the present embodiment (the second embodiment), the power conversion apparatus 1 includes the smoothing circuit 20, the inverter circuit 40, and the output terminal 40T. Specifically, the inverter circuit 40 includes the U-phase circuit 41 in which multiple switch modules 410, in which upper and lower arms including multiple semiconductor switches 410s are connected in series, are connected in parallel, wherein connection points (the alternating current output terminals 4100) of the upper and lower arms of the multiple switch modules 410 are connected with each other. Likewise, the inverter circuit 40 includes the V-phase circuit 42 in which multiple switch modules 420, in which upper and lower arms including multiple semiconductor switches 420s are connected in series, are connected in parallel, wherein connection points (the alternating current output terminals 420O) of the upper and lower arms of the multiple switch modules 420 are connected with each other. Likewise, the inverter circuit 40 includes the W-phase circuit 43 in which multiple switch modules 430, in which upper and lower arms including multiple semiconductor switches 430s are connected in series, are connected in parallel, wherein connection points (the alternating current output terminals 430O) of the upper and lower arms of the multiple switch modules 430 are connected with each other. Specifically, the inverter circuit 40 includes the bridge circuit constituted by connecting multiple phases of output circuits (the U-phase circuit 41, the V-phase circuit 42, and the W-phase circuit 43) in parallel. The inverter circuit 40 outputs a predetermined alternating current power on the basis of the direct current power received from the smoothing circuit 20. The output terminal 40T outputs a predetermined alternating current power from the inverter circuit 40 to the outside. Also, the inverter circuit 40 includes: the positive-side direct current bus bar 40P connecting the positive-side terminals 410P, 420P, and 430P of the multiple switch modules 410, 420, and 430 with each other; and the negative-side direct current bus bar 40N connecting the negative-side terminals 410N, 420N, and 430N of the multiple switch modules 410, 420, and 430 with each other. Also, the inverter circuit 40 includes the U-phase parallel connection bus bar 4101 connecting the alternating current output terminals 4100 of the multiple switch modules 410 with each other. Likewise, the inverter circuit 40 includes the V-phase parallel connection bus bar 4201 connecting the alternating current output terminals 420O of the multiple switch modules 420 with each other. Likewise, the inverter circuit 40 includes the W-phase parallel connection bus bar 4301 connecting the alternating current output terminals 430O of the multiple switch modules 430. Also, the positive-side direct current bus bar 40P and the negative-side direct current bus bar 40N have the laminated structure in which the positive-side direct current bus bar 40P and the negative-side direct current bus bar 40N are stacked one over another with the insulating layers 41I1, 42I1, and 43I1 being interposed therebetween. The U-phase parallel connection bus bar 41O1 is configured so that the lengths of the power paths, passing through all of the arms (the semiconductor switches 410s) included in the multiple switch modules 410, between the smoothing circuit 20 and the merging portion where all of the paths from the multiple switch modules 410 are merged are substantially the same. Also, the U-phase parallel connection bus bar 4101 is configured so that the current densities of the entire paths of the respective power paths, passing through all of the arms included in the multiple switch modules 410, between the smoothing circuit 20 and the merging portion are substantially the same. Likewise, the V-phase parallel connection bus bar 4201 is configured so that the lengths of the power paths, passing through all of the arms (the semiconductor switches 420s) included in the multiple switch modules 420, between the smoothing circuit 20 and the merging portion where all of the paths from the multiple switch modules 420 are merged are substantially the same. Also, the V-phase parallel connection bus bar 4201 is configured so that the current densities of the entire paths of the respective power paths, passing through all of the arms included in the multiple switch modules 420, between the smoothing circuit 20 and the merging portion are substantially the same. Likewise, the W-phase parallel connection bus bar 4301 is configured so that the lengths of the power paths, passing through all of the arms (the semiconductor switches 430s) included in the multiple switch modules 430, between the smoothing circuit 20 and the merging portion where all of the paths from the multiple switch modules 430 are merged are substantially the same. Also, the W-phase parallel connection bus bar 4301 is configured so that the current densities of the entire paths of the respective power paths, passing through all of the arms included in the multiple switch modules 430, between the smoothing circuit 20 and the merging portion are substantially the same.

Accordingly, in the inverter circuit 40, the lengths of all of the paths between the direct current input and the merging portion of the alternating current outputs and the current density of each of the entire paths can be uniformized. Therefore, in the power paths passing through the multiple switch modules 410, the power conversion apparatus 1 can make the inductances of the circuits of the power paths between the smoothing circuit 20 and the output terminal 40T (the U-phase output terminal 41T) be substantially the same. Accordingly, the power conversion apparatus 1 can alleviate the unbalance in the electric currents through multiple semiconductor switches 410s (the switch modules 410), and can uniformize the electric currents. This is also applicable to the multiple switch modules 420. Therefore, in the power paths passing through the multiple switch modules 420, the power conversion apparatus 1 can make the inductances of the circuits of the power paths between the smoothing circuit 20 and the output terminal 40T (the V-phase output terminal 42T) be substantially the same. Accordingly, the power conversion apparatus 1 can alleviate the unbalance in the electric currents through multiple semiconductor switches 420s (the switch modules 420), and can uniformize the electric currents. This is also applicable to the multiple switch modules 430. Therefore, in the power paths passing through the multiple switch modules 430, the power conversion apparatus 1 can make the inductances of the circuits of the power paths between the smoothing circuit 20 and the output terminal 40T (the W-phase output terminal 43T) be substantially the same. Accordingly, the power conversion apparatus 1 can alleviate the unbalance in the electric currents through multiple semiconductor switches 430s (the switch modules 430), and can uniformize the electric currents.

Also, in the present embodiment (the second embodiment), the U-phase parallel connection bus bar 4101 may be configured so that the current densities of the portions of the power paths, passing through the multiple switch modules 410, of which the lengths are the same are substantially the same. The U-phase parallel connection bus bar 4101 may be configured so that the current densities of portions of the respective power paths other than the above-mentioned portions, i.e., portions of the respective power paths of which the lengths are different, are, for each of the power paths, substantially the same as the current densities of the positive-side direct current bus bar 40P and the negative-side direct current bus bar 40N. This is also applicable to the V-phase parallel connection bus bar 42O1 and the W-phase parallel connection bus bar 43O1.

Accordingly, in the inverter circuit 40, the current densities of the entire paths of all of the paths between the direct current input and the merging portion of the alternating current inputs can be made substantially the same.

Also, in the present embodiment (the second embodiment), the smoothing circuit 20 and the inverter circuit 40 may be arranged in one axial direction (the X axis direction). The multiple switch modules 410 may be arranged in the X axis direction. This is also applicable to the multiple switch modules 420 and the multiple switch modules 430. The U-phase parallel connection bus bar 4101 may include multiple leg portions 41O1a that are provided to extend in the vertical direction (the Z axis direction) from the connection points (the alternating current output terminals 410O) of the upper and lower arms of the multiple switch modules 410 and that have substantially the same length and substantially the same size of the cross-sectional area as each other. Also, the U-phase parallel connection bus bar 41O1 may include the interconnection portion 41O1b connecting the multiple leg portions 41O1a with each other so as to extend in the X axis direction. The interconnection portion 41O1b may be connected to, at the end portion thereof away from the smoothing circuit 20 in the X axis direction, the interconnection (the U-phase output bus bar 41O2) extending to the output terminal 40T (the U-phase output terminal 41T). Then, the interconnection portion 41O1b may be configured so that the current density of each of the power paths passing through the multiple switch modules 410 is substantially the same as the current densities of the positive-side direct current bus bar 40P and the negative-side direct current bus bar 40N. This is also applicable to the V-phase parallel connection bus bar 4201 and the W-phase parallel connection bus bar 4301.

Accordingly, in the inverter circuit 40, specifically, the lengths of the power paths and the current densities of the entire paths of all of the respective power paths between the direct current input and the merging portion of the alternating current outputs can be made substantially the same.

In the present embodiment (the second embodiment), the multiple switch modules 410 may be arranged such that two groups, in each of which two switch modules 410 are arranged next to each other in one axial direction (the X axis direction), are arranged next to each other in two rows in another axial direction (the Y axis direction) perpendicular to the X axis direction. The interconnection portion 41O1b of the U-phase parallel connection bus bar 41O1 may connect multiple leg portions 41O1a with each other so as to extend in the X axis direction and the Y axis direction.

Accordingly, in the inverter circuit 40, specifically, the lengths of the power paths and the current densities of the entire paths of all of the respective power paths between the direct current input and the merging portion of the alternating current outputs can be made substantially the same.

In the present embodiment (the third embodiment), the power conversion apparatus 1 includes the smoothing circuit 20, the inverter circuit 40, and the output terminal 40T. Specifically, the inverter circuit 40 includes the U-phase circuit 41 in which multiple switch modules 410, in which upper and lower arms including multiple semiconductor switches 410s are connected in series, are connected in parallel, wherein the connection points (the alternating current output terminals 4100) of the upper and lower arms of the multiple switch modules 410 are connected with each other. Likewise, the inverter circuit 40 includes the V-phase circuit 42 in which multiple switch modules 420, in which upper and lower arms including multiple semiconductor switches 420s are connected in series, are connected in parallel, wherein the connection points (the alternating current output terminals 420O) of the upper and lower arms of the multiple switch modules 420 are connected with each other. Likewise, the inverter circuit 40 includes the W-phase circuit 43 in which multiple switch modules 430, in which upper and lower arms including multiple semiconductor switches 430s are connected in series, are connected in parallel, wherein the connection points (the alternating current output terminals 430O) of the upper and lower arms of the multiple switch modules 430 are connected with each other. Specifically, the inverter circuit 40 includes the bridge circuit constituted by connecting multiple phases of output circuits (the U-phase circuit 41, the V-phase circuit 42, and the W-phase circuit 43) in parallel. The inverter circuit 40 outputs a predetermined alternating current power on the basis of the direct current power received from the smoothing circuit 20. The output terminal 40T outputs a predetermined alternating current power from the inverter circuit 40 to the outside. Also, the inverter circuit 40 includes: the positive-side direct current bus bar 40P connecting the positive-side terminals 410P, 420P, and 430P of the multiple switch modules 410, 420, and 430 with each other; and the negative-side direct current bus bar 40N connecting the negative-side terminals 410N, 420N, and 430N of the multiple switch modules 410, 420, and 430 with each other. Also, the inverter circuit 40 includes the U-phase parallel connection bus bar 4101 connecting the alternating current output terminals 4100 of the multiple switch modules 410 with each other. The positive-side direct current bus bar 40P, the negative-side direct current bus bar 40N, and the U-phase parallel connection bus bar 4101 have a laminated structure in which the positive-side direct current bus bar 40P, the negative-side direct current bus bar 40N, and the U-phase parallel connection bus bar 41O1 are stacked one over another with the insulating layers 41I1, 41I2 interposed therebetween. Likewise, the inverter circuit 40 includes the V-phase parallel connection bus bar 4201 connecting the alternating current output terminals 420O of the multiple switch modules 420 with each other. The positive-side direct current bus bar 40P, the negative-side direct current bus bar 40N, and the V-phase parallel connection bus bar 4201 have a laminated structure in which the positive-side direct current bus bar 40P, the negative-side direct current bus bar 40N, and the V-phase parallel connection bus bar 4201 are stacked one over another with the insulating layers 42I1, 42I2 interposed therebetween. Likewise, the inverter circuit 40 includes the W-phase parallel connection bus bar 43O1 connecting the alternating current output terminals 430O of the multiple switch modules 430. The positive-side direct current bus bar 40P, the negative-side direct current bus bar 40N, and the W-phase parallel connection bus bar 4301 have a laminated structure in which the positive-side direct current bus bar 40P, the negative-side direct current bus bar 40N, and the W-phase parallel connection bus bar 4301 are stacked one over another with the insulating layers 43I1, 43I2 interposed therebetween. The connection portion between the U-phase parallel connection bus bar 4101 and the interconnection (the U-phase output bus bar 4102) with the output terminal 40T (the U-phase output terminal 41T) is provided at the position farther away from the smoothing circuit 20 than are the semiconductor switches 410s farthest from the smoothing circuit 20 from among all of the arms (the semiconductor switches 410s) included in the multiple switch modules 410. Likewise, the connection portion between the V-phase parallel connection bus bar 42O1 and the interconnection (the V-phase output bus bar 42O2) with the output terminal 40T (the V-phase output terminal 42T) is provided at the position farther away from the smoothing circuit 20 than are the semiconductor switches 420s farthest from the smoothing circuit 20 from among all of the arms (the semiconductor switches 420s) included in the multiple switch modules 420. Likewise, the connection portion between the W-phase parallel connection bus bar 4301 and the interconnection (the W-phase output bus bar 43O2) with the output terminal 40T (the V-phase output terminal 43T) is provided at the position farther away from the smoothing circuit 20 than are the semiconductor switches 430s farthest from the smoothing circuit 20 from among all of the arms (the semiconductor switches 430s) included in the multiple switch modules 430.

Accordingly, by making the bus bar of the inverter circuit 40 into the laminate structure, the current densities of all the power paths between the direct current input of the inverter circuit 40 and the merging portion of the alternating current inputs can be substantially uniformized. In addition, with the arrangement of the connection portion between the U-phase parallel connection bus bar 4101 and the U-phase output bus bar 4102, the merging portion where the respective paths from the multiple switch modules 410 are merged is set in proximity to the semiconductor switches 410s farthest from the smoothing circuit 20. Specifically, the lengths of all the power paths, passing through the multiple switch modules 410, between the direct current input and the merging portion of the alternating current outputs of the inverter circuit 40 can be substantially the same. Therefore, the power conversion apparatus 1 can make the inductances of the circuits of all of the power paths, passing through the multiple switch modules 410, between the smoothing circuit 20 and the output terminal 40T (the U-phase output terminal 41T) be substantially the same. Accordingly, the power conversion apparatus 1 can alleviate the unbalance in the electric currents through multiple semiconductor switches 410s (the switch modules 410), and can uniformize the electric currents. This is also applicable to the multiple switch modules 420. Therefore, the power conversion apparatus 1 can make the inductances of the circuits of all of the power paths, passing through the multiple switch modules 420, between the smoothing circuit 20 and the output terminal 40T (the V-phase output terminal 42T) be substantially the same. Therefore, the power conversion apparatus 1 can alleviate the unbalance in the electric currents through multiple semiconductor switches 420s (the switch modules 420), and can uniformize the electric currents. This is also applicable to the multiple switch modules 430. Therefore, the power conversion apparatus 1 can make the inductances of the circuits of all of the power paths, passing through the multiple switch modules 430, between the smoothing circuit 20 and the output terminal 40T (the W-phase output terminal 43T) be substantially the same. Therefore, the power conversion apparatus 1 can alleviate the unbalance in the electric currents through multiple semiconductor switches 430s (the switch modules 430), and can uniformize the electric currents.

Also, in the present embodiment (the third embodiment), the smoothing circuit 20 and the inverter circuit 40 may be arranged next to each other in one axial direction (the X axis direction). The connection portion between the U-phase parallel connection bus bar 4101 and the U-phase output bus bar 4102 may be arranged at the position, in the X axis direction, farther away from the smoothing circuit 20 than are the switch modules 410 farthest from the smoothing circuit 20 from among the multiple switch modules 410. This is also applicable to the connection portion between the V-phase parallel connection bus bar 42O1 and the V-phase output bus bar 42O2 and the connection portion between the W-phase parallel connection bus bar 43O1 and the W-phase output bus bar 43O2.

For example, the multiple switch modules 410 may be arranged such that two groups, in each of which the switch modules 410 are arranged next to each other in the X axis direction, may be arranged next to each other in two rows in another axial direction (the Y axis direction) perpendicular to the X axis direction. This is also applicable to the multiple switch modules 420 and the multiple switch modules 430. The connection portion between the U-phase parallel connection bus bar 4101 and the U-phase output bus bar 4102 may be arranged, at a position away from the end portion of the two groups that is away from the smoothing circuit 20 in the X axis direction, at a substantially central position of the two groups in the Y axis direction. This is also applicable to the connection portion between the V-phase parallel connection bus bar 4201 and the V-phase output bus bar 42O2 and the connection portion between the W-phase parallel connection bus bar 4301 and the W-phase output bus bar 43O2.

Accordingly, in the inverter circuit 40, specifically, the lengths of the power paths between the direct current input and the merging portion of the alternating current outputs can be made substantially the same.

In the present embodiment (the fourth embodiment), the power conversion apparatus 1 includes the smoothing circuit 20, the inverter circuit 40, and the output terminal 40T. Specifically, the inverter circuit 40 includes the U-phase circuit 41 in which multiple switch modules 410, in which upper and lower arms including multiple semiconductor switches 410s are connected in series, are connected in parallel, wherein connection points (the alternating current output terminals 4100) of the upper and lower arms of the multiple switch modules 410 are connected with each other. Likewise, the inverter circuit 40 includes the V-phase circuit 42 in which multiple switch modules 420, in which upper and lower arms including multiple semiconductor switches 420s are connected in series, are connected in parallel, wherein connection points (the alternating current output terminals 420O) of the upper and lower arms of the multiple switch modules 420 are connected with each other. Likewise, the inverter circuit 40 includes the W-phase circuit 43 in which multiple switch modules 430, in which upper and lower arms including multiple semiconductor switches 430s are connected in series, are connected in parallel, wherein connection points (the alternating current output terminals 430O) of the upper and lower arms of the multiple switch modules 430 are connected with each other. Specifically, the inverter circuit 40 includes the bridge circuit constituted by connecting multiple phases of output circuits (the U-phase circuit 41, the V-phase circuit 42, and the W-phase circuit 43) in parallel. The inverter circuit 40 outputs a predetermined alternating current power on the basis of the direct current power received from the smoothing circuit 20. The output terminal 40T outputs a predetermined alternating current power from the inverter circuit 40 to the outside. Also, the inverter circuit 40 includes: the positive-side direct current bus bar 40P connecting the positive-side terminals 410P, 420P, and 430P of the multiple switch modules 410, 420, and 430 with each other; and the negative-side direct current bus bar 40N connecting the negative-side terminals 410N, 420N, and 430N of the multiple switch modules 410, 420, and 430 with each other. Also, the inverter circuit 40 includes the U-phase parallel connection bus bar 4101 connecting the alternating current output terminals 4100 of the multiple switch modules 410 with each other. The positive-side direct current bus bar 40P, the negative-side direct current bus bar 40N, and the U-phase parallel connection bus bar 4101 have a laminated structure in which the positive-side direct current bus bar 40P, the negative-side direct current bus bar 40N, and the U-phase parallel connection bus bar 41O1 are stacked one over another with the insulating layers 41I1, 41I2 interposed therebetween. Likewise, the inverter circuit 40 includes the V-phase parallel connection bus bar 42O1 connecting the alternating current output terminals 420O of the multiple switch modules 420 with each other. The positive-side direct current bus bar 40P, the negative-side direct current bus bar 40N, and the V-phase parallel connection bus bar 4201 have a laminated structure in which the positive-side direct current bus bar 40P, the negative-side direct current bus bar 40N, and the V-phase parallel connection bus bar 4201 are stacked one over another with the insulating layers 4211, 42I2 interposed therebetween. Likewise, the inverter circuit 40 includes the W-phase parallel connection bus bar 43O1 connecting the alternating current output terminals 430O of the multiple switch modules 430. The positive-side direct current bus bar 40P, the negative-side direct current bus bar 40N, and the W-phase parallel connection bus bar 4301 have a laminated structure in which the positive-side direct current bus bar 40P, the negative-side direct current bus bar 40N, and the W-phase parallel connection bus bar 4301 are stacked one over another with the insulating layers 4311, 43I2 interposed therebetween. The connection portion between the U-phase parallel connection bus bar 4101 and the interconnection (the U-phase output bus bar 4102) with the output terminal 40T (the U-phase output terminal 41T) is provided at the position farther away from the smoothing circuit 20 than are the semiconductor switches 410s farthest from the smoothing circuit 20 from among all of the arms (the semiconductor switches 410s) included in the multiple switch modules 410. Likewise, the connection portion between the V-phase parallel connection bus bar 42O1 and the interconnection (the V-phase output bus bar 42O2) with the output terminal 40T (the V-phase output terminal 42T) is provided at the position farther away from the smoothing circuit 20 than are the semiconductor switches 420s farthest from the smoothing circuit 20 from among all of the arms (the semiconductor switches 420s) included in the multiple switch modules 420. Likewise, the connection portion between the W-phase parallel connection bus bar 4301 and the interconnection (the W-phase output bus bar 43O2) with the output terminal 40T (the V-phase output terminal 43T) is provided at the position farther away from the smoothing circuit 20 than are the semiconductor switches 430s farthest from the smoothing circuit 20 from among all of the arms (the semiconductor switches 430s) included in the multiple switch modules 430.

Accordingly, by making the bus bar of the inverter circuit 40 into the laminate structure, the current densities of all the power paths between the direct current input of the inverter circuit 40 and the merging portion of the alternating current inputs can be substantially uniformized. In addition, with the arrangement of the connection portion between the U-phase parallel connection bus bar 4101 and the U-phase output bus bar 4102, the merging portion where the respective paths from the multiple switch modules 410 are merged is set in proximity to the semiconductor switches 410s farthest from the smoothing circuit 20. In addition, with the arrangement of the connection portion between the U-phase parallel connection bus bar 4101 and the U-phase output bus bar 4102, the directions of the electric currents through the U-phase positive-side direct current bus bar 41P and the directions of the electric currents through the U-phase parallel connection bus bar 4101 can be made opposite to each other in the actual space. Likewise, the directions of the electric currents through the U-phase parallel connection bus bar 4101 and the directions of the electric currents through U-phase negative-side direct current bus bar 41N can be made opposite to each other. Accordingly, the electric currents of substantially the same current density flow in the opposite directions, so that the generated magnetic field is cancelled, and the inductances of the U-phase positive-side direct current bus bar 41P, the U-phase negative-side direct current bus bar 41N, and the U-phase parallel connection bus bar 4101 can be reduced to a significantly small level. As result, the difference in the inductance of all of the power paths, passing through the multiple switch modules 410, between the direct current input and the merging portion of the alternating current inputs is reduced, and the inductances between the power paths can be uniformized. Therefore, the power conversion apparatus 1 can alleviate and can significantly reduce the difference in the inductances of the circuits of power paths, passing through the multiple switch modules 410, between the smoothing circuit 20 and the output terminal 40T (the U-phase output terminal 41T). Therefore, the power conversion apparatus 1 can alleviate the unbalance in the electric currents through multiple semiconductor switches 410s (the switch modules 410), and can uniformize the electric currents. This is also applicable to the multiple switch modules 420. Therefore, the power conversion apparatus 1 can alleviate and can significantly reduce the difference in the inductances of the circuits of power paths, passing through the multiple switch modules 420, between the smoothing circuit 20 and the output terminal 40T (the V-phase output terminal 42T) . Therefore, the power conversion apparatus 1 can alleviate the difference multiple semiconductor switches 420s (the switch modules 420), and can significantly reduce the unbalance in the electric currents. This is also applicable to the multiple switch modules 430. Therefore, the power conversion apparatus 1 can alleviate and can significantly reduce the difference in the inductances of the circuits of power paths, passing through the multiple switch modules 430, between the smoothing circuit 20 and the output terminal 40T (the W-phase output terminal 43T). Therefore, the power conversion apparatus 1 can alleviate the unbalance in the electric currents through multiple semiconductor switches 430s (the switch modules 430), and can uniformize the electric currents.

In the present embodiment (the fourth embodiment), the smoothing circuit 20 and the inverter circuit 40 may be arranged next to each other in one axial direction (the X axis direction). The connection portion between the U-phase parallel connection bus bar 4101 and the U-phase output bus bar 4102 may be arranged at a position closer to the smoothing circuit 20 than are the switch modules 410 closest to the smoothing circuit 20 from among the multiple switch modules 410 in the X axis direction. This is also applicable to the connection portion between the V-phase parallel connection bus bar 4201 and the V-phase output bus bar 42O2 and the connection portion between the W-phase parallel connection bus bar 43O1 and the W-phase output bus bar 43O2.

For example, in the plan view, the multiple switch modules 410 are arranged such that two groups, in each of which the switch modules 410 are arranged next to each other in the X axis direction, may be arranged next to each other in two rows in another axial direction (the Y axis direction) perpendicular to the X axis direction. This is also applicable to the multiple switch modules 420 and the multiple switch modules 430. The connection portion between the U-phase parallel connection bus bar 4101 and the interconnection (the U-phase output bus bar 4102) with the output terminal 40T (the U-phase output terminal 41T) may be provided at the position closer to the smoothing circuit 20 than is the end portion of the two groups that is closer to the smoothing circuit 20 in the X axis direction. This is also applicable to the connection portion between the V-phase parallel connection bus bar 42O1 and the interconnection (the V-phase output bus bar 42O2) with the V-phase output terminal 42T and the connection portion between the W-phase parallel connection bus bar 43O1 and the interconnection (the W-phase output bus bar 43O2) with the W-phase output terminal 43T.

Accordingly, specifically, the directions of the electric currents through the U-phase positive-side direct current bus bar 41P and the U-phase parallel connection bus bar 4101 and the directions of the electric currents through the U-phase parallel connection bus bar 4101 and the U-phase negative-side direct current bus bar 41N can be made opposite to each other in the actual space. Likewise, the directions of the electric currents through the V-phase positive-side direct current bus bar 42P and the V-phase parallel connection bus bar 4201 and the directions of the electric currents through the V-phase parallel connection bus bar 4201 and the V-phase negative-side direct current bus bar 42N can be made opposite to each other in the actual space. Likewise, the directions of the electric currents through the W-phase positive-side direct current bus bar 43P and the W-phase parallel connection bus bar 4301 and the directions of the electric currents through the W-phase parallel connection bus bar 4301 and the W-phase negative-side direct current bus bar 43N can be made opposite to each other in the actual space.

Although the embodiments have been hereinabove described in detail, the present disclosure is not limited to the particular embodiments described above, and various modifications and changes can be made within the scope of the gist set forth in the claims. The scope of protection is only limited by the appended claims.

## Claims

1. A power conversion apparatus (1) comprising:
a smoothing circuit (20);
an inverter circuit (40) including a bridge circuit that includes a plurality of output circuits (41, 42, 43), corresponding to respective phases, connected in parallel, each of the output circuits (41, 42, 43) including a plurality of switch legs (410, 420, 430) connected in parallel, each of the plurality of switch legs (410, 420, 430) including upper and lower arms being connected in series and including a plurality of semiconductor switches, connection points between the upper and lower arms of the plurality of switch legs (410, 420, 430) being connected with each other, and the inverter circuit being configured to output a predetermined alternating current power, based on a direct current power received from the smoothing circuit; and
output terminals (41T, 42T, 43T) configured to output the predetermined alternating current power to an outside,
wherein the inverter circuit includes:
a positive-side direct current bus bar (41P, 42P, 43P) connecting positive-side terminals (410P, 420P, 430P) of the plurality of switch legs (410, 420, 430) with each other;
a negative-side direct current bus bar (41N, 42N, 43N) connecting negative-side terminals (410N, 420N, 430N) of the plurality of switch legs (410, 420, 430) with each other; and
a parallel connection bus bar (4101, 4201, 4301) connecting the connection points of the upper and lower arms of the plurality of switch legs (410, 420, 430),
wherein the power conversion apparatus is configured in any one of the following (i) to (iii) :
(i) the positive-side direct current bus bar (41P, 42P, 43P), the negative-side direct current bus bar (41N, 42N, 43N), and the parallel connection bus bar (4101, 4201, 4301) have a laminated structure in which the positive-side direct current bus bar (41P, 42P, 43P), the negative-side direct current bus bar (41N, 42N, 43N), and the parallel connection bus bar (4101, 4201, 4301) are stacked one over another with an insulating layer (41I1, 42I1, 43I1, 41I2, 42I2, 43I2) interposed therebetween, and
a connection portion between the parallel connection bus bar (41O1, 42O1, 43O1) and an interconnection (41O2, 42O2, 43O2) extending to a corresponding one of the output terminals (41T, 42T, 43T) is arranged at a position farther away from the smoothing circuit (20) than are the upper and lower arms farthest from the smoothing circuit (20) among all of the upper and lower arms included in the plurality of switch legs (410, 420, 430),
wherein the smoothing circuit and the inverter circuit are arranged next to each other in one axial direction,
wherein the plurality of switch legs (410, 420, 430) are arranged next to each other in the one axial direction, and
wherein the connection portion is arranged at a position farther away from the smoothing circuit than is one of the plurality of switch legs (410, 420, 430) farthest from the smoothing circuit from among the plurality of switch legs (410, 420, 430) arranged in the one axial direction; or
(ii) wherein the positive-side direct current bus bar (41P, 42P, 43P) and the negative-side direct current bus bar (41N, 42N, 43N) have a laminated structure in which the positive-side direct current bus bar (41P, 42P, 43P) and the negative-side direct current bus bar (41N, 42N, 43N) are stacked with an insulating layer (41I1, 42I1, 43I1) interposed therebetween, and
the parallel connection bus bar (41O1, 42O1, 43O1) is configured such that respective paths, passing through the upper and lower arms included in the plurality of switch legs (410, 420, 430), between the smoothing circuit and a merging portion where all of the respective paths from the plurality of switch legs (410, 420, 430) are merged have substantially a same length and have substantially a same current density over entireties of the respective paths,
wherein the parallel connection bus bar (4101, 4201, 4301) is configured so that portions of the respective paths of which lengths are same (41O1a) have substantially a same current density, and is configured so that, in portions other than the portions of which the lengths are same (41O1b), each of the respective paths has substantially a same current density as in the positive-side direct current bus bar (41P, 42P, 43P) and the negative-side direct current bus bar (41N, 42N, 43N),
wherein the smoothing circuit and the inverter circuit are arranged next to each other in one axial direction,
wherein the plurality of switch legs (410, 420, 430) are arranged next to each other in the one axial direction,
wherein the plurality of output circuits (41, 42, 43) are arranged next to each other in a lateral direction perpendicular to the one axial direction,
wherein the parallel connection bus bar (4101, 4201, 4301) includes:
a plurality of leg portions (41O1a, 42O1a, 43O1a) provided to extend in a vertical direction from the connection points of the upper and lower arms of the plurality of switch legs (410, 420, 430) and having substantially a same length and substantially a same size of a cross-sectional area as each other, wherein the vertical direction is perpendicular to the one axial direction and perpendicular to the lateral direction; and
an interconnection portion (41O1b, 42O1b, 43O1b) connecting the plurality of leg portions (41O1a, 42O1a, 43O1a) with each other so as to extend in the one axial direction, and
wherein the interconnection portion (41O1b, 42O1b, 43O1b) is connected to, at an end portion thereof away from the smoothing circuit in the one axial direction, an interconnection (41O2, 42O2, 43O2) extending to a corresponding one of the output terminals (41T, 42T, 43T), and is configured to have, for each of the respective paths, substantially a same current density as in the positive-side direct current bus bar (41P, 42P, 43P) and the negative-side direct current bus bar (41N, 42N, 43N); or
(iii) wherein the positive-side direct current bus bar (41P, 42P, 43P), the negative-side direct current bus bar (41N, 42N, 43N), and the parallel connection bus bar (4101, 4201, 4301) have a laminated structure in which the positive-side direct current bus bar (41P, 42P, 43P), the negative-side direct current bus bar (41N, 42N, 43N), and the parallel connection bus bar (4101, 4201, 43O1) are stacked one over another with an insulating layer (41I1, 42I1, 43I1, 41I2, 42I2, 43I2) interposed therebetween, and
a connection portion between the parallel connection bus bar (41O1, 42O1, 43O1) and an interconnection (41O2, 42O2, 43O2) extending to a corresponding one of the output terminals (41T, 42T, 43T) is arranged at a position closer to the smoothing circuit than are the upper and lower arms closest to the smoothing circuit among all of the upper and lower arms included in the plurality of switch legs (410, 420, 430),
wherein the smoothing circuit and the inverter circuit are arranged next to each other in one axial direction,
wherein the plurality of switch legs (410, 420, 430) are arranged next to each other in the one axial direction, and
wherein the connection portion is arranged at a position closer to the smoothing circuit than is one of the plurality of switch legs (410, 420, 430) closest to the smoothing circuit from among the plurality of switch legs (410, 420, 430) arranged in the one axial direction.

2. The power conversion apparatus according to claim 1, wherein the power conversion apparatus is configured in the (i) of claim 1, wherein the plurality of switch legs (410, 420, 430) are arranged such that two groups, in which two or more switch legs (410, 420, 430) of the plurality of switch legs (410, 420, 430) are arranged next to each other in the one axial direction, are arranged in two rows next to each other in another axial direction perpendicular to the one axial direction, and
wherein the connection portion is arranged at a position farther away from the smoothing circuit than is an end portion of the two groups away from the smoothing circuit in the one axial direction, the position being at a substantially central position of the two groups in the another axial direction.

3. The power conversion apparatus according to claim 1, wherein, where the power conversion apparatus is configured in the (ii) of claim 1, the plurality of switch legs (410, 420, 430) are arranged such that two groups, in which two or more switch legs (410, 420, 430) of the plurality of switch legs (410, 420, 430) are arranged next to each other in the one axial direction, are arranged in two rows next to each other in another axial direction perpendicular to the one axial direction, and
wherein the interconnection portion (41O1b, 42O1b, 43O1b) connects the plurality of leg portions (41O1a, 42O1a, 43O1a) with each other so as to extend in the one axial direction and the another axial direction.

4. The power conversion apparatus according to claim 1, wherein the power conversion apparatus is configured in the (iii) of claim 1, wherein the plurality of switch legs (410, 420, 430) are arranged such that two groups, in which two or more switch legs (410, 420, 430) of the plurality of switch legs (410, 420, 430) are arranged next to each other in the one axial direction, are arranged in two rows next to each other in another axial direction perpendicular to the one axial direction, and
wherein the connection portion is arranged at a position closer to the smoothing circuit than is an end portion of the two groups closer to the smoothing circuit in the one axial direction.

## Patentansprüche

1. Leistungsumwandlungsvorrichtung (1), umfassend:
eine Glättungsschaltung (20);
eine Wechselrichterschaltung (40) einschließlich einer Brückenschaltung, die mehrere Ausgangsschaltungen (41, 42, 43) umfasst, die entsprechenden Phasen entsprechen, die parallel verbunden sind, wobei jede der Ausgangsschaltungen (41, 42, 43) mehrere parallel verbundene Schaltzweige (410, 420, 430) umfasst, jeder der mehreren Schaltzweige (410, 420, 430) obere und untere Arme umfasst, die in Reihe verbunden sind und mehrere Halbleiterschalter umfassen, Verbindungspunkte zwischen den oberen und unteren Armen der mehreren Schaltzweige (410, 420, 430) miteinander verbunden sind und die Wechselrichterschaltung konfiguriert ist, basierend auf einer von der Glättungsschaltung empfangenen Gleichstromleistung eine vorbestimmte Wechselstromleistung auszugeben; und
Ausgangsanschlüsse (41T, 42T, 43T), die konfiguriert sind, die vorbestimmte Wechselstromleistung nach außen auszugeben, wobei die Wechselrichterschaltung umfasst:
eine positivseitige Gleichstromsammelschiene (41P, 42P, 43P), die positivseitige Anschlüsse (410P, 420P, 430P) der mehreren Schaltzweige (410, 420, 430) miteinander verbindet;
eine negativseitige Gleichstromsammelschiene (41N, 42N, 43N), die negativseitige Anschlüsse (410N, 420N, 430N) der mehreren Schaltzweige (410, 420, 430) miteinander verbindet; und
eine Parallelverbindungssammelschiene (4101, 4201, 4301), welche die Verbindungspunkte der oberen und unteren Arme der mehreren Schaltzweige (410, 420, 430) verbindet, wobei die Leistungsumwandlungsvorrichtung in einem der folgenden (i) bis (iii) konfiguriert ist:
(i) dass die positivseitige Gleichstromsammelschiene (41P, 42P, 43P), die negativseitige Gleichstromsammelschiene (41N, 42N, 43N) und die Parallelverbindungssammelschiene (4101, 4201, 4301) eine laminierte Struktur aufweisen, in der die positivseitige Gleichstromsammelschiene (41P, 42P, 43P), die negativseitige Gleichstromsammelschiene (41N, 42N, 43N) und die Parallelverbindungssammelschiene (4101, 4201, 43O1) mit einer dazwischen angeordneten Isolierschicht (41I1, 42I1, 43I1, 41I2, 42I2, 43I2) übereinander gestapelt sind, und
ein Verbindungsabschnitt zwischen der Parallelverbindungssammelschiene (41O1, 42O1, 43O1) und einer Zwischenverbindung (41O2, 42O2, 43O2), die sich zu einem entsprechenden der Ausgangsanschlüsse (41T, 42T, 43T) erstreckt, an einer Position angeordnet ist, die sich weiter von der Glättungsschaltung (20) entfernt befindet als die oberen und unteren Arme, die sich am weitesten von der Glättungsschaltung (20) entfernt befinden, unter all den oberen und unteren Armen, die in den mehreren Schaltzweigen (410, 420, 430) enthalten sind,
wobei die Glättungsschaltung und die Wechselrichterschaltung in einer axialen Richtung nebeneinander angeordnet sind,
wobei die mehreren Schaltzweige (410, 420, 430) in der einen axialen Richtung nebeneinander angeordnet sind, und
wobei der Verbindungsabschnitt an einer Position angeordnet ist, die sich weiter von der Glättungsschaltung entfernt befindet als einer der mehreren Schaltzweige (410, 420, 430), die sich am weitesten von der Glättungsschaltung entfernt befinden, unter den mehreren in der einen axialen Richtung angeordneten Schaltzweigen (410, 420, 430); oder
(ii) wobei die positivseitige Gleichstromsammelschiene (41P, 42P, 43P) und die negativseitige Gleichstromsammelschiene (41N, 42N, 43N) eine laminierte Struktur aufweisen, in der die positivseitige Gleichstromsammelschiene (41P, 42P, 43P) und die negativseitige Gleichstromsammelschiene (41N, 42N, 43N) mit einer dazwischen angeordneten Isolierschicht (41I1, 42I1, 43I1) gestapelt sind, und
die Parallelverbindungssammelschiene (41O1, 42O1, 43O1) derart konfiguriert ist, dass entsprechende Pfade, die durch die oberen und unteren Arme verlaufen, die in den mehreren Schaltzweigen (410, 420, 430) enthalten sind, zwischen der Glättungsschaltung und einem Zusammenführungsabschnitt, in dem alle entsprechenden Pfade der mehreren Schaltzweige (410, 420, 430) zusammengeführt sind, im Wesentlichen eine gleiche Länge aufweisen und im Wesentlichen eine gleiche Stromdichte über Gesamtheiten der entsprechenden Pfade aufweisen,
wobei die Parallelverbindungssammelschiene (41O1, 42O1, 43O1) derart konfiguriert ist, dass Abschnitte der entsprechenden Pfade, deren Längen gleich sind (41O1a), im Wesentlichen eine gleiche Stromdichte aufweisen, und derart konfiguriert ist, dass in anderen Abschnitten als den Abschnitten, deren Längen gleich sind (41O1b), jeder der entsprechenden Pfade im Wesentlichen eine gleiche Stromdichte wie in der positivseitigen Gleichstromsammelschiene (41P, 42P, 43P) und der negativseitigen Gleichstromsammelschiene (41N, 42N, 43N) aufweist,
wobei die Glättungsschaltung und die Wechselrichterschaltung in einer axialen Richtung nebeneinander angeordnet sind,
wobei die mehreren Schaltzweige (410, 420, 430) in der einen axialen Richtung nebeneinander angeordnet sind,
wobei die mehreren Ausgangsschaltungen (41, 42, 43) in einer seitlichen Richtung senkrecht zu der einen axialen Richtung nebeneinander angeordnet sind,
wobei die Parallelverbindungssammelschiene (41O1, 42O1, 43O1) umfasst:
mehrere Zweigabschnitte (41O1a, 42O1a, 43O1a), die derart vorgesehen sind, dass sie sich von den Verbindungspunkten der oberen und unteren Arme der mehreren Schaltzweige (410, 420, 430) in einer vertikalen Richtung erstrecken, und die im Wesentlichen eine gleiche Länge und im Wesentlichen eine gleiche Größe eines Querschnittsbereichs wie jeder andere aufweisen, wobei die vertikale Richtung senkrecht zu der einen axialen Richtung und senkrecht zu der lateralen Richtung ist; und
einen Zwischenverbindungsabschnitt (41O1b, 42O1b, 43O1b), der die mehreren Zweigabschnitte (41O1a, 42O1a, 43O1a) miteinander verbindet, sodass sie sich in der einen axialen Richtung erstrecken, und
wobei der Zwischenverbindungsabschnitt (41O1b, 42O1b, 43O1b) an einem Endabschnitt davon, der sich in der einen axialen Richtung entfernt von der Glättungsschaltung befindet, mit einer Zwischenverbindung (41O2, 42O2, 43O2) verbunden ist, die sich zu einem entsprechenden der Ausgangsanschlüsse (41T, 42T, 43T) erstreckt, und derart konfiguriert ist, dass er für jeden der entsprechenden Pfade im Wesentlichen eine gleiche Stromdichte wie in der positivseitigen Gleichstromschiene (41P, 42P, 43P) und der negativseitigen Gleichstromschiene (41N, 42N, 43N) aufweist; oder
(iii) wobei die positivseitige Gleichstromsammelschiene (41P, 42P, 43P), die negativseitige Gleichstromsammelschiene (41N, 42N, 43N) und die Parallelverbindungssammelschiene (41O1, 42O1, 43O1) eine laminierte Struktur aufweisen, in der die positivseitige Gleichstromsammelschiene (41P, 42P, 43P), die negativseitige Gleichstromsammelschiene (41N, 42N, 43N) und die Parallelverbindungssammelschiene (41O1, 42O1, 43O1) mit einer dazwischen angeordneten Isolierschicht (41I1, 42I1, 43I1, 41I2, 42I2, 43I2) übereinander gestapelt sind, und
ein Verbindungsabschnitt zwischen der Parallelverbindungssammelschiene (41O1, 42O1, 43O1) und einer Zwischenverbindung (41O2, 42O2, 43O2), die sich zu einem entsprechenden der Ausgangsanschlüsse (41T, 42T, 43T) erstreckt, an einer Position angeordnet ist, die sich näher an der Glättungsschaltung befindet als die oberen und
unteren Arme, die sich am nahesten an der Glättungsschaltung befinden, unter all den oberen und unteren Armen, die in den mehreren Schaltzweigen (410, 420, 430) enthalten sind,
wobei die Glättungsschaltung und die Wechselrichterschaltung in einer axialen Richtung nebeneinander angeordnet sind,
wobei die mehreren Schaltzweige (410, 420, 430) in der einen axialen Richtung nebeneinander angeordnet sind, und
wobei der Verbindungsabschnitt an einer Position angeordnet ist, die sich näher an der Glättungsschaltung befindet als einer der mehreren Schaltzweige (410, 420, 430), die sich am nahesten an der Glättungsschaltung befinden, unter den mehreren in der einen axialen Richtung angeordneten Schaltzweigen (410, 420, 430).

2. Leistungsumwandlungsvorrichtung nach Anspruch 1, wobei die Leistungsumwandlungsvorrichtung in dem (i) von Anspruch 1 konfiguriert ist, wobei die mehreren Schaltzweige (410, 420, 430) derart angeordnet sind, dass zwei Gruppen, in denen zwei oder mehr Schaltzweige (410, 420, 430) der mehreren Schaltzweige (410, 420, 430) in der einen axialen Richtung nebeneinander angeordnet sind, in einer anderen axialen Richtung senkrecht zu der einen axialen Richtung in zwei Reihen nebeneinander angeordnet sind, und
wobei der Verbindungsabschnitt an einer Position angeordnet ist, die sich weiter von der Glättungsschaltung entfernt befindet als sich ein Endabschnitt der zwei Gruppen von der Glättungsschaltung in der einen axialen Richtung entfernt befindet, wobei sich die Position an einer im Wesentlichen zentralen Position der beiden Gruppen in der anderen axialen Richtung befindet.

3. Leistungsumwandlungsvorrichtung nach Anspruch 1, wobei, wo die Leistungsumwandlungsvorrichtung in der (ii) von Anspruch 1 konfiguriert ist, die mehreren Schaltzweige (410, 420, 430) derart angeordnet sind, dass zwei Gruppen, in denen zwei oder mehr Schaltzweige (410, 420, 430) der mehreren Schaltzweige (410, 420, 430) in der einen axialen Richtung nebeneinander angeordnet sind, in einer anderen axialen Richtung senkrecht zu der einen axialen Richtung in zwei Reihen nebeneinander angeordnet sind, und
wobei der Zwischenverbindungsabschnitt (41O1b, 42O1b, 43O1b) die mehreren Zweigabschnitte (41O1a, 42O1a, 43O1a) miteinander verbindet, sodass sie sich in der einen axialen Richtung und der anderen axialen Richtung erstrecken.

4. Leistungsumwandlungsvorrichtung nach Anspruch 1, wobei die Leistungsumwandlungsvorrichtung in der (iii) von Anspruch 1 konfiguriert ist, wobei die mehreren Schaltzweige (410, 420, 430) derart angeordnet sind, dass zwei Gruppen, in denen zwei oder mehr Schaltzweige (410, 420, 430) der mehreren Schaltzweige (410, 420, 430) in der einen axialen Richtung nebeneinander angeordnet sind, in einer anderen axialen Richtung senkrecht zu der einen axialen Richtung in zwei Reihen nebeneinander angeordnet sind, und
wobei der Verbindungsabschnitt an einer Position angeordnet ist, die sich näher an der Glättungsschaltung befindet als ein Endabschnitt der zwei Gruppen, die sich in der einen axialen Richtung näher an der Glättungsschaltung befinden.

## Revendications

1. Appareil de conversion de puissance (1) comprenant :
un circuit de lissage (20) ;
un circuit onduleur (40) incluant un circuit en pont qui inclut une pluralité de circuits de sortie (41, 42, 43), correspondant à des phases respectives, connectés en parallèle, chacun des circuits de sortie (41, 42, 43) incluant une pluralité de branches de commutation (410, 420, 430) connectées en parallèle, chacune de la pluralité de branches de commutation (410, 420, 430) incluant des bras supérieurs et inférieurs connectés en série et incluant une pluralité d'interrupteurs à semi-conducteur, des points de connexion entre les bras supérieur et inférieur de la pluralité de branches de commutation (410, 420, 430) étant connectés l'un à l'autre, et le circuit onduleur étant configuré pour délivrer en sortie une puissance de courant alternatif prédéterminée, sur la base d'une puissance de courant continu reçue du circuit de lissage ; et
des bornes de sortie (41T, 42T, 43T) configurées pour délivrer en sortie la puissance de courant alternatif prédéterminée vers un extérieur,
dans lequel le circuit onduleur inclut :
une barre bus à courant continu côté positif (41P, 42P, 43P) connectant les bornes côté positif (410P, 420P, 430P) de la pluralité de branches de commutation (410, 420, 430) les unes aux autres ;
une barre bus à courant continu côté négatif (41N, 42N, 43N) connectant les bornes côté négatif (410N, 420N, 430N) de la pluralité de branches de commutation (410, 420, 430) les unes aux autres ; et
une barre bus à connexion parallèle (4101, 4201, 4301) connectant les points de connexion des bras supérieur et inférieur de la pluralité de branches de commutation (410, 420, 430),
dans lequel l'appareil de conversion de puissance est configuré selon l'une quelconque des configurations (i) à (iii) suivantes :
(i) la barre bus à courant continu côté positif (41P, 42P, 43P), la barre bus à courant continu côté négatif (41N, 42N, 43N) et la barre bus à connexion parallèle (4101, 4201, 4301) ont une structure stratifiée dans laquelle la barre bus à courant continu côté positif (41P, 42P, 43P), la barre bus à courant continu côté négatif (41N, 42N, 43N) et la barre bus à connexion parallèle (4101, 4201, 4301) sont empilées les unes sur les autres avec une couche isolante (41I1, 42I1, 43I1, 41I2, 42I2, 43I2) interposée entre elles, et
une partie de connexion entre la barre bus à connexion parallèle (4101, 4201, 4301) et une interconnexion (4102, 4202, 4302) s'étendant vers une borne correspondante des bornes de sortie (41T, 42T, 43T) est agencée dans une position plus éloignée du circuit de lissage (20) que ne le sont les bras supérieurs et inférieurs les plus éloignés du circuit de lissage (20) parmi l'ensemble des bras supérieurs et inférieurs inclus dans la pluralité de branches de commutation (410, 420, 430),
dans lequel le circuit de lissage et le circuit onduleur sont agencés côte à côte dans une première direction axiale,
dans lequel la pluralité de branches de commutation (410, 420, 430) sont agencées côte à côte dans la première direction axiale, et
dans lequel la partie de connexion est agencée dans une position plus éloignée du circuit de lissage que ne l'est l'une de la pluralité de branches de commutation (410, 420, 430) la plus éloignée du circuit de lissage parmi la pluralité de branches de commutation (410, 420, 430) agencées dans la première direction axiale ; ou
(ii) dans lequel la barre bus à courant continu côté positif (41P, 42P, 43P) et la barre bus à courant continu côté négatif (41N, 42N, 43N) ont une structure stratifiée dans laquelle la barre bus à courant continu côté positif (41P, 42P, 43P) et la barre bus à courant continu côté négatif (41N, 42N, 43N) sont empilées avec une couche isolante (4111, 4211, 4311) interposée entre elles, et
la barre bus à connexion parallèle (4101, 4201, 4301) est configurée de telle sorte que les trajets respectifs, traversant les bras supérieurs et inférieurs inclus dans la pluralité de branches de commutation (410, 420, 430), entre le circuit de lissage et une partie de convergence où tous les trajets respectifs depuis la pluralité de branches de commutation (410, 420, 430) convergent présentent sensiblement une même longueur et présentent sensiblement une même densité de courant sur la totalité des trajets respectifs,
dans lequel la barre bus à connexion parallèle (4101, 4201, 4301) est configurée de telle sorte que des parties des trajets respectifs dont les longueurs sont les mêmes (4101a) présentent sensiblement une même densité de courant, et est configurée de telle sorte que, dans des parties autres que les parties dont les longueurs sont les mêmes (4101b), chacun des trajets respectifs présente sensiblement même densité de courant que dans la barre bus à courant continu côté positif (41P, 42P, 43P) et la barre bus à courant continu côté négatif (41N, 42N, 43N),
dans lequel le circuit de lissage et le circuit onduleur sont agencés côte à côte dans une première direction axiale,
dans lequel la pluralité de branches de commutation (410, 420, 430) sont agencées côte à côte dans la première direction axiale,
dans lequel la pluralité de circuits de sortie (41, 42, 43) sont agencés côte à côte dans une direction latérale perpendiculaire à la première direction axiale,
dans lequel la barre bus à connexion parallèle (4101, 4201, 4301) inclut :
une pluralité de parties de branches (4101a, 4201a, 4301a) prévues pour s'étendre dans une direction verticale par rapport aux points de connexion des bras supérieurs et inférieurs de la pluralité de branches de commutation (410, 420, 430) et présentant sensiblement une même longueur et sensiblement une même taille de section transversale les unes par rapport aux autres, dans lequel la direction verticale est perpendiculaire à la première direction axiale et perpendiculaire à la direction latérale ; et
une partie d'interconnexion (4101b, 4201b, 4301b) connectant la pluralité de parties de branches (4101a, 4201a, 4301a) les unes aux autres de sorte à s'étendre dans la première direction axiale, et
dans lequel la partie d'interconnexion (4101b, 4201b ; 4301b) est connectée, au niveau d'une partie d'extrémité de celle-ci éloignée du circuit de lissage dans la première direction axiale, à une interconnexion (4102, 4202, 4302) s'étendant vers une borne correspondante des bornes de sortie (41T, 42T, 43T), et est configurée pour présenter, pour chacun des trajets respectifs, sensiblement une même densité de courant que dans la barre bus à courant continu côté positif (41P, 42P, 43P) et la barre bus à courant continu côté négatif (41N, 42N, 43N) ; ou
(iii) dans lequel la barre bus à courant continu côté positif (41P, 42P, 43P), la barre bus à courant continu côté négatif (41N, 42N, 43N) et la barre bus à connexion parallèle (4101, 4201, 4301) présentent une structure stratifiée dans laquelle la barre bus à courant continu côté positif (41P, 42P, 43P), la barre bus à courant continu côté négatif (41N, 42N, 43N) et la barre bus à connexion parallèle (4101, 4201, 4301) sont empilées les unes sur les autres avec une couche isolante (41I1, 42I1, 43I1, 41I2, 42I2, 43I2) interposée entre elles, et
une partie de connexion entre la barre bus à connexion parallèle (4101, 4201, 4301) et une interconnexion (4102, 4202, 4302) s'étendant vers une borne correspondante des bornes de sortie (41T, 42T, 432T) est agencée dans une position plus proche du circuit de lissage que ne le sont les bras supérieur et inférieur les plus proches du circuit de lissage parmi l'ensemble des bras supérieurs et inférieurs inclus dans la pluralité de branches de commutation (410, 420, 430),
dans lequel le circuit de lissage et le circuit onduleur sont agencés côte à côte dans la première direction axiale,
dans lequel la pluralité de branches de commutation (410, 420, 430) sont agencées côte à côte dans la première direction axiale, et
dans lequel la partie de connexion est agencée dans une position plus proche du circuit de lissage que ne l'est une de la pluralité de branches de commutation (410, 420, 430) la plus proche du circuit de lissage parmi la pluralité de branches de commutation (410, 420, 430) agencées dans la première direction axiale.

2. Appareil de conversion de puissance selon la revendication 1, dans lequel l'appareil de conversion de puissance est configuré selon la configuration (i) de la revendication 1, dans lequel la pluralité de branches de commutation (410, 420, 430) sont agencées de telle sorte que deux groupes, dans lesquels deux branches de commutation (410, 420, 430) ou plus de la pluralité de branches de commutation (410, 420, 430) sont agencées côte à côte dans la première direction axiale, sont agencés sur deux rangées côte à côte dans une autre direction axiale perpendiculaire à la première direction axiale, et
dans lequel la partie de connexion est agencée dans une position plus éloignée du circuit de lissage que ne l'est une partie d'extrémité des deux groupes éloignés du circuit de lissage dans la première direction axiale, la position étant dans une position sensiblement centrale des deux groupes dans l'autre direction axiale.

3. Appareil de conversion de puissance selon la revendication 1, dans lequel, lorsque l'appareil de conversion de puissance est configuré selon la configuration (ii) de la revendication 1, la pluralité de branches de commutation (410, 420, 430) sont agencées de telle sorte que deux groupes, dans lesquels deux branches de commutation (410, 420, 430) ou plus de la pluralité de branches de commutation (410, 420, 430) sont agencées côte à côte dans la première direction axiale, sont agencés sur deux rangées côte à côte dans une autre direction axiale perpendiculaire à la première direction axiale, et
dans lequel la partie d'interconnexion (4101b, 4201b, 4301b) connecte la pluralité de parties de branches (4101a, 4201a, 4301a) les unes aux autres de sorte à s'étendre dans la première direction axiale et l'autre direction axiale.

4. Appareil de conversion de puissance selon la revendication 1, dans lequel l'appareil de conversion de puissance est configuré selon la configuration (iii) de la revendication 1, dans lequel la pluralité de branches de commutation (410, 420, 430) sont agencées de telle sorte que deux groupes, dans lesquels deux branches de commutation (410, 420, 430) ou plus de la pluralité de branches de commutation (410, 420, 430) sont agencées côte à côte dans la première direction axiale, sont agencés sur deux rangées côte à côte dans une autre direction axiale perpendiculaire à la première direction axiale, et
dans lequel la partie de connexion est agencée dans une position plus proche du circuit de lissage que ne l'est une partie d'extrémité des deux groupes plus proches du circuit de lissage dans la première direction axiale.
